(19) Europäisches Patentamt
European Patent Office
Office européen des brevets

(11) EP 2 042 311 A1

(12) EUROPEAN PATENT APPLICATION

(43) Date of publication:
**01.04.2009 Bulletin 2009/14**

(51) Int Cl.:
***B41C 1/10*** *(2006.01)* ***G03F 7/11*** *(2006.01)*
*B41N 1/08* *(2006.01)*

(21) Application number: **08017061.6**

(22) Date of filing: **26.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **28.09.2007 JP 2007256777**

(71) Applicant: **FUJIFILM Corporation**
**Minato-ku**
**Tokyo (JP)**

(72) Inventor: **Oohashi, Hidekazu**
**Haibara-gun**
**Shizuoka (JP)**

(74) Representative: **HOFFMANN EITLE**
**Patent- und Rechtsanwälte**
**Arabellastraße 4**
**81925 München (DE)**

(54) **Lithographic printing plate precursor, method of preparing lithographic printing plate and lithographic printing method**

(57) A lithographic printing plate precursor includes a support; a layer A containing a compound having a functional group represented by the formula (1) as defined herein; and a layer B containing a compound having a functional group represented by the formula (2) as defined herein.

EP 2 042 311 A1

## Description

FIELD OF THE INVENTION

The present invention relates to a lithographic printing plate precursor which is capable of undergoing a so-called direct plate making, in which the plate making is directly conducted based on digital signals, for example, from a computer using various kinds of lasers, particularly, to a lithographic printing plate precursor of a simple processing type which does not need alkali development, and a method of preparing a lithographic printing plate and a lithographic printing method using the lithographic printing plate precursor.

BACKGROUND OF THE INVENTION

A solid laser, semiconductor laser and gas laser having a large output and a small size, which radiate an ultraviolet ray, visible light or infrared ray having a wavelength of 300 to 1,200 nm, have become easily available, and these lasers are very useful for recording light sources used in the direct plate making based on digital signals, for example, from a computer. Various investigations on recording materials sensitive to such various laser beams have been made. Typical examples thereof include firstly recording materials capable of being recorded with a infrared laser having a wavelength of not less than 760 nm, for example, positive type recording materials described in U.S. Patent 4,708,925 and acid catalyst crosslinking type negative type recording materials described in JP-A-8-276558 (the term "JP-A" as used herein means an "unexamined published Japanese patent application") (corresponding to U.S. Patent 6,132,935), and secondly recording materials responsive to an ultraviolet ray or visible light laser having a wavelength of from 300 to 700 nm, for example, radical polymerization type negative type recording materials described in U.S. Patent 2,850,445 and JP-B-44-20189 (the term "JP-B" as used herein means an "examined Japanese patent publication").

Further, with respect to hitherto known lithographic printing plate precursors (hereinafter, also referred to as PS plates), a step of removing the non-image area by dissolution (development processing) is indispensable and a post-processing step, for example, washing the printing plate after the development processing with water, treatment of the printing plate after the development processing with a rinse solution containing a surfactant or treatment of the printing plate after the development processing with an oil-desensitizing solution containing gum arabic or a starch derivative, is also necessary. The point that such additional wet treatments are indispensable is a large subject of investigation in hitherto known PS plates. Even when the first half (image-forming process) of plate making process is simplified by the above-described digital processing, the effects due to the simplification is still insufficient as long as the last half (development processing) is the troublesome wet treatment.

Particularly, the consideration for global environment has become a great concern throughout the field of industry in recent years. In view of the consideration for global environment, a treatment with a developer closer to a neutral range and a small amount of waste liquid are subjects of further investigations. Further, it is desirable that the wet type post-processing is simplified or changed to a dry processing.

From this viewpoint, as one method for eliminating the processing step, a method referred to as on-machine development (on-press development) wherein an exposed printing plate precursor is mounted on a cylinder of a printing machine and the non-image area of the printing plate precursor is removed by supplying dampening water (fountain solution) and ink while rotating the cylinder is known. Specifically, according to the method, the printing plate precursor is exposed and mounted on a printing machine as it is to complete development processing in a conventional process of printing.

A lithographic printing plate precursor suitable for the on-machine development is required to have an image-forming layer soluble in dampening water or an ink solvent and a bright room handling property suitable for development on a printing machine placed in a bright room.

However, it is substantially impossible for hitherto known PS plates to fulfill such requirements.

In order to fulfill such requirements, a lithographic printing plate precursor having provided on a hydrophilic support an image-forming layer in which fine particles of thermoplastic hydrophobic polymer are dispersed in a hydrophilic binder polymer is proposed (see, for example, Japanese Patent 2,938,397 (corresponding to U.S. Patent 6,030,750)). In the plate-making, the lithographic printing plate precursor is exposed to an infrared laser to agglomerate (fuse) the fine particles of thermoplastic hydrophobic polymer by heat generated by light-to-heat conversion thereby forming an image, and mounted on a cylinder of a printing machine to carry out on-machine development by supplying at least any one of dampening water and ink. Since the lithographic printing plate precursor has the sensitive zone in an infrared region, it has also the handling property in a bright room.

However, the image formed by the agglomeration (fusion) of the fine particles of thermoplastic hydrophobic polymer is insufficient in strength and has a problem of printing durability as a printing plate.

Lithographic printing plate precursors including microcapsules containing a polymerizable compound incorporated therein in stead of the thermoplastic fine particles are also proposed (see, for example, JP-A-2000-211262, JP-A-2001-277740 (corresponding to US2001/0018159A1), JP-A-2002-29162 (corresponding to US2002/0031715A1), JP-A-2002-46361, JP-A-2002-137562 (corresponding to US2002/0102488A1) and JP-A-2002-326470 (corresponding to US2002/0117066A1)). In the lithographic printing plate precursors according to such a proposal, it is advantageous that the polymer image formed by a reaction of the polymerizable compound is excellent in the strength in comparison with the image formed by the fusion of the fine particles.

Also, since the polymerizable compound has high reactivity, many proposals for isolation of the polymerizable compound using microcapsules have been made. Further, it has been proposed to use a thermally degradable polymer in a shell of the microcapsule.

However, in the hitherto known lithographic printing plate precursors described in Japanese Patent 2,938,397 (corresponding to U.S. Patent 6,030,750), JP-A-2000-211262, JP-A-2001-277740 (corresponding to US2001/0018159A1), JP-A-2002-29162 (corresponding to US2002/0031715A1), JP-A-2002-46361, JP-A-2002-137562 (corresponding to US2002/0102488A1) and JP-A-2002-326470 (corresponding to US2002/0117066A1), printing durability of the image formed by laser exposure is insufficient and thus further improvements have been requested. Specifically, in such a lithographic printing plate precursor of a simple processing type, a support having a surface of high hydrophilicity is used in order to make possible development with an aqueous solution having pH of 10 or less or dampening water (ordinarily nearly neutral) on a printing machine and as a result, the image area is apt to be removed from the support by dampening water during printing and sufficient printing durability can not be obtained. On the contrary, when the surface of support renders hydrophobic, ink also adheres on the non-image area during printing to cause printing stain. Thus, it is extremely difficult to achieve a good balance between the printing durability and the stain resistance and a lithographic printing plate precursor of a simple processing type which provides good stain resistance and sufficient printing durability has not yet been known.

## SUMMARY OF THE INVENTION

Therefore, an object of the present invention is to provide a lithographic printing plate precursor which provides good stain resistance and sufficient printing durability, a method of preparing a lithographic printing plate and a lithographic printing method.

The present invention includes the following items.

(1) A lithographic printing plate precursor comprising a support, a layer A containing a compound having a functional group represented by formula (1) shown below and a layer B containing a compound having a functional group represented by formula (2) shown below:

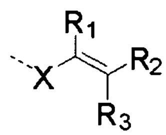 (1)

in formula (1), $R_1$ to $R_3$ each independently represents a hydrogen atom or a monovalent substituent, X represents -O-, -S-, -N($R_4$)-, -C($R_5$)($R_6$)- or -Ar-, $R_4$ to $R_6$ each independently represents a hydrogen atom, an alkyl group, an aryl group, an alkenyl group or an alkynyl group, Ar represents an aromatic ring, and a dotted line represents a connecting bond to a mother skeleton of the compound, or any one of $R_1$ to $R_6$ and Ar in X may be connected to the mother skeleton of the compound to form a ring;

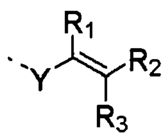 (2)

in formula (2), $R_1$ to $R_3$ each independently represents a hydrogen atom or a monovalent substituent, Y represents -CO- or -$SO_2$-, and a dotted line represents a connecting bond to a mother skeleton of the compound, or any one of $R_1$ to $R_3$ may be connected to the mother skeleton of the compound to form a ring.

(2) The lithographic printing plate precursor as described in (1) above which comprises a support, a layer A containing a compound having a functional group represented by formula (1) shown below and a layer B containing a compound

having a functional group represented by formula (2) shown below:

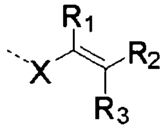 (1)

in formula (1), $R_1$ to $R_3$ each independently represents a hydrogen atom, an alkyl group, an aryl group, an alkenyl group, an alkynyl group, an alkoxy group, an alkylthio group, an aryloxy group, an arylthio group, an amino group, an acyloxy group, an acylamino group, a sulfoxy group or a sulfoamino group, X represents -O-, -S-, -N($R_4$)-, -C($R_5$)($R_6$)- or -Ar-, $R_4$ to $R_6$ each independently represents a hydrogen atom, an alkyl group, an aryl group, an alkenyl group or an alkynyl group, Ar represents an aromatic ring, and a dotted line represents a connecting bond to a mother skeleton of the compound, or any one of $R_1$ to $R_6$ and Ar in X may be connected to the mother skeleton of the compound to form a ring;

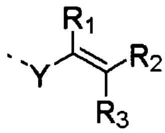 (2)

in formula (2), $R_1$ to $R_3$ each independently represents a hydrogen atom, an alkyl group, an aryl group, an alkenyl group, an alkynyl group, a cyano group, an acyl group, an alkylacyl group, an arylacyl group, an alkoxyacyl group, an aryloxyacyl group, an aminoacyl group or a sulfone group, Y represents -CO- or -$SO_2$-, and a dotted line represents a connecting bond to a mother skeleton of the compound, or any one of $R_1$ to $R_3$ may be connected to the mother skeleton of the compound to form a ring.

(3) The lithographic printing plate precursor as described in (2) above, wherein in the functional group represented by formula (1), X represents -O-, -N($R_4$)-, -C($R_5$)($R_6$)- or -Ar-, $R_4$ to $R_6$ each independently represents a hydrogen atom, an alkyl group having 6 or less carbon atoms or a phenyl group, and Ar represents a phenyl group, a naphthyl group, a phenyl group having an electron donating group or a naphthyl group having an electron donating group.

(4) The lithographic printing plate precursor as described in (2) above, wherein in the functional group represented by formula (2), Y represents -CO-.

(5) The lithographic printing plate precursor as described in (2) above, wherein in the functional group represented by formula (2), Y represents -CO-, and at least one of $R_1$ to $R_3$ represents an alkylacyl group, an arylacyl group, an alkoxyacyl group, an aryloxyacyl group, an aminoacyl group, a sulfone group or a cyano group.

(6) The lithographic printing plate precursor as described in (1) above, wherein the layer A is an undercoat layer, the layer B is an image-forming layer, and the layer A and the layer B are adjacent to each other.

(7) The lithographic printing plate precursor as described in (1) above, wherein the layer B is an undercoat layer, the layer A is an image-forming layer, and the layer A and the layer B are adjacent to each other.

(8) The lithographic printing plate precursor as described in (6) above, wherein the compound having a functional group represented by formula (1) is a polymer compound.

(9) The lithographic printing plate precursor as described in (7) above, wherein the compound having a functional group represented by formula (2) is a polymer compound.

(10) The lithographic printing plate precursor as described in (6) or (8) above, wherein the compound having a functional group represented by formula (1) further has a substrate adhesion group.

(11) The lithographic printing plate precursor as described in (7) or (9) above, wherein the compound having a functional group represented by formula (2) further has a substrate adhesion group.

(12) The lithographic printing plate precursor as described in (6), (8) or (10) above, wherein the compound having a functional group represented by formula (1) further has a hydrophilic group.

(13) The lithographic printing plate precursor as described in (7), (9) or (11) above, wherein the compound having a functional group represented by formula (2) further has a hydrophilic group.

(14) The lithographic printing plate precursor as described in (7), (9), (11) or (13) above, wherein the compound having a functional group represented by formula (1) has two or more radical polymerizable double bonds in its molecule.

(15) The lithographic printing plate precursor as described in (6), (8), (10) or (12) above, wherein the compound having a functional group represented by formula (2) has two or more radical polymerizable double bonds in its

molecule.

(16) A method of preparing a lithographic printing plate comprising exposing imagewise the lithographic printing plate precursor as described in any one of (1) to (15) above with laser of 350 to 1,200 nm, and rubbing a surface of the exposed lithographic printing plate precursor with a rubbing member in the presence of a developer having pH of 2 to 10 in an automatic processor equipped with the rubbing member to remove an unexposed area of the image-forming layer.

(17) The method of preparing a lithographic printing plate as described in (16) above, wherein the exposed lithographic printing plate precursor is subjected to a heat treatment between the exposure and the development.

(18) A lithographic printing method comprising (i) mounting the lithographic printing plate precursor as described in any one of (1) to (15) above on a printing machine and exposing it imagewise with laser of 350 to 1,200 nm, or (ii) exposing the lithographic printing plate precursor as claimed in any one of Claims 1 to 15 imagewise with laser of 350 to 1,200 nm and mounting the exposed lithographic printing plate precursor on a printing machine, and then supplying printing ink and dampening water on the exposed lithographic printing plate precursor to remove an unexposed area of the image-forming layer and to conduct printing.

According to the present invention, a lithographic printing plate precursor of a simple processing type which particularly does not need alkali development and provides good stain resistance and sufficient printing durability, a method of preparing a lithographic printing plate and a lithographic printing method can be provided.

## BRIEF DESCRIPTION OF THE DRAWINGS

Fig. 1 is an illustration for showing a structure of an automatic development processor.

[Description of reference numerals and signs]

61: Rotating brush roller
62: Backing roller
63: Transport roller
64: Transport guide plate
65: Spray pipe
66: Pipe line
67: Filter
68: Plate supply table
69: Plate discharge table
70: Developer tank
71: Circulating pump
72: Plate

## DETAILED DESCRIPTION OF THE INVENTION

The present invention will be described in more detail below.

The lithographic printing plate precursor according to the invention comprises a support having thereon a layer A containing a compound (hereinafter, also referred to as an "electron donating double bond compound") having a functional group represented by formula (1) and a layer B containing a compound (hereinafter, also referred to as an "electron accepting double bond compound") having a functional group represented by formula (2). Although the function mechanism according to the invention is not quite clear, it is believed as follows. Specifically, by incorporating the electron donating double bond compound and the electron accepting double bond compound in the layer A and the layer B different from each other respectively, mutual copolymerization proceeds between the layer A and the layer B and thus the layer A and the layer B strongly adhere to each other. Therefore, it is believed that good printing durability can be achieved.

[Electron donating double bond compound]

As the electron donating double bond compound for use in the lithographic printing plate precursor according to the invention, any compound containing a double bond and having a negative value which is determined by a conventionally known method (reference literature: Polymer Handbook, 4th Edition, Vol. 1, page 309) may be suitably used,

a compound containing a double bond and having the value of -0.5 or less is preferably used, and a compound containing a double bond and having the value of -0.6 or less is particularly preferably used.

The electron donating double bond compound for use in the lithographic printing plate precursor according to the invention is a compound having a functional group represented by formula (1) shown below.

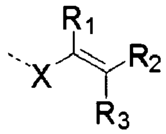 (1)

In formula (1), $R_1$ to $R_3$ each independently represents a hydrogen atom or a monovalent substituent, X represents -O-, -S-, $-N(R_4)-$, $-C(R_5)(R_6)-$ or -Ar-, $R_4$ to $R_6$ each independently represents a hydrogen atom, an alkyl group, an aryl group, an alkenyl group or an alkynyl group, Ar represents an aromatic ring, and a dotted line represents a connecting bond to a mother skeleton of the compound, or any one of $R_1$ to $R_6$ and Ar in X may be connected to the mother skeleton of the compound to form a ring.

Preferably, $R_1$ to $R_3$ each independently represents a hydrogen atom, an alkyl group, an aryl group, an alkenyl group, an alkynyl group, an alkoxy group, an alkylthio group, an aryloxy group, an arylthio group, an amino group, an acyl group, an acyloxy group, an acylamino group, a sulfoxy group or a sulfoamino group, X represents -O-, -S-, $-N(R_4)-$, $-C(R_5)(R_6)-$ or -Ar-, $R_4$ to $R_6$ each independently represents a hydrogen atom, an alkyl group, an aryl group, an alkenyl group or an alkynyl group, Ar represents an aromatic ring.

Specific examples of the alkyl group represented by any one of $R_1$ to $R_3$ include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methyl-carbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group. Of the alkyl groups, an alkyl group having 10 or less carbon atoms is preferable in view of reactivity.

Specific examples of the aryl group represented by any one of $R_1$ to $R_3$ include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group. Of the aryl groups, an aryl group having 10 or less carbon atoms is preferable in view of reactivity.

Specific examples of the alkenyl group represented by any one of $R_1$ to $R_3$ include a vinyl group, a 1-propenyl group, a 1-butenyl group, a cinnamyl group and a 2-chloro-1-ethenyl group. Of the alkenyl groups, an alkenyl group having 10 or less carbon atoms is preferable in view of reactivity.

Specific examples of the alkynyl group represented by any one of $R_1$ to $R_3$ include an ethynyl group, a 1-propynyl group, a 1-butynyl group and a trimethylsilylethynyl group. Of the alkynyl groups, an alkynyl group having 10 or less carbon atoms is preferable in view of reactivity.

Specific examples of the alkoxy group represented by any one of $R_1$ to $R_3$ include a substituent represented

by $-OR_{11}$ (wherein $R_{11}$ represents an alkyl group). Specific examples of the alkyl group represented by $R_{11}$ include the specific examples of the alkyl group described above.

Specific examples of the alkylthio group represented by any one of $R_1$ to $R_3$ include a substituent represented by $-SR_{11}$ (wherein $R_{11}$ represents an alkyl group). Specific examples of the alkyl group represented by $R_{11}$ include the specific examples of the alkyl group described above.

Specific examples of the aryloxy group represented by any one of $R_1$ to $R_3$ include a substituent represented by $-OR_{12}$ (wherein $R_{12}$ represents an aryl group). Specific examples of the aryl group represented by $R_{12}$ include the specific examples of the aryl group described above.

Specific examples of the arylthio group represented by any one of $R_1$ to $R_3$ include a substituent represented by $-SR_{12}$ (wherein $R_{12}$ represents an aryl group). Specific examples of the aryl group represented by $R_{12}$ include the specific examples of the aryl group described above.

Specific examples of the amino group represented by any one of $R_1$ to $R_3$ include a substituent represented by $-NR_{11}R_{12}$ (wherein $R_{11}$ and $R_{12}$ each represents an alkyl group or an aryl group). Specific examples of the alkyl group represented by $R_{11}$ or $R_{12}$ include the specific examples of the alkyl group described above. Specific examples of the aryl group represented by $R_{11}$ or $R_{12}$ include the specific examples of the aryl group described above.

Specific examples of the acyloxy group represented by any one of $R_1$ to $R_3$ include a substituent represented by $-OCOR_{11}$, $-OCOOR_{11}$ or $-OCONR_{11}R_{12}$ (wherein $R_{11}$ and $R_{12}$ each represents an alkyl group or an aryl group). Specific examples of the alkyl group represented by any one of $R_{11}$ or $R_{12}$ include the specific examples of the alkyl group described above. Specific examples of the aryl group represented by any one of $R_{11}$ or $R_{12}$ include the specific examples of the aryl group described above.

Specific examples of the acylamino group represented by any one of $R_1$ to $R_3$ include a substituent represented by $-NR_{11}COR_{12}$, $-NR_{11}COOR_{12}$ or $-NR_{11}CONR_{12}R_{13}$ (wherein $R_{11}$ to $R_{13}$ each represents an alkyl group or an aryl group). Specific examples of the alkyl group represented by any one of $R_{11}$ to $R_{13}$ include the specific examples of the alkyl group described above. Specific examples of the aryl group represented by any one of $R_{11}$ to $R_{13}$ include the specific examples of the aryl group described above.

Specific examples of the sulfoxy group represented by any one of $R_1$ to $R_3$ include a substituent represented by $-OSO_2R_{11}$ (wherein $R_{11}$ represents an alkyl group or an aryl group). Specific examples of the alkyl group represented by $R_{11}$ include the specific examples of the alkyl group described above. Specific examples of the aryl group represented by $R_{11}$ include the specific examples of the aryl group described above.

Specific examples of the sulfoamino group represented by any one of $R_1$ to $R_3$ include a substituent represented by $-NR_{11}SO_2R_{12}$ (wherein $R_{11}$ and $R_{12}$ each represents an alkyl group or an aryl group). Specific examples of the alkyl group represented by $R_{11}$ or $R_{12}$ include the specific examples of the alkyl group described above. Specific examples of the aryl group represented by $R_{11}$ or $R_{12}$ include the specific examples of the aryl group described above.

For any one of $R_1$ to $R_3$, a hydrogen atom, an alkyl group, an aryl group, an alkoxy group, an alkylthio group, an aryloxy group, an arylthio group, an amino group, an acyloxy group and an acylamino group are preferable and a hydrogen atom, an alkyl group, an aryl group, an alkoxy group, an aryloxy group, an amino group, an acyloxy group and an acylamino group are more preferable.

Specific examples of the alkyl group, aryl group, alkenyl group and alkynyl group represented by $R_4$ or $R_5$ include those described above respectively and preferable examples are also same as those described above respectively.

Specific examples of the aromatic ring represented by Ar include a divalent cyclic structure formed by eliminating two hydrogen atoms from an aromatic compound, for example, benzene, naphthalene or anthracene. A preferable aromatic ring includes benzene, naphthalene, benzene having an electron donating group and naphthalene having an electron donating group. As the electron donating group, $-R_{11}$, $-OR_{11}$, $-NR_{11}R_{12}$ or $-SR_{11}$ (wherein $R_{11}$ and $R_{12}$ each represents a hydrogen atom, an alkyl group, an aryl group, an alkenyl group or an alkynyl group, or $R_{11}$ and $R_{12}$ may be combined with each other to form a ring or any of $R_{11}$ and $R_{12}$ may be combined with the aromatic ring to form a ring) is preferable. Particularly, benzene in which the electron donating group is present on 2-position or 4-position with respect to the vinyl group, 1-vinylnaphthalene having the electron donating group on 2-position, 4-position, 5-position or 7-position and 2-vinylnaphthalene having the electron donating group on 1-position, 3-position, 6-position or 8-position are preferable.

Preferable examples of the functional group represented by formula (1) in the electron donating double bond compound for use in the invention include functional groups represented by formula (1) wherein $R_1$ to $R_3$ each represents a hydrogen atom or an alkyl group having 6 or less carbon atoms, X represents -O-, $-N(R_4)-$, $-C(R_5)(R_6)-$ or -Ar-, $R_4$ to $R_6$ each independently represents a hydrogen atom, an alkyl group having 6 or less carbon atoms or a phenyl group, and Ar represents a phenyl group, a naphthyl group, a phenyl group having an electron donating group or a naphthyl group having an electron donating group. Functional groups represented by formulae (1-1) to (1-18) shown below are more preferable and functional groups represented by formulae (1-1) to (1-11) shown below are particularly preferable.

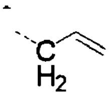 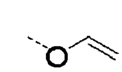 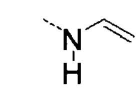 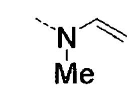 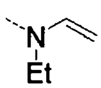 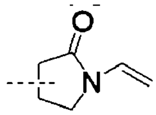

(1-1) (1-2) (1-3) (1-4) (1-5) (1-6)

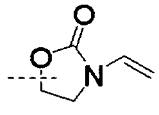 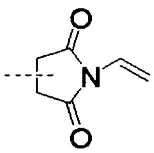 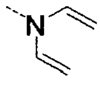 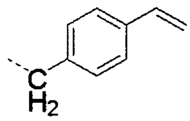 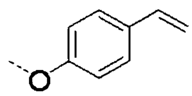

(1-7) (1-8) (1-9) (1-10) (1-11)

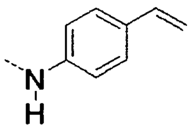 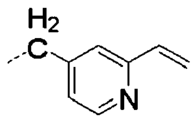 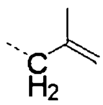 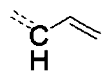 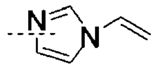

(1-12) (1-13) (1-14) (1-15) (1-16)

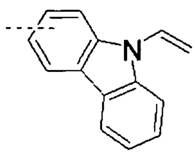 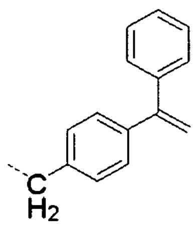

(1-17) (1-18)

As the electron donating double bond compound for use in the invention, any low molecular compound and polymer compound may be suitably used as long as they have the functional group represented by formula (1). In the case where the layer A is a lower layer with respect to the layer B, the electron donating double bond compound is preferably a polymer compound. In the case where the layer A is an upper layer with respect to the layer B, the electron donating double bond compound is preferably a low molecular compound. When the electron donating double bond compound is a polymer compound, as the main chain of the polymer compound, a known polymer main chain, for example, an acrylic resin, a methacrylic resin, a styrene resin, a vinyl resin, a urethane resin, a urea resin, an amide resin, an ester resin, a carbonate resin, a novolac resin, an epoxy resin or an alkylene oxide resin can be used. Among them, an acrylic resin, a methacrylic resin, a styrene resin, a vinyl resin, a urethane resin, a urea resin, an amide resin, an ester resin and a carbonate resin are more preferable and an acrylic resin, a methacrylic resin, a styrene resin, a vinyl resin or a urethane resin are particularly preferable. When the electron donating double bond compound is a polymer compound, the weight average molecular weight thereof is preferably 5,000 or more, more preferably 10,000 or more. By adjusting the weight average molecular weight to 5,000 or more, good printing durability is obtained. The weight average molecular weight thereof is particularly preferably from 10,000 to 500,000.

In the electron donating double bond compound, the amount of the functional group represented by formula (1) is preferably from 0.01 to 50 mmol/g, more preferably from 0.05 to 25 mmol/g, particularly preferably from 0.1 to 10 mmol/g. Two or more of the functional groups represented by formula (1) may be contained in the electron donating double bond compound.

When the electron donating double bond compound for use in the invention is incorporated into a layer adjacent to the support, for example, an undercoat layer, it is preferred that the compound further has a functional group (substrate

adhesion group) capable of interacting with the surface of support. By the introduction of the substrate adhesion group, printing durability of the image area and stain resistance in the non-image area are improved. The substrate adhesion group can be appropriately selected according to the support used. In the case of using an aluminum support conventionally used as the support for lithographic printing plate precursor, a functional group, for example, a phosphoric acid group or its salt group, a phosphonic acid group or its salt group, an ammonium group, a siloxane group, a β-dicarbonyl group or a carboxylic acid group or its salt group is exemplified, although a specific functional group may be varied depending on the surface treatment of the support. Of the functional groups, a phosphoric acid salt group, a phosphonic acid salt group, an ammonium group, a siloxane group, a β-dicarbonyl group and a carboxylic acid salt group are preferable. The functional groups may be used in combination of two or more thereof. The amount of the substrate adhesion group introduced into the electron donating double bond compound for use in the invention is preferably from 0.01 to 10 mmol/g, more preferably from 0.05 to 5 mmol/g, particularly preferably from 0.1 to 3 mmol/g.

It is preferred that the electron donating double bond compound for use in the invention further has a hydrophilic functional group, when the layer A is a lower layer with respect to the layer B. As the hydrophilic functional group, any functional group capable of increasing the affinity with water may be suitably used. For example, a sulfonic acid (salt) group, an amido group, a polyalkylene oxide group, a carboxylic acid (salt) group, a phosphoric acid (salt) group, a hydroxy group, a sulfuric mono ester (salt) group, an ammonium group, a sulfonamido group, an amino group, a sulfuric mono amido (salt) group, a phosphonium group, a sulfonimido group and a sulfocarboxyimido group are preferable, a sulfonic acid (salt) group, an amido group, a polyalkylene oxide group, a carboxylic acid (salt) group, a phosphoric acid (salt) group, a hydroxy group, a sulfuric mono ester (salt) group, an ammonium group, a sulfonamido group, an amino group and a sulfuric mono amido (salt) group are more preferable, and a sulfonic acid (salt) group, an ammonium group, an amido group, a polyalkylene oxide group and a hydroxy group are particularly preferable. When the electron donating double bond compound according to the invention has the hydrophilic functional group, the amount of the hydrophilic functional group introduced into the electron donating double bond compound is preferably from 0.5 to 15 mmol/g, more preferably from 0.75 to 12.5 mmol/g, particularly preferably from 1.0 to 10 mmol/g. By adjusting the amount of the hydrophilic functional group introduced in the range described above, high hydrophilicity is achieved and stain resistance during the printing is improved.

Specific examples of the electron donating double bond compound in the case where the layer A for use in the invention is a lower layer are set forth below, but the invention should not be construed as being limited thereto.

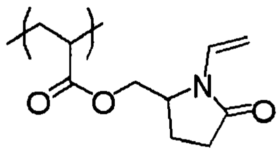
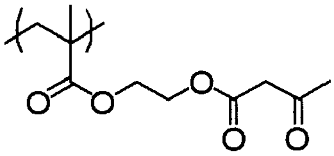
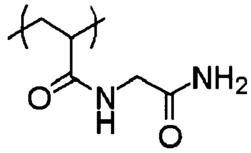

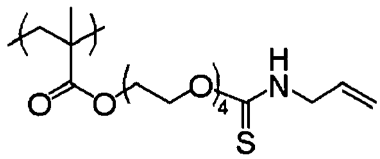
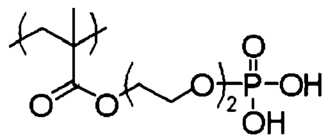
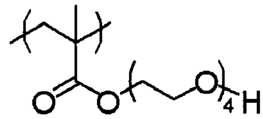

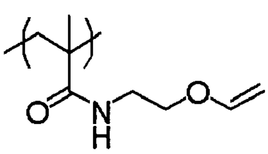
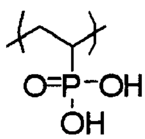
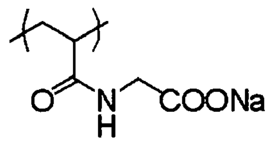

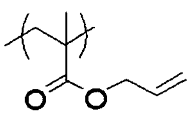
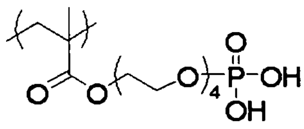
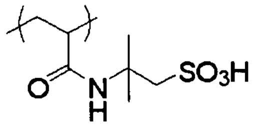

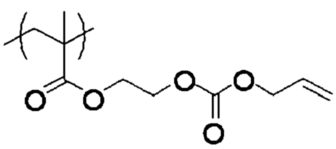
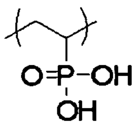
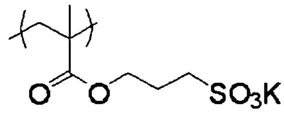

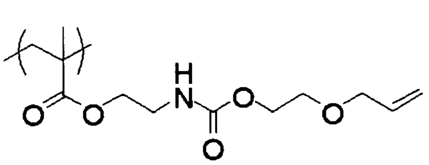
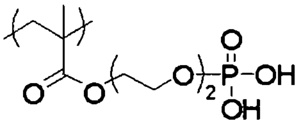
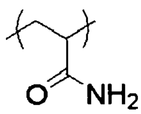

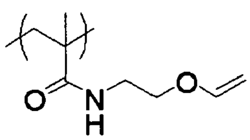
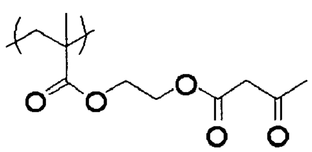
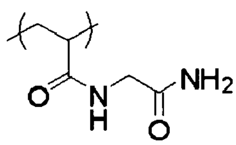

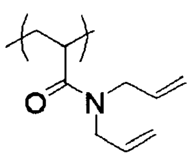
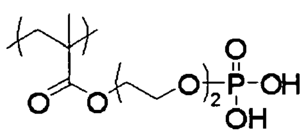
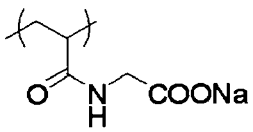

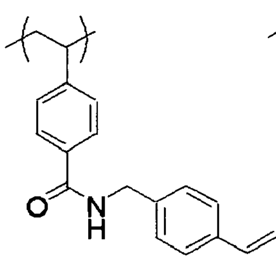
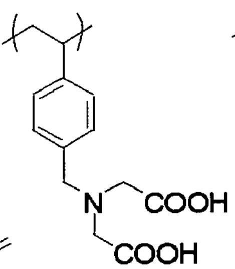
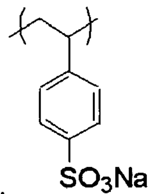

It is preferred that the electron donating double bond compound for use in the invention further has two or more radical polymerizable functional groups in its molecule, when the layer A is an image-forming layer. As the radical polymerizable functional group, the functional group represented by formula (1), an acryl group, a methacryl group and an itaconic acid group are exemplified.

In the case where the layer A is an image-forming layer, the electron donating double bond compound is preferably a low molecular compound. The molecular weight of the low molecular compound is preferably less than 5,000, more preferably less than 4,000, particularly preferably less than 3,000. By using the electron donating double bond compound having the molecular weight of less than 5,000, good printing durability is obtained.

Specific examples of the electron donating double bond compound in the case where the layer A for use in the invention is an image-forming layer are set forth below, but the invention should not be construed as being limited thereto.

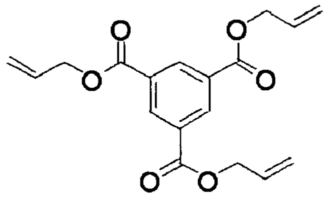

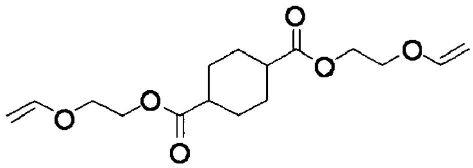

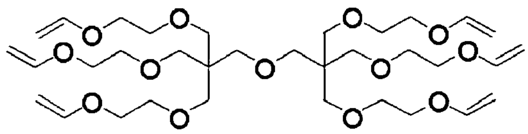

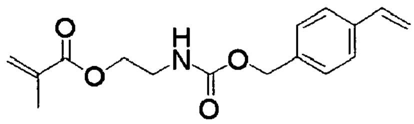

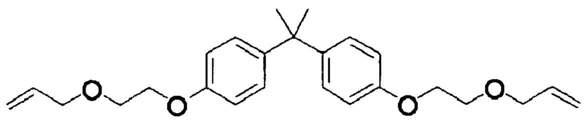

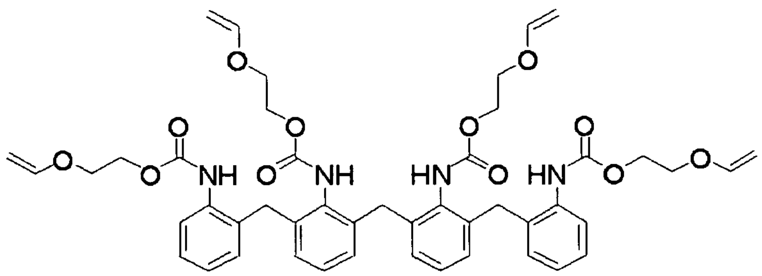

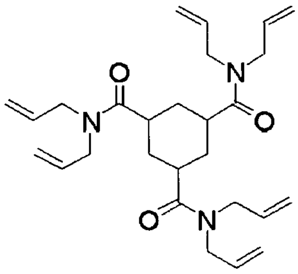

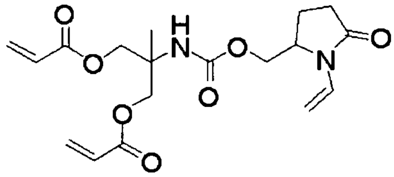

The electron donating double bond compounds for use in the invention may be used individually or as a mixture of two or more thereof.

The content of the electron donating double bond compound for use in the invention in the layer A is preferably 10% by weight or more, more preferably from 20 to 95% by weight, particularly preferably from 30 to 90% by weight, based on the total solid content of the layer A. By adjusting the content of the electron donating double bond compound to the range described above, good printing durability is obtained.

The layer A for use in the invention may optionally contain a binder polymer, a polymerizable compound, a radical polymerization initiator, a sensitizing dye, a co-sensitizer, a polymerization inhibitor, a microcapsule, a surfactant, a hydrophilic polymer, a coloring agent, a print-out agent, a higher fatty acid derivative, a plasticizer, a fine particle, a hydrophilic low molecular weight compound or the like in addition to the electron donating double bond compound described above. These components will be described in detail hereinafter.

[Electron accepting double bond compound]

As the electron accepting double bond compound for use in the lithographic printing plate precursor according to the invention, any compound containing a double bond and having a positive value which is determined by a conventionally known method (reference literature: Polymer Handbook, 4th Edition, Vol. 1, page 309) may be suitably used, a compound containing a double bond and having the value of 1.0 or more is preferably used, and a compound containing a double bond and having the value of 1.5 or more is more preferably used.

The electron accepting double bond compound for use in the lithographic printing plate precursor according to the invention is a compound having a functional group represented by formula (2) shown below.

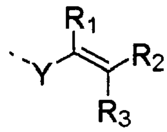
(2)

In formula (2), $R_1$ to $R_3$ each independently represents a hydrogen atom or a monovalent substituent, Y represents -CO- or $-SO_2-$, and a dotted line represents a connecting bond to a mother skeleton of the compound, or any one of $R_1$ to $R_3$ may be connected to the mother skeleton of the compound to form a ring.

Preferably, $R_1$ to $R_3$ each independently represents a hydrogen atom, an alkyl group, an aryl group, an alkenyl group, an alkynyl group, a cyano group, an acyl group, an alkylacyl group, an arylacyl group, an alkoxyacyl group, an aryloxyacyl group, an aminoacyl group or a sulfone group, and Y represents -CO- or $-SO_2-$.

Specific examples of the alkyl group, aryl group, alkenyl group and alkynyl group represented by any one of $R_1$ to $R_3$ in formula (2) include those described in formula (1) above respectively and preferable examples are also same as those described above respectively.

Specific examples of the acyl group represented by any one of $R_1$ to $R_3$ include an alkylacyl group or arylacyl group represented by formula $-COR_{11}$, an alkoxyacyl group or aryloxyacyl group represented by formula $-COOR_{11}$ and an acylamino group represented by formula $-CONR_{11}R_{12}$ In the formulae, $R_{11}$ and $R_{12}$ each represents a hydrogen atom, an alkyl group or an aryl group.

Specific examples of the sulfone group represented by any one of $R_1$ to $R_3$ include a substituent represented by $-SO_2R_{11}$, $-SO_2OR_{11}$, $-SO_2NR_{11}R_{12}$ (wherein $R_{11}$ and $R_{12}$ each represents a hydrogen atom, an alkyl group or an aryl group). Specific examples of the alkyl group represented by any one of $R_{11}$ to $R_{13}$ include the specific examples of the alkyl group described above. Specific examples of the aryl group represented by any one of $R_{11}$ to $R_{13}$ include the

specific examples of the aryl group described above.

For any one of $R_1$ to $R_3$, an alkylacyl group, an arylacyl group, an alkoxyacyl group, an aryloxyacyl group, an aminoacyl group, a sulfone group and a cyano group are particularly preferable.

Of the functional groups represented by formula (2) in the electron accepting double bond compound for use in the invention, functional groups represented by formula (2) wherein Y represents -CO- are preferable, functional groups represented by formula (2) wherein Y represents -CO- and at lest one of $R_1$ to $R_3$ represents an alkylacyl group, an arylacyl group, an alkoxyacyl group, an aryloxyacyl group, an aminoacyl group, a sulfone group or a cyano group are more preferable, functional groups represented by formulae (2-1) to (2-13) shown below are still more preferable, and functional groups represented by formulae (2-1) to (2-9) shown below are particularly preferable.

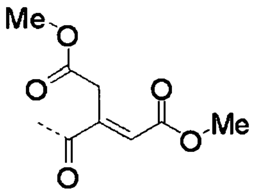
(2-1)

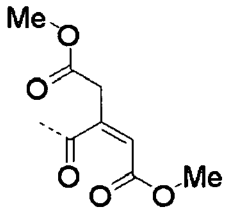
(2-2)

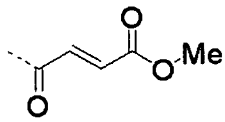
(2-3)

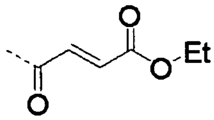
(2-4)

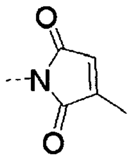
(2-5)

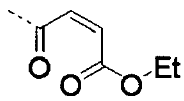
(2-6)

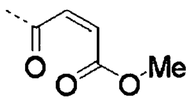
(2-7)

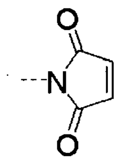
(2-8)

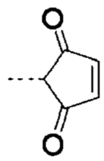
(2-9)

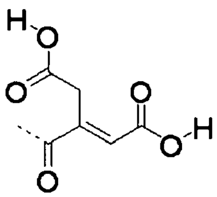
(2-10)

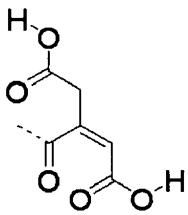
(2-11)

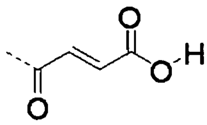
(2-12)

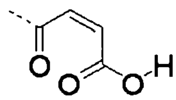
(2-13)

As the electron accepting double bond compound for use in the invention, any low molecular compound and polymer compound may be suitably used as long as they have the functional group represented by formula (2). In the case where the layer B is a lower layer with respect to the layer A, the electron accepting double bond compound is preferably a polymer compound. In the case where the layer B is an upper layer with respect to the layer A, the electron accepting double bond compound is preferably a low molecular compound.

When the electron accepting double bond compound is a polymer compound, as the main chain of the polymer compound, a known polymer main chain, for example, an acrylic resin, a methacrylic resin, a styrene resin, a vinyl resin, a urethane resin, a urea resin, an amide resin, an ester resin, a carbonate resin, a novolac resin, an epoxy resin or an alkylene oxide resin can be used. Among them, an acrylic resin, a methacrylic resin, a styrene resin, a vinyl resin, a urethane resin, a urea resin, an amide resin, an ester resin and a carbonate resin are more preferable and an acrylic resin, a methacrylic resin, a styrene resin, a vinyl resin or a urethane resin are particularly preferable. When the electron accepting double bond compound is a polymer compound, the weight average molecular weight thereof is preferably 5,000 or more, more preferably 10,000 or more. By adjusting the weight average molecular weight to 5,000 or more, good printing durability is obtained. The weight average molecular weight thereof is particularly preferably from 10,000 to 500,000.

In the electron accepting double bond compound, the amount of the functional group represented by formula

(2) is preferably from 0.01 to 50 mmol/g, more preferably from 0.05 to 25 mmol/g, particularly preferably from 0.1 to 10 mmol/g. Two or more of the functional groups represented by formula (2) may be contained in the electron accepting double bond compound.

When the electron donating double bond compound for use in the invention is incorporated into a layer adjacent to the support, for example, an undercoat layer, it is preferred that the compound further has a functional group (substrate adhesion group) capable of interacting with the surface of support. By the introduction of the substrate adhesion group, printing durability of the image area and stain resistance in the non-image area are improved. The substrate adhesion group can be appropriately selected according to the support used. In the case of using an aluminum support conventionally used as the support for lithographic printing plate precursor, a functional group, for example, a phosphoric acid group or its salt group, a phosphonic acid group or its salt group, an ammonium group, a siloxane group, a β-dicarbonyl group or a carboxylic acid group or its salt group is exemplified, although a specific functional group may be varied depending on the surface treatment of the support. Of the functional groups, a phosphoric acid salt group, a phosphonic acid salt group, an ammonium group, a siloxane group, a β-dicarbonyl group and a carboxylic acid salt group are preferable. The functional groups may be used in combination of two or more thereof. The amount of the substrate adhesion group introduced into the electron accepting double bond compound for use in the invention is preferably from 0.01 to 10 mmol/g, more preferably from 0.05 to 5 mmol/g, particularly preferably from 0.1 to 3 mmol/g.

It is preferred that the electron accepting double bond compound for use in the invention further has a hydrophilic functional group, when the layer B is a lower layer with respect to the layer A. As the hydrophilic functional group, any functional group capable of increasing the affinity with water may be suitably used. For example, a sulfonic acid (salt) group, an amido group, a polyalkylene oxide group, a carboxylic acid (salt) group, a phosphoric acid (salt) group, a hydroxy group, a sulfuric mono ester (salt) group, an ammonium group, a sulfonamido group, an amino group, a sulfuric mono amido (salt) group, a phosphonium group, a sulfonimido group and a sulfocarboxyimido group are preferable, a sulfonic acid (salt) group, an amido group, a polyalkylene oxide group, a carboxylic acid (salt) group, a phosphoric acid (salt) group, a hydroxy group, a sulfuric mono ester (salt) group, an ammonium group, a sulfonamido group, an amino group and a sulfuric mono amido (salt) group are more preferable, and a sulfonic acid (salt) group, an ammonium group, an amido group, a polyalkylene oxide group and a hydroxy group are particularly preferable. When the electron accepting double bond compound according to the invention has the hydrophilic functional group, the amount of the hydrophilic functional group introduced into the electron accepting double bond compound is preferably from 0.5 to 15 mmol/g, more preferably from 0.75 to 12.5 mmol/g, particularly preferably from 1.0 to 10 mmol/g. By adjusting the amount of the hydrophilic functional group introduced in the range described above, high hydrophilicity is achieved and stain resistance during the printing is improved.

Specific examples of the electron accepting double bond compound in the case where the layer B for use in the invention is a lower layer are set forth below, but the invention should not be construed as being limited thereto.

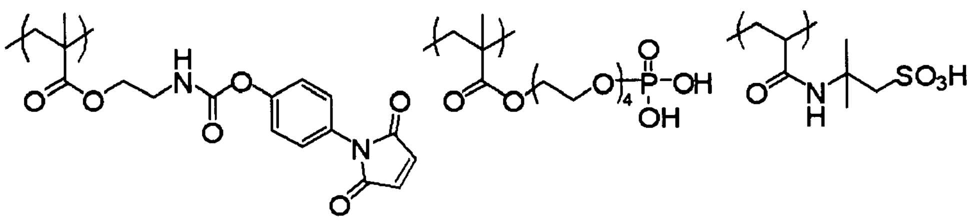

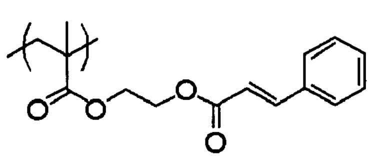

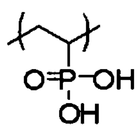

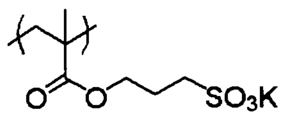

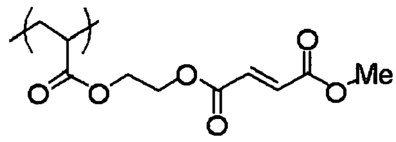
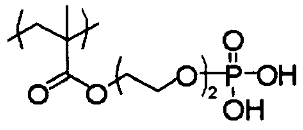
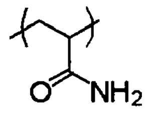

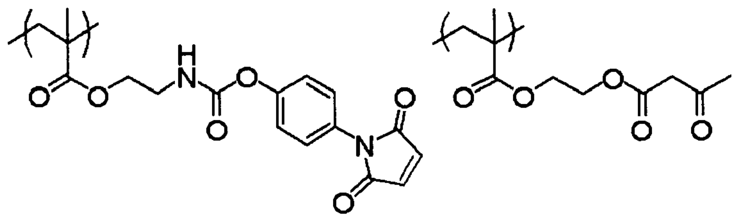
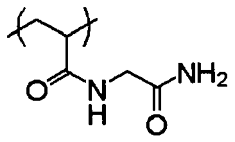

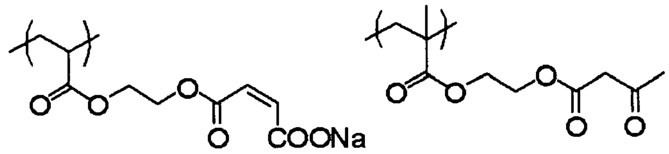

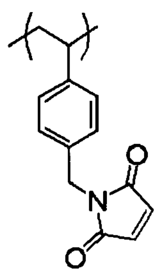
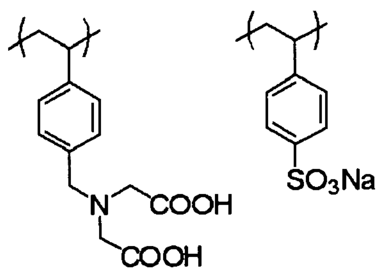

It is preferred that the electron accepting double bond compound for use in the invention further has two or more radical polymerizable functional groups in its molecule, when the layer B is an image-forming layer. As the radical polymerizable functional group, the functional group represented by formula (2), an acryl group, a methacryl group and an itaconic acid group are exemplified.

In the case where the layer B is an image-forming layer, the electron accepting double bond compound is preferably a low molecular compound. The molecular weight of the low molecular compound is preferably less than 5,000, more preferably less than 4,000, particularly preferably less than 3,000. By using the electron accepting double bond compound having the molecular weight of less than 5,000, good printing durability is obtained.

Specific examples of the electron accepting double bond compound in the case where the layer B for use in the invention is an image-forming layer are set forth below, but the invention should not be construed as being limited thereto.

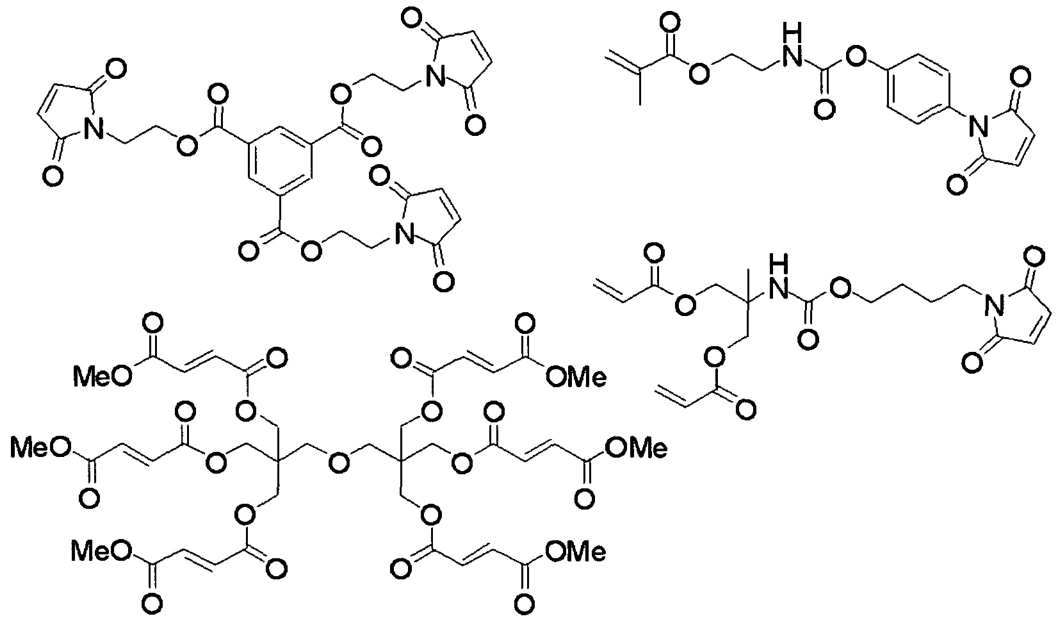

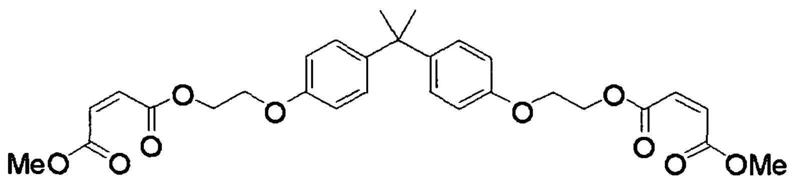

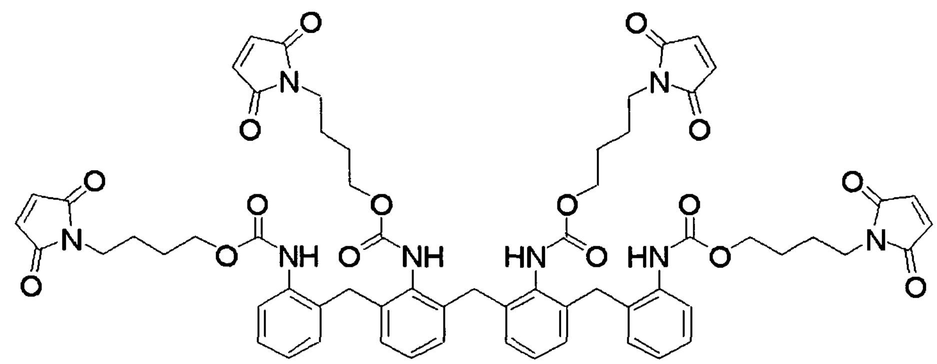

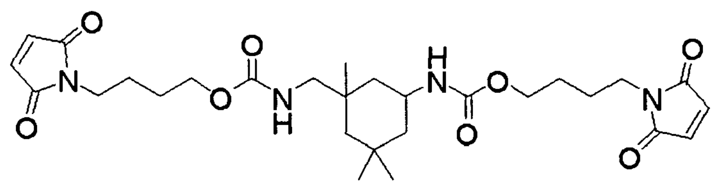

The electron accepting double bond compounds for use in the invention may be used individually or as a mixture of two or more thereof.

The content of the electron accepting double bond compound for use in the invention in the layer B is preferably 10% by weight or more, more preferably from 20 to 95% by weight, particularly preferably from 30 to 90% by weight, based on the total solid content of the layer B. By adjusting the content of the electron accepting double bond compound

to the range described above, good printing durability is obtained.

The layer B for use in the invention may optionally contain a binder polymer, a polymerizable compound, a radical polymerization initiator, a sensitizing dye, a co-sensitizer, a polymerization inhibitor, a microcapsule, a surfactant, a hydrophilic polymer, a coloring agent, a print-out agent, a higher fatty acid derivative, a plasticizer, a fine particle, a hydrophilic low molecular weight compound or the like in addition to the electron accepting double bond compound described above.

The absolute value of difference between the value of the electron donating double bond compound and the value of the electron accepting double bond compound for use in the invention is preferably 2 or more, more preferably 2.1 or more, particularly preferably 2.2 or more. By adjusting the absolute value of difference between the values to 2 or more, it is believed that good mutual copolymerization property is obtained and printing durability is improved.

According to the invention, although any of the layer A and the layer B may be a lower layer or an image-forming layer, it is preferred that the layer A is a lower layer (undercoat layer) and the layer B is an image-forming layer in view of printing durability and stain resistance. Also, it is desirable that the layer A and the layer B are adjacent to each other, and it is more desirable that the undercoat layer is adjacent to the support.

<Binder polymer>

The binder polymer for use in the invention is not particularly restricted but when the development is performed with an alkali solution having pH of 10 or more, a conventionally known alkali-soluble binder is used. As the alkali-soluble binder, a binder polymer having a carboxylic acid group as the alkali-soluble group is preferably employed.

A water-insoluble polymer is preferably used as the binder polymer in the case (1) where the development is performed with an aqueous component and/or oily ink and in the case (2) where the development is performed with an aqueous solution having pH of 2 to 10, each of which is a preferred embodiment of the invention.

Further, the binder polymer which can be used in the invention preferably does not substantially contain an acid group, for example, a carboxyl group, a sulfonic acid group or a phosphoric acid group. An acid value (acid content per g of polymer, indicated by the chemical equivalent number) of the binder polymer is preferably 0.3 meq/g or less, more preferably 0.1 meq/g or less.

Specifically, the binder polymer which can be used in the invention is preferably insoluble in water and an aqueous solution having pH of 10 or more. The solubility of the hydrophobic binder polymer in water or an aqueous solution having pH of 10 or more is preferably 0.5% by weight or less, more preferably 0.1% by weight or less. By using such a binder polymer, film strength, water resistance and ink-receptive property of the image-forming layer are increased and improvement in printing durability can be achieved.

As for the binder polymer, conventionally known binder polymers preferably having the characteristics in the above-described range can be used without limitation as long as the performances of the lithographic printing plate precursor of the invention are not impaired, and a linear organic polymer having film-forming property is preferred.

Preferable examples of such a binder polymer include a polymer selected from an acrylic resin, a vinyl acetal resin, a vinyl resin, a urethane resin, an amide resin, an epoxy resin, a methacrylic resin, a styrene resin and an ester resin. Among them, an acrylic resin, a methacrylic resin and a urethane resin are preferred, and a (meth)acrylic acid ester copolymer is more preferred. More specifically, a copolymer of a (meth)acrylic acid alkyl or aralkyl ester with a (meth)acrylic acid ester containing a $-CH_2CH_2O-$ or $-CH_2CH_2NH-$ unit in R of the ester residue (-COOR) of the (meth) acrylic acid ester is particularly preferred. The alkyl group in the (meth)acrylic acid alkyl ester is preferably an alkyl group having from 1 to 5 carbon atoms, more preferably a methyl group. Preferable examples of the (meth)acrylic acid aralkyl ester include benzyl (meth)acrylate.

The binder polymer can be imparted with a crosslinking property in order to increase the film strength of the image area.

In order to impart the crosslinking property to the binder polymer, a crosslinkable functional group is introduced into a main chain or side chain of the polymer. The crosslinkable functional group may be introduced by copolymerization or a polymer reaction.

The term "crosslinkable functional group" as used herein means a group capable of crosslinking the binder polymer in the process of a radical polymerization reaction which is caused in the image-forming layer when the lithographic printing plate precursor is exposed to light. The crosslinkable functional group is not particularly restricted as long as it has such a function and includes, for example, an ethylenically unsaturated bond group, an amino group or an epoxy group as a functional group capable of conducting an addition polymerization reaction. Also, a functional group capable of forming a radical upon irradiation with light may be used and such a crosslinkable functional group includes, for example, a thiol group, a halogen atom and an onium salt structure. Among them, the ethylenically unsaturated bond group is preferable, and functional groups represented by formulae (1) to (3) shown below are particularly preferable.

Formula (1):

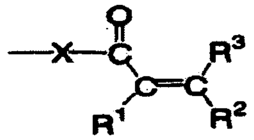

In formula (1), $R^1$ to $R^3$ each independently represents a hydrogen atom or a monovalent organic group. $R^1$ preferably includes, for example, a hydrogen atom or an alkyl group which may have a substituent. Among them, a hydrogen atom or a methyl group is more preferable because of high radical reactivity. $R^2$ and $R^3$ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is more preferable because of high radical reactivity.

X represents an oxygen atom, a sulfur atom or $-N(R^{12})-$, and $R^{12}$ represents a hydrogen atom or a monovalent organic group. The monovalent organic group represented by $R^{12}$ includes, for example, an alkyl group which may have a substituent. A hydrogen atom, a methyl group, an ethyl group or an isopropyl group is preferable for $R^{12}$ because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

Formula (2):

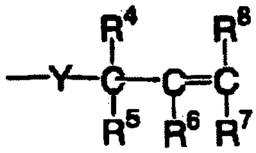

In formula (2), $R^4$ to $R^8$ each independently represents a hydrogen atom or a monovalent organic group. $R^4$ to $R^8$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable.

Examples of the substituent introduced include those described in Formula (1).

Y represents an oxygen atom, a sulfur atom or $-N(R^{12})-$, and $R^{12}$ has the same meaning as $R^{12}$ defined in Formula (1). Preferable examples for $R^{12}$ are also same as those described in Formula (1).

Formula (3):

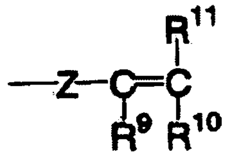

In formula (3), $R^9$ to $R^{11}$ each independently represents a hydrogen atom or a monovalent organic group. The monovalent organic group includes, for example, an alkyl group which may have a substituent. A hydrogen atom or a methyl group is preferable for $R^9$ because of high radical reactivity. $R^{10}$ and $R^{11}$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

Examples of the substituent introduced include those described in Formula (1).

Z represents an oxygen atom, a sulfur atom, -N($R^{13}$)- or a phenylene group which may have a substituent. $R^{13}$ includes an alkyl group which may have a substituent or the like. Among them, a methyl group, an ethyl group or an isopropyl group is preferable for $R^{13}$ because of high radical reactivity.

Among the polymers, a (meth)acrylic acid copolymer and a polyurethane each having a crosslinkable functional group in the side chain thereof are more preferable.

In the binder polymer having a crosslinking property, for example, a free radical (a polymerization initiating radical or a propagating radical in the process of polymerization of the polymerizable compound) is added to the crosslinkable functional group to cause addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the crosslinkable functional group) in the polymer is withdrawn by a free radical to produce a polymer radical and the polymer radicals are combined with each other to form crosslinking between the polymer molecules to effect curing.

The content of the crosslinkable functional group (content of radical-polymerizable unsaturated double bond determined by iodine titration) in the binder polymer is preferably from 0.1 to 10.0 mmol, more preferably from 1.0 to 7.0 mmol, most preferably from 2.0 to 5.5 mmol, per g of the binder polymer.

In view of improvement in the developing property with an aqueous solution, the binder polymer is preferably hydrophilic. On the other hand, in view of increasing the printing durability, it is important that the binder polymer has good compatibility with the polymerizable compound contained in the image-forming layer, that is, the binder polymer is preferably oleophilic. From these standpoints, it is also effective in the invention to copolymerize a hydrophilic group-containing component and an oleophilic group-containing component in the binder polymer in order to improve the developing property and printing durability. Examples of the hydrophilic group-containing component preferably include components having a hydrophilic group, for example, a hydroxy group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amido group and a carboxymethyl group.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymer may be any of a random polymer, a block polymer, a graft polymer and the like, and it is preferably a random polymer.

The binder polymers may be used individually or in combination of two or more thereof.

The content of the binder polymer is ordinarily from 5 to 90% by weight, preferably from 10 to 70% by weight, more preferably from 10 to 60% by weight, based on the total solid content of the image-forming layer. In the range described above, preferable strength of the image area and good image-forming property are obtained.

<Radical polymerizable compound>

The radical polymerizable compound (hereinafter, also simply referred to as a "polymerizable compound") for use in the image-forming layer according to the invention is an addition-polymerizable compound having at least one ethylenically unsaturated double bond, and it is selected from compounds having at least one, preferably two or more, terminal ethylenically unsaturated double bonds. Such compounds are widely known in the art and they can be used in the invention without any particular limitation. The compound has a chemical form, for example, a monomer, a prepolymer, specifically, a dimer, a trimer or an oligomer, or a copolymer thereof, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate

or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate or polyester acrylate oligomer; methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis [p-(3-methacryloxy-2-hydroxypropoxy)phenyl]dimethylmethane or bis[p-(methacryloxyethoxy)phenyl]dimethylmethane; itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate;

crotonic acid esters, for example, ethylene glycol dicrotonate, tetramethylene glycol dicrotonate, pentaerythritol dicrotonate or sorbitol tetracrotonate;

isocrotonic acid esters, for example, ethylene glycol diisocrotonate, pentaerythritol diisocrotonate or sorbitol tetraisocrotonate;

and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-51-47334 (the term "JP-B" as used herein means an "examined Japanese patent publication") and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R_4)COOCH_2CH(R_5)OH \qquad (A)$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive composition having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers

or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use or an amount added, can be appropriately determined in accordance with the characteristic design of the final lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the image-forming layer. For instance, the compatibility may be improved in some cases by using the compound of low purity or using two or more kinds of the compounds in combination. A specific structure may be selected for the purpose of improving an adhesion property to a support, a protective layer or the like described hereinafter.

The polymerizable compound is used preferably in a range of 5 to 80% by weight, more preferably in a range of 25 to 75% by weight, based on the total solid content of the image-forming layer. The polymerizable compounds may be used individually or in combination of two or more thereof. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

<Radical polymerization initiator>

The radical polymerization initiator for use in the image-forming layer according to the invention (which may be referred merely as "polymerization initiator" in the following descriptions) is a compound which generates a radical with light energy or heat energy to initiate or accelerate polymerization of a polymerizable compound. The radical polymerization initiator is appropriately selected to use, for example, from known radical polymerization initiators and compounds containing a bond having small bond dissociation energy.

The radical polymerization initiators include, for example, organic halogen compounds, carbonyl compounds, organic peroxides, azo compounds, azido compounds, metallocene compounds, hexaarylbiimidazole compounds, organic boron compounds, disulfone compounds, oxime ester compounds and onium salt compounds.

The organic halogen compounds described above specifically include, for example, compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Among them, oxazole compounds and s-triazine compounds each substituted with a trihalomethyl group are preferable.

More preferably, s-triazine derivatives in which at least one of mono-, di- or tri-halogen substituted methyl group is connected to the s-triazine ring and oxazole derivatives in which at least one of mono-, di- or tri-halogen substituted methyl group is connected to the oxazole ring are exemplified. Specific examples thereof include
2,4,6-tris(monochloromethyl)-s-triazine, 2,4,6-tris(dichloromethyl)-s-triazine,
2,4,6-tris(trichloromethyl)-s-triazine, 2-methyl-4,6-bis(trichloromethyl)-s-triazine,
2-n-propyl-4,6-bis(trichloromethyl)-s-triazine,
2-(α,α,β-trichloroethyl)-4,6-bis(trichloromethyl)-s-triazine,
2-(3,4-epoxyphenyl)-4,6-bis(trichloromethyl)-s-triazine,
2-[1-(p-methoxyphenyl)-2,4-butadienyl]-4,6-bis(trichloromethyl)-s-triazine,
2-styryl-4,6-bis(trichloromethyl)-s-triazine,
2-(p-methoxystyryl-4,6-bis(trichloromethyl)-s-triazine,
2-(p-isopropyloxystyryl-4,6-bis(trichloromethyl)-s-triazine,
2-(p-tolyl)-4,6-bis(trichloromethyl)-s-triazine,
2-(4-methoxynaphthyl)-4,6-bis(trichloromethyl)-s-triazine,
2-phenylthio-4,6-bis(trichloromethyl)-s-triazine,
2-benzylthio-4,6-bis(trichloromethyl)-s-triazine, 2,4,6-tris(dibromomethyl)-s-triazine,
2,4,6-tris(tribromomethyl)-s-triazine, 2-methyl-4,6-bis(tribromomethyl)-s-triazine,
2-methoxy-4,6-bis(tribromomethyl)-s-triazine and compounds shown below.

(I)-1

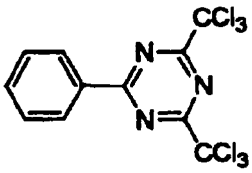

(I)-2

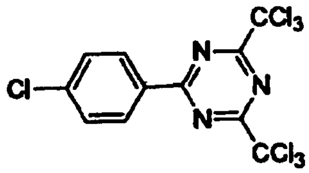

(I)-3

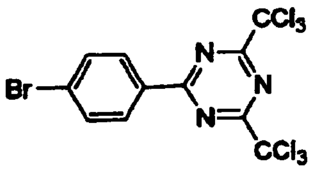

(I)-4

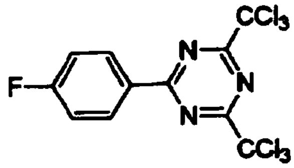

(I)-5

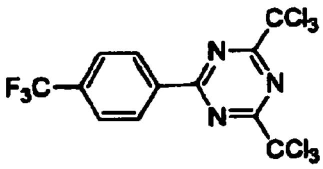

(I)-6

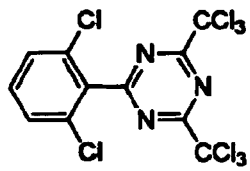

(I)-7

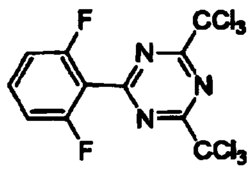

(I)-8

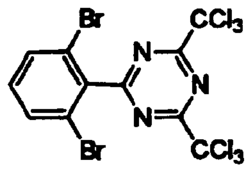

(I)-9

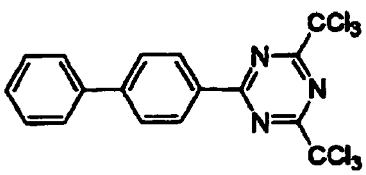

(I)-10

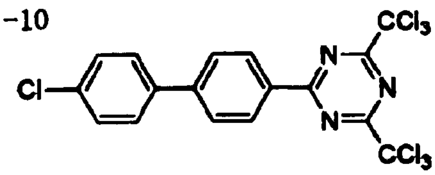

(I)-11

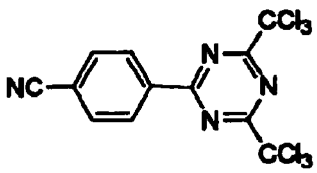

(I)-12

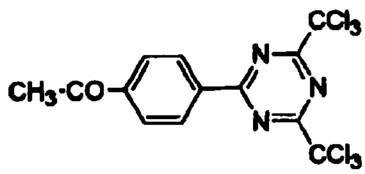

(I)-13

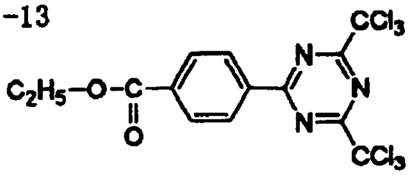

(I)-14

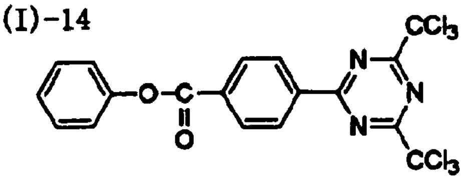

(I)-15

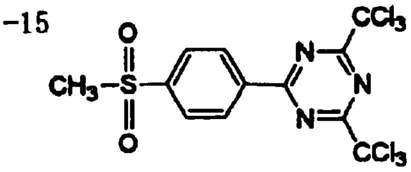

(I)-16

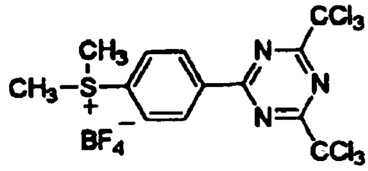

(I)-17

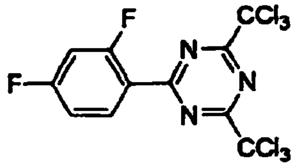

(I)-18

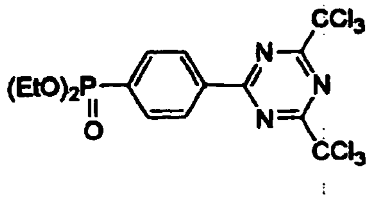

(I)-19

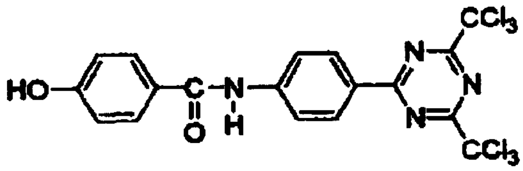

(I)-20

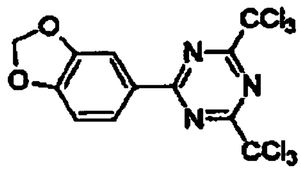

(I)-21

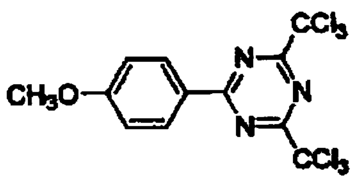

(I)-22

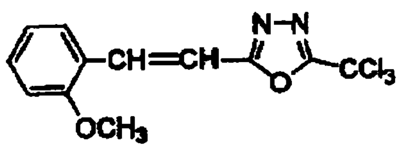

(I)-23

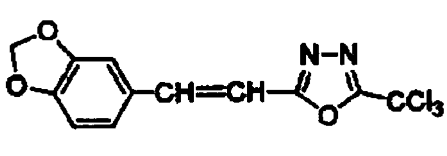

(I)-24

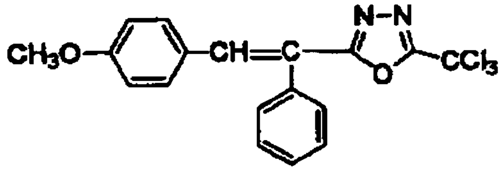

(I)-25

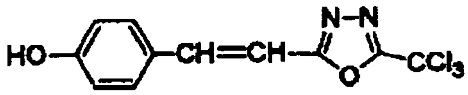

(I)-26

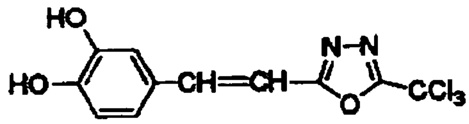

(I)-27

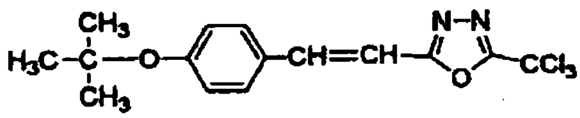

The carbonyl compounds described above include, for example, benzophenone derivatives, e.g., benzophenone, Michler's ketone, 2-methylbenzophenone, 3-methylbenzophenone, 4-methylbenzophenone, 2-chlorobenzophenone, 4-bromobenzophenone or 2-carboxybenzophenone, acetophenone derivatives, e.g., 2,2-dimethoxy-2-phenylacetophenone, 2,2-diethoxyacetophenone, 1-hydroxycyclohexylphenylketone, α-hydroxy-2-methylphenylpropane, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propane or 1,1,1,-trichloromethyl-(p-butylphenyl)ketone, thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone, and benzoic acid ester derivatives, e.g., ethyl p-dimethylaminobenzoate or ethyl p-diethylaminobenzoate.

The azo compounds described above include, for example, azo compounds described in JP-A-8-108621.

The organic peroxides described above include, for example, trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butylhydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, peroxy succinic acid, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy dicarbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy laurate, tersyl carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

The metallocene compounds described above include, for example, various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-triafluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-triafluorophen-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, or bis(cyclopentadienyl)-bis(2,6-difluoro-3-(pyr-1-yl)phenyl) titanium and iron-arene complexes described in JP-A-1-304453 and JP-A-1-152109.

The hexaarylbiimidazole compounds described above include, for example, various compounds described in JP-B-6-29285 and U.S. Patents 3,479,185, 4,311,783 and 4,622,286, specifically, for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The organic boron compounds described above include, for example, organic boric acid salts described in JP-A-62-143044, JP-A-62-150242, JP-A-9-188685, JP-A-9-188686, JP-A-9-188710, JP-A-2000-131837, JP-A-2002-107916, Japanese Patent 2764769, JP-A-2002-116539 and Martin Kunz, Rad Tech '98, Proceeding, April 19-22 (1998), Chicago, organic boron sulfonium complexes or organic boron oxosulfonium complexes described in JP-A-6-157623, JP-A-6-175564 and JP-A-6-175561, organic boron iodonium complexes described in JP-A-6-175554 and JP-A-6-175553, organic boron phosphonium complexes described in JP-A-9-188710, and organic boron transition metal coordination complexes described in JP-A-6-348011, JP-A-7-128785, JP-A-7-140589, JP-A-7-306527 and JP-A-7-292014.

The disulfone compounds described above include, for example, compounds described in JP-A-61-166544 and JP-A-2002-328465.

The oxime ester compounds described above include, for example, compounds described in J. C. S. Perkin II, 1653-1660 (1979), J. C. S. Perkin II, 156-162 (1979), Journal of Photopolymer Science and Technology, 202-232 (1995) and JP-A-2000-66385, and compounds described in JP-A-2000-80068. Specific examples thereof include compounds represented by the following structural formulae:

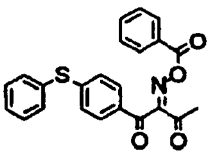 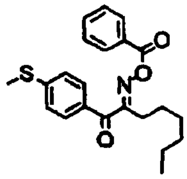 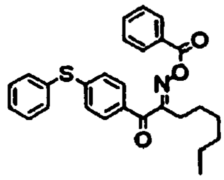 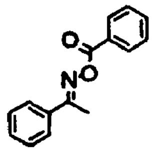 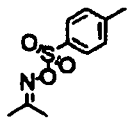

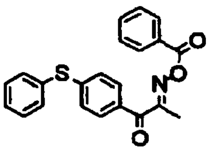 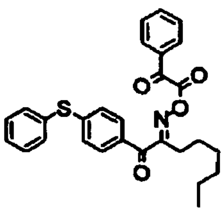 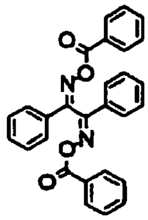 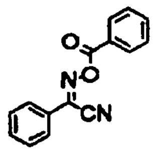 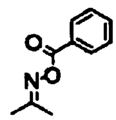

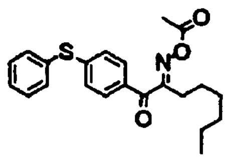 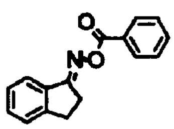 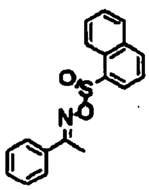 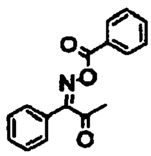 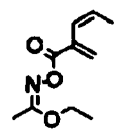

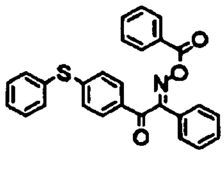 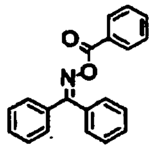 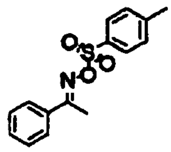 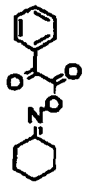 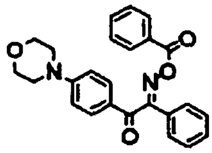

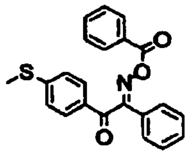 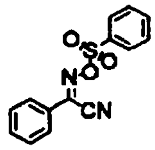

The onium salt compounds described above include onium salts, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827 and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh, Proc. Conf. Rad. Curing ASIA, p. 478, Tokyo, Oct. (1988).

In the invention, the onium salt functions not as an acid generator, but as an ionic radical polymerization initiator.

The onium salts preferably used in the invention include onium salts represented by the following formulae (RI-I) to (RI-III):

$$Ar_{11}-\overset{+}{N}\equiv N \qquad Z_{11}^{-} \qquad (RI-I)$$

$$Ar_{21}-\overset{+}{I}-Ar_{22} \qquad Z_{21}^{-} \qquad (RI-II)$$

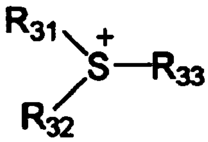 $Z_{31}^{-}$ (RI-III)

In formula (RI-I), $Ar_{11}$ represents an aryl group having 20 or less carbon atoms, which may have 1 to 6 substituents. Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylimino group having from 1 to 12 carbon atoms, an alkylamido group or arylamido having from 1 to 12 carbon atoms, a carbonyl group, a carboxyl

group, a cyano group, a sulfonyl group, an thioalkyl group having from 1 to 12 carbon atoms and an thioaryl group having from 1 to 12 carbon atoms. $Z_{11}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion and a sulfate ion. Among them, a perchlorate ion, a hexafluorophosphate ion, a tetrafluoroborate ion, a sulfonate ion and a sulfinate ion are preferred in view of stability.

In the formula (RI-II), $Ar_{21}$ and $Ar_{22}$ each independently represents an aryl group having 20 or less carbon atoms, which may have 1 to 6 substituents. Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylimino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. $Z_{21}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), $R_{31}$, $R_{32}$ and $R_{33}$ each independently represents an aryl group having 20 or less carbon atoms, which may have 1 to 6 substituents, an alkyl group, an alkenyl group or an alkynyl group. Among them, the aryl group is preferred in view of reactivity and stability. Preferable examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylimino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. $Z_{31}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

Specific examples of the onium salt are set forth below, but the invention should not be construed as being limited thereto.

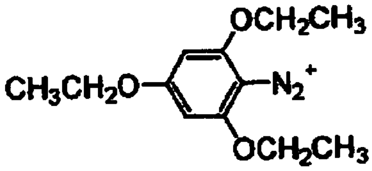 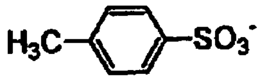 (N-1)

$PF_6^-$ (N-2)

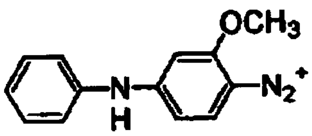 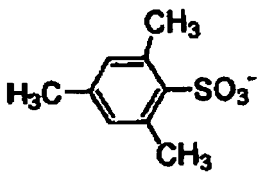 (N-3)

$ClO_4^-$ (N-4)

$PF_6^-$ (N-5)

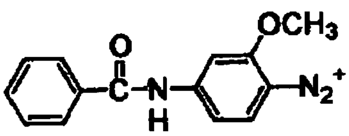

$CF_3SO_3^-$ (N-6)

$BF_4^-$ (N-7)

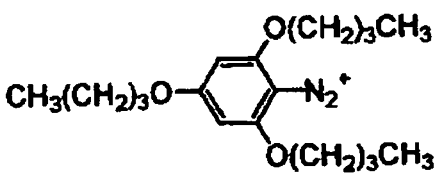 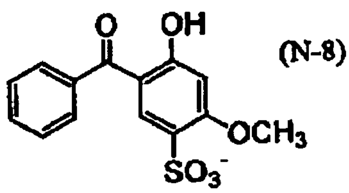 (N-8)

$ClO_4^-$ (N-9)

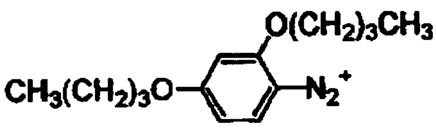 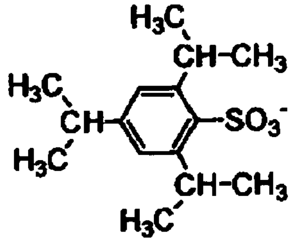 (N-10)

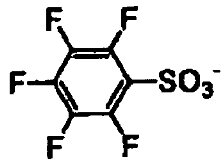 (N-11)

$PF_6^-$ (N-12)

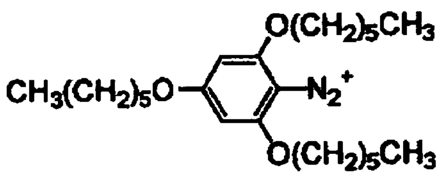 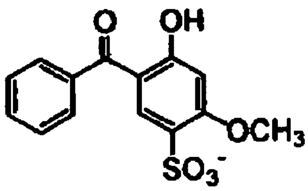 (N-13)

$ClO_4^-$ (N-14)

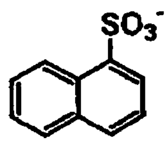 (N-15)

$PF_6^-$ (N-16)

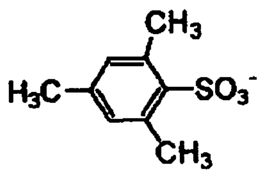 (N-17)

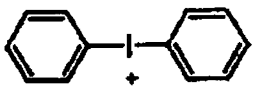

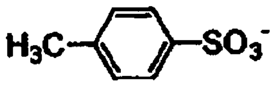

(I-1)

$PF_6^-$ (I-2)

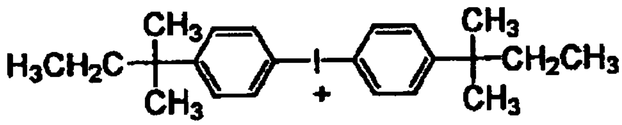

$PF_6^-$ (I-3)

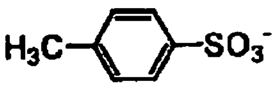 (I-4)

$ClO_4^-$ (I-5)

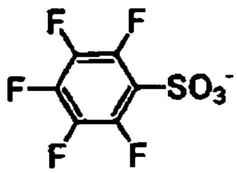 (I-6)

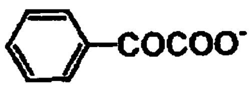 (I-7)

$CF_3SO_3^-$ (I-8)

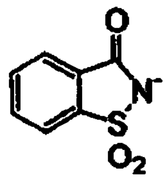 (I-9)

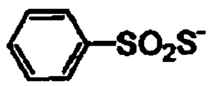 (I-10)

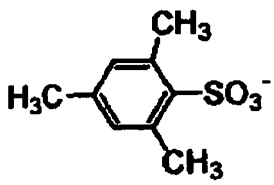 (I-11)

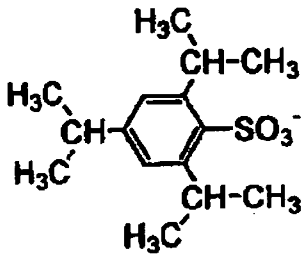 (I-12)

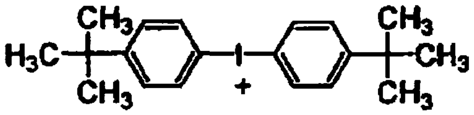
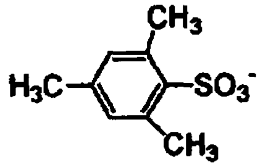
(I-13)

$ClO_4^-$ (I-14)

$PF_6^-$ (I-15)

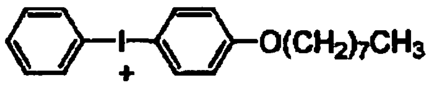
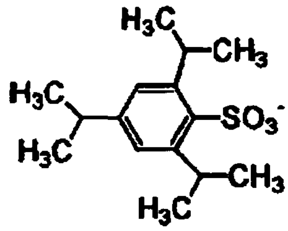
(I-16)

$CF_3COO^-$ (I-17)

$CF_3SO_3^-$ (I-18)

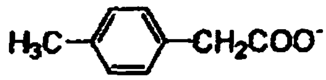
(I-19)

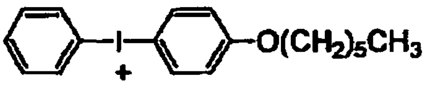
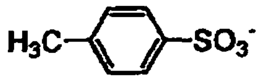
(I-20)

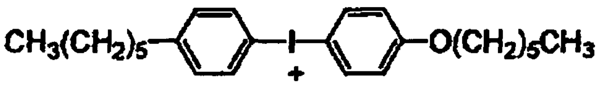
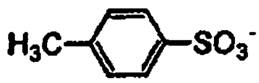
(I-21)

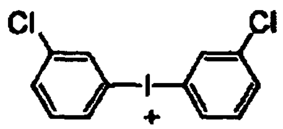

$BF_4^-$ (I-22)

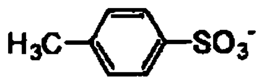
(I-23)

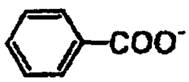
(I-24)

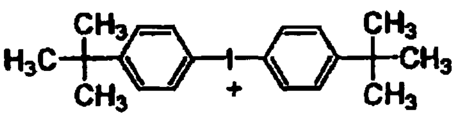 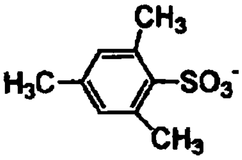 (I-13)

$ClO_4^-$ (I-14)

$PF_6^-$ (I-15)

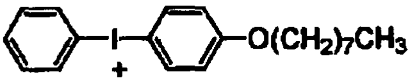 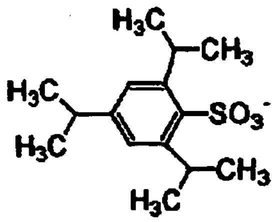 (I-16)

$CF_3COO^-$ (I-17)

$CF_3SO_3^-$ (I-18)

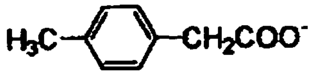 (I-19)

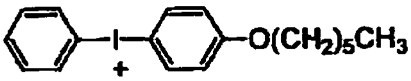 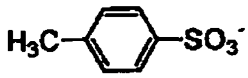 (I-20)

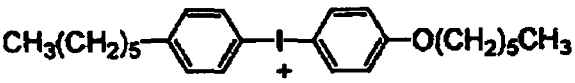 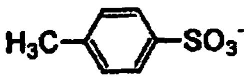 (I-21)

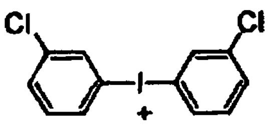

$BF_4^-$ (I-22)

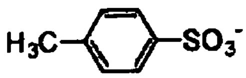 (I-23)

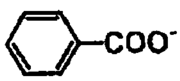 (I-18)

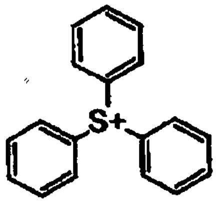

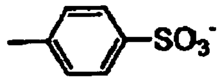 (S-1)

$PF_6^-$ (S-2)

$ClO_4^-$ (S-3)

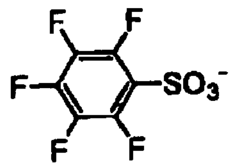 (S-4)

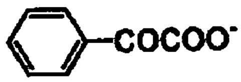 (S-5)

$CF_3SO_3^-$ (S-6)

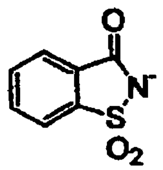 (S-7)

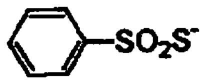 (S-8)

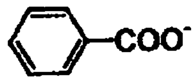 (S-9)

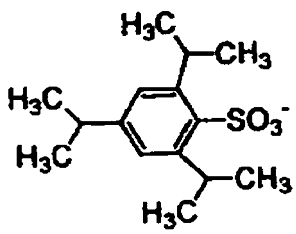 (S-10)

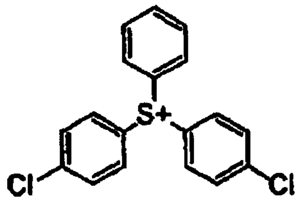

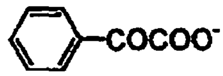 (S-11)

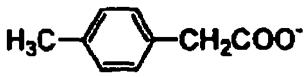 (S-12)

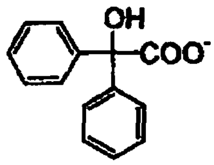 (S-13)

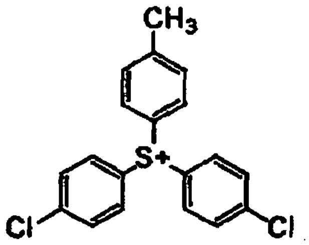

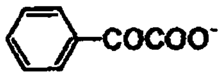 (S-14)

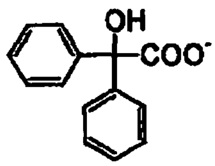 (S-15)

$BF_4^-$ (S-16)

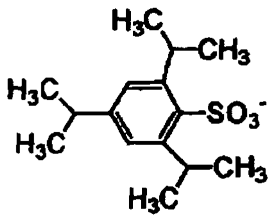 (S-17)

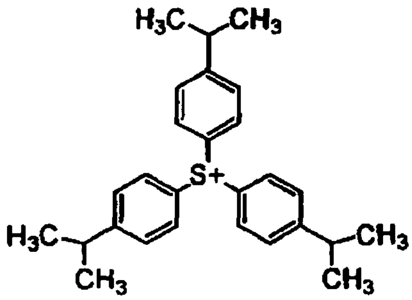

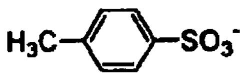 (S-18)

The radical polymerization initiator is not limited to those described above. In particular, from the standpoint of reactivity and stability, the triazine type initiators, organic halogen compounds, metallocene compounds, hexaarylbiimidazole compounds, organic boron compounds, oxime ester compounds and onium salt compounds are preferable and the triazine type initiators, organic halogen compounds, metallocene compounds, hexaarylbiimidazole compounds and onium salt compounds are more preferable.

The radical polymerization initiator can be added preferably in an amount from 0.1 to 50% by weight, more preferably from 0.5 to 30% by weight, particularly preferably from 0.8 to 20% by weight, based on the total solid content of the image-forming layer.

<Sensitizing dye having absorption maximum in wavelength range of 350 to 1,200 nm>

The sensitizing dye having an absorption maximum in a wavelength range of 350 to 1,200 nm for use in the image-forming layer according to the invention is not particularly restricted and can be appropriately selected depending on the intended use or the like. For instance, an infrared absorbing agent and a sensitizing dye absorbing light of 350 to 450 nm are exemplified.

[Infrared absorbing agent]

The infrared absorbing agent is a component used for increasing sensitivity to an infrared laser. The infrared absorbing agent has a function of converting the infrared ray absorbed to heat. The infrared absorbing agent for use in the invention is preferably a dye or pigment having an absorption maximum in a wavelength range of 760 to 1,200 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Examples of preferable dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) in U.S. Patent 4,756,993.

Other preferable examples of the infrared absorbing dye include specific indolenine cyanine dyes described in JP-A-2002-278057 as illustrated below.

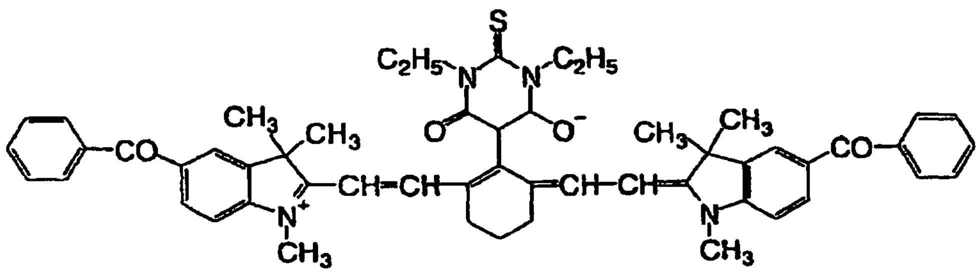

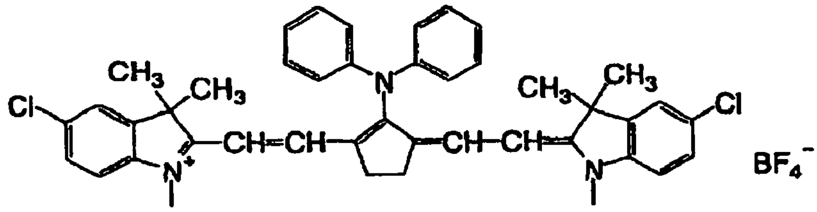

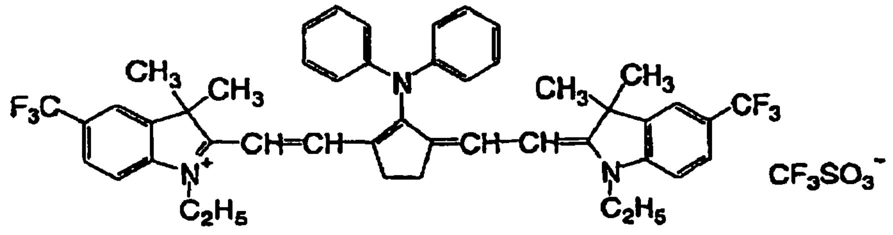

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferable example of the dye, a cyanine dye represented by the following formula (I) is exemplified.

Formula (I):

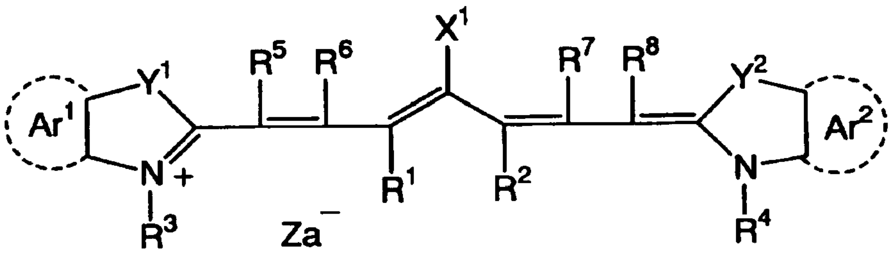

In formula (I), $X^1$ represents a hydrogen atom, a halogen atom, $-NPh_2$, $X^2$-$L^1$ or a group shown below. $X^2$ represents an oxygen atom, a nitrogen atom or a sulfur atom, $L^1$ represents a hydrocarbon group having from 1 to 12 carbon atoms, an aromatic ring containing a hetero atom or a hydrocarbon group having from 1 to 12 carbon atoms and containing a hetero atom. The hetero atom indicates here a nitrogen atom, a sulfur atom, an oxygen atom, a halogen atom or a selenium atom. $Xa^-$ has the same meaning as $Za^-$ defined hereinafter. $R^a$ represents a substituent selected from a hydrogen atom, an alkyl group, an aryl group, a substituted or unsubstituted amino group and a halogen atom.

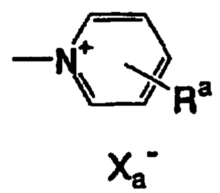

$R^1$ and $R^2$ each independently represents a hydrocarbon group having from 1 to 12 carbon atoms. In view of the preservation stability of a coating solution for image-forming layer, it is preferred that $R^1$ and $R^2$ each represents a hydrocarbon group having two or more carbon atoms, and it is particularly preferred that $R^1$ and $R^2$ are combined with each other to form a 5-membered or 6-membered ring.

$Ar^1$ and $Ar^2$, which may be the same or different, each represents an aromatic hydrocarbon group which may have a substituent. Preferable examples of the aromatic hydrocarbon group include a benzene ring and a naphthalene ring. Also, preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (I) has an anionic substituent in the

structure thereof and neutralization of charge is not needed. Preferable examples of the counter ion for $Za^-$ include a halogen ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for image-forming layer.

Specific examples of the cyanine dye represented by formula (I), which can be preferably used in the invention, include those described in Paragraph Nos. [0017] to [0019] of JP-A-2001-133969.

Further, other particularly preferable examples include specific indolenine cyanine dyes described in JP-A-2002-278057 described above.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after the surface treatment. For the surface treatment, a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984) and Saishin Ganryo Oyo Gijutsu (Newest Application on Technologies for Pigments), CMC Publishing Co., Ltd. (1986).

The pigment has a particle size of preferably from 0.01 to 10 μm, more preferably from 0.05 to 1 μm, particularly preferably from 0.1 to 1 μm. In the range described above, good stability and good uniformity of the pigment dispersion in the image-forming layer can be obtained.

For dispersing the pigment, known dispersion techniques for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application on Technologies for Pigments), CMC Publishing Co., Ltd. (1986).

The infrared absorbing agent may be added by being incorporated into a microcapsule.

With respect to the amount of the infrared absorbing agent added, the amount is so controlled that absorbance of the image-forming layer at the maximum absorption wavelength in the wavelength region of 760 to 1,200 nm measured by reflection measurement is in a range of 0.3 to 1.3, preferably in a range of 0.4 to 1.2. In the range described above, the polymerization reaction proceeds uniformly in the thickness direction of the image-forming layer and good film strength of the image area and good adhesion property of the image area to the lower layer are achieved.

The absorbance of the image-forming layer can be controlled depending on the amount of the infrared absorbing agent added to the image-forming layer and the thickness of the image-forming layer. The measurement of the absorbance can be carried out in a conventional manner. The method for measurement includes, for example, a method of forming an image-forming layer having a thickness determined appropriately in the range necessary for the lithographic printing plate precursor on a reflective support, for example, an aluminum plate, and measuring reflection density of the image-forming layer by an optical densitometer or a spectrophotometer according to a reflection method using an integrating sphere.

[Sensitizing dye absorbing light of 350 to 450 nm]

The sensitizing dye absorbing light of 350 to 450 nm includes a sensitizing dye having an absorption maximum in a wavelength range of 350 to 450 nm, for example, merocyanine dyes represented by formula (I) shown below, benzopyranes or coumarins represented by formula (II) shown below, aromatic ketones represented by formula (III) shown below and anthracenes represented by formula (IV) shown below.

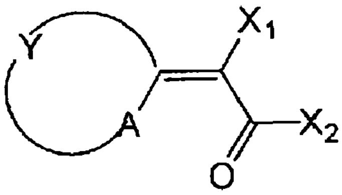

(I)

In formula (I), A represents a sulfur atom or $NR_6$, $R_6$ represents a monovalent non-metallic atomic group, Y represents a non-metallic atomic group necessary for forming a basic nucleus of the dye together with adjacent A and the adjacent carbon atom, and $X_1$ and $X_2$ each independently represents a monovalent non-metallic atomic group or $X_1$ and $X_2$ may be combined with each other to form an acidic nucleus of the dye.

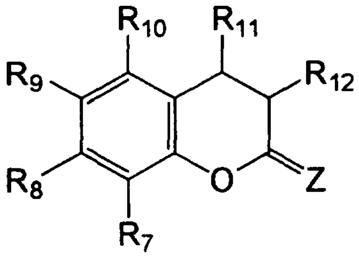

(II)

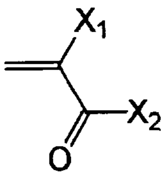

(I')

In formula (II), =Z represents an oxo group, a thioxo group, an imino group or an alkylydene group represented by the partial structural formula (I') described above, $X_1$ and $X_2$ have the same meanings as defined in formula (I) respectively, and $R_7$ to $R_{12}$ each independently represents a monovalent non-metallic atomic group.

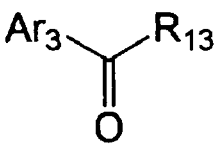

(III)

In formula (III), $Ar_3$ represents an aromatic group which may have a substituent or a heteroaromatic group which may have a substituent, and $R_{13}$ represents a monovalent non-metallic atomic group. $R_{13}$ preferably represents an aromatic group or a heteroaromatic group. $Ar_3$ and $R_{13}$ may be combined with each other to form a ring.

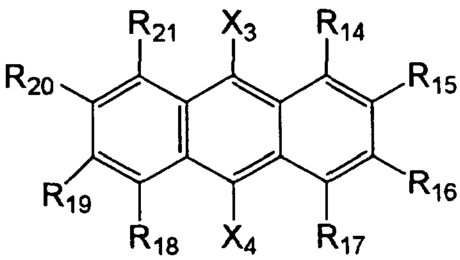

(IV)

In formula (IV), $X_3$, $X_4$ and $R_{14}$ to $R_{21}$ each independently represents a monovalent non-metallic atomic group. Preferably, $X_3$ and $X_4$ each independently represents an electron-donating group having a negative Hammett substituent constant.

In formulae (I) to (IV), preferable examples of the monovalent non-metallic atomic group represented by any one of $X_1$ to $X_4$ and $R_6$ to $R_{21}$ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an

isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methyl-carbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group), a heteroaryl group (for example, a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrine, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl-carbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N', N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an

"alkylphosphonatooxy group"), a monoarylphosphonooxy group ($-OPO_3H$(aryl)) and its conjugated base group (hereinafter referred to as an "arylphosphonatooxy group"), a cyano group and a nitro group. Among the above-described groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (V) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1] selenazole); thiazolines (for example, thiazoline or 4-methylthiazoline); quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); isoquinolines (for example, isoquinoline or 3,4-dihydroisoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); and pyridines (for example, pyridine or 5-methylpyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 350 to 450 nm, dyes represented by formula (V) shown below are more preferable in view of high sensitivity.

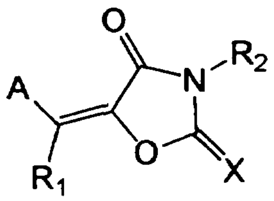

(V)

In formula (V), A represents an aromatic cyclic group which may have a substituent or a heterocyclic group which may have a substituent, X represents an oxygen atom, a sulfur atom or $=N(R_3)$, and $R_1$, $R_2$ and $R_3$ each inde-

pendently represents a monovalent non-metallic atomic group, or A and $R_1$ or $R_2$ and $R_3$ may be combined with each other to form an aliphatic or aromatic ring.

The formula (V) will be described in more detail below. $R_1$, $R_2$ and $R_3$ each independently represents a monovalent non-metallic atomic group, preferably a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

Preferable examples of $R_1$, $R_2$ and $R_3$ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N, N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an "alkylphosphonatooxy group"), a monoarylphosphonooxy group ($-OPO_3H(aryl)$) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Examples of the heteroaryl group include a monocyclic or polycyclic aromatic cyclic group containing at least one of a nitrogen atom, an oxygen atom and a sulfur atom. Examples of especially preferable heteroaryl group include a group derived from a heteroaryl ring, for example, thiophene, thiathrene, furan, pyran, isobenzofuran, chromene,

xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Also, examples of the alkenyl group include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of $G_1$ in the acyl group ($G_1CO$-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of $R_1$, $R_2$ and $R_3$, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of $R_1$, $R_2$ and $R_3$ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferable substituted aryl group represented by any one of $R_1$, $R_2$ and $R_3$ include aryl groups having a monovalent non-metallic atomic group exclusive of a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group.

Specific examples of the preferable substituted or unsubstituted alkenyl group and the preferable substituted or unsubstituted heteroaryl group represented by any one of $R_1$, $R_2$ and $R_3$ include those described with respect to the alkenyl group and heteroaryl group above, respectively.

Next, A in formula (V) will be described below. A represents an aromatic cyclic group which may have a substituent or heterocyclic group which may have a substituent. Specific examples of the aromatic cyclic group which may have a substituent and heterocyclic group which may have a substituent include those described for the aryl group and heteroaryl group represented by any one of $R_1$, $R_2$ and $R_3$ in formula (V).

The sensitizing dye represented by formula (V) is obtained by a condensation reaction of the above-described acidic nucleus or an active methyl group-containing acidic nucleus with a substituted or unsubstituted, aromatic ring or hetero ring. Specifically, it can be synthesized with reference to the description of JP-B-59-28329.

Preferable specific examples (D1) to (D41) of the compound represented by formula (V) are set forth below. Further, when isomers with respect to a double bond connecting an acidic nucleus and a basic nucleus are present in each of the compounds, the invention should not be construed as being limited to any one of the isomers.

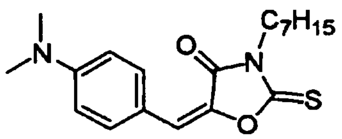

(D1)

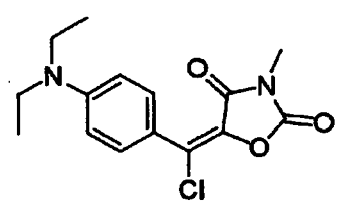

(D2)

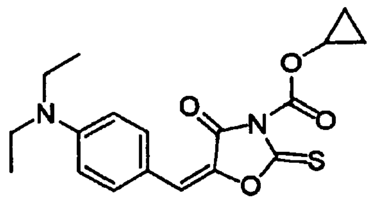

(D3)

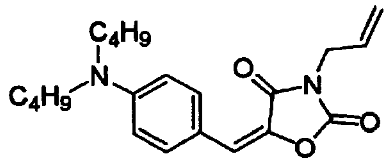

(D4)

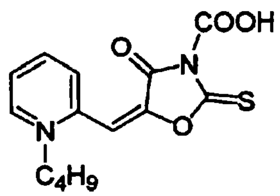

(D5)

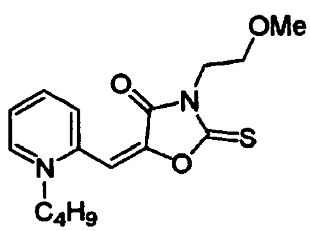

(D6)

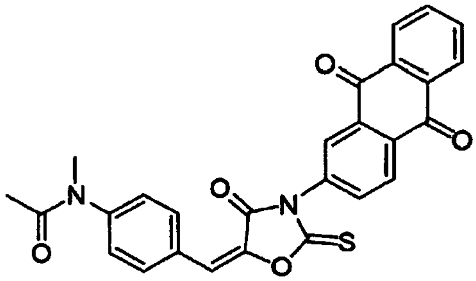

(D7)

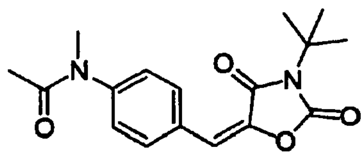

(D8)

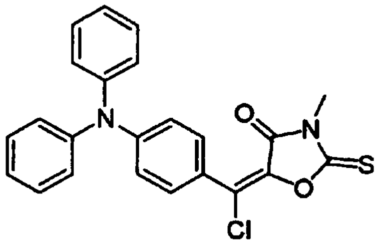

(D9)

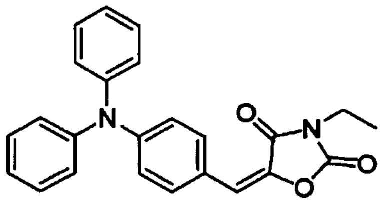

(D10)

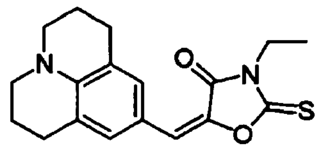

(D11)

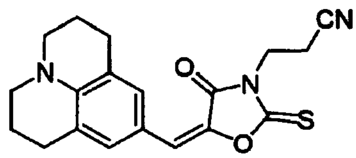

(D12)

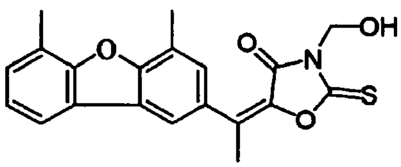

(D13)

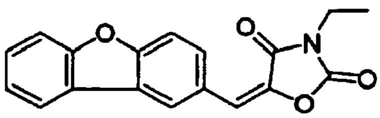

(D14)

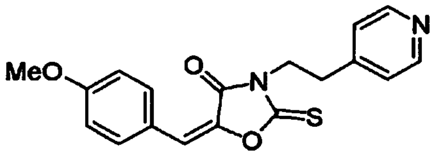

(D15)

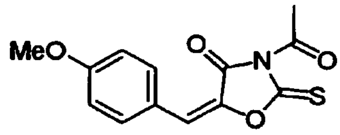

(D16)

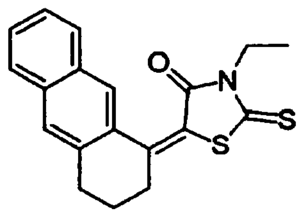

(D17)

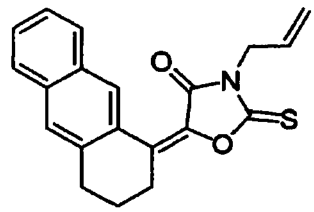

(D18)

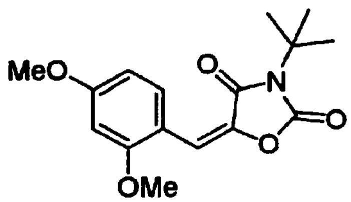

(D19)

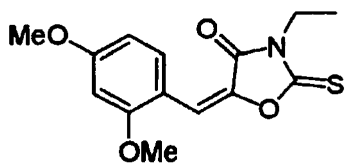

(D20)

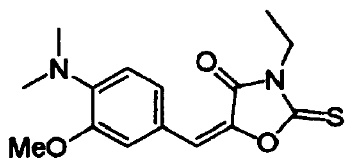

(D21)

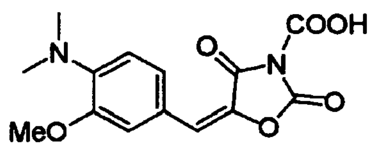

(D22)

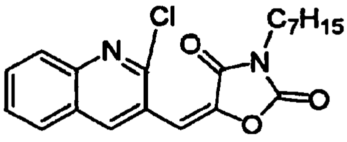

(D23)

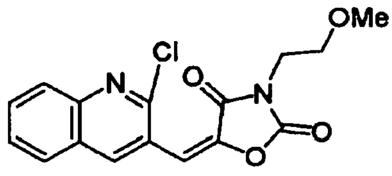

(D24)

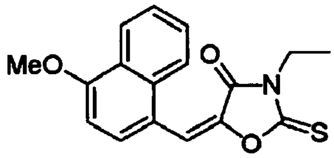

(D25)

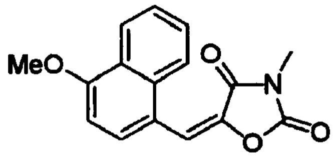

(D26)

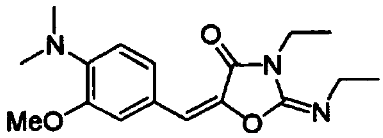

(D27)

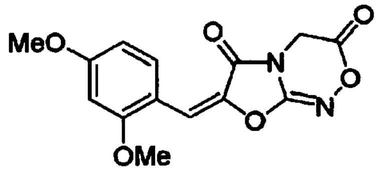

(D28)

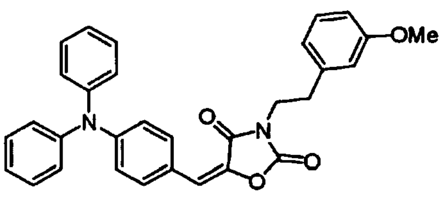

(D29)

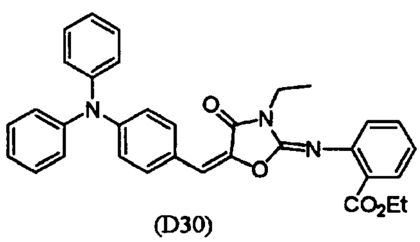

(D30)

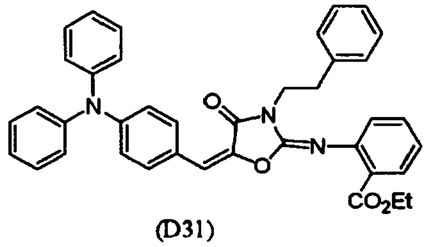

(D31)

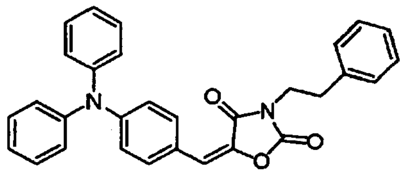

(D32)

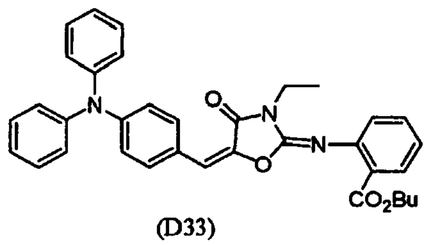

(D33)

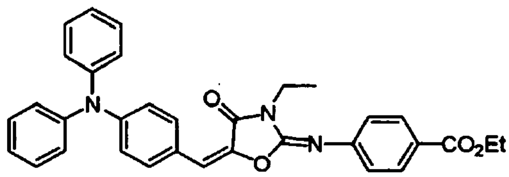

(D34)

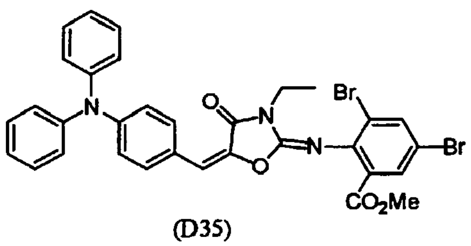

(D35)

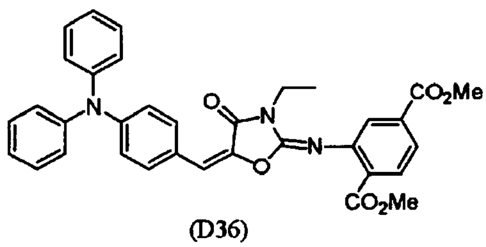

(D36)

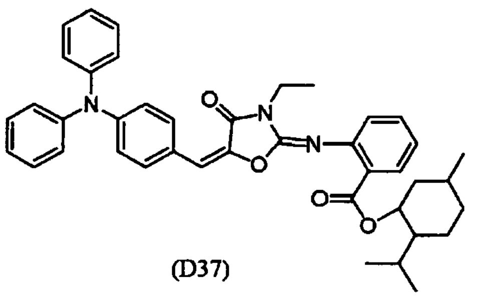

(D37)

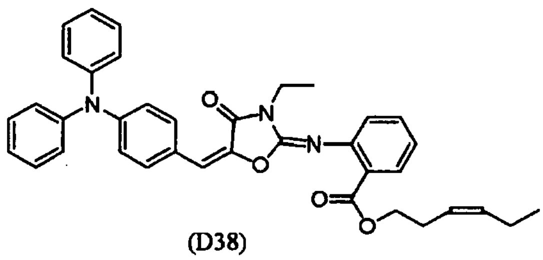

(D38)

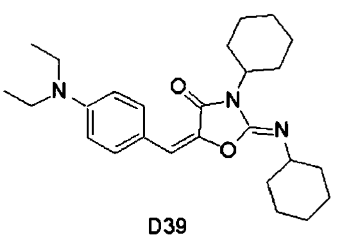

D39

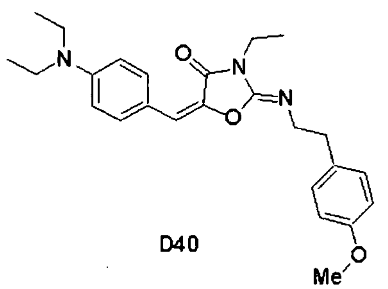

D40

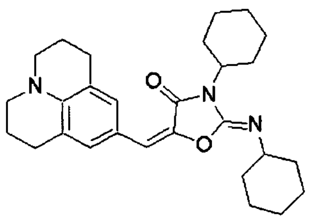

D41

The sensitizing dye absorbing light of 350 to 450 nm is preferably used in a range of 1.0 to 10.0% by weight, more preferably in a range of 1.5 to 5.0% by weight, based on the total solid content of the image-forming layer.

The image-forming layer according to the invention may contain other component, for example, a co-sensitizer, a polymerization inhibitor, a microcapsule, a surfactant, a hydrophilic polymer, a coloring agent, a print-out agent, a higher fatty acid derivative, a plasticizer, a fine particle or a hydrophilic low molecular weight compound depending on the intended use.

(Co-sensitizer)

The sensitivity of the image-forming layer can be further increased by using a certain additive. Such a compound is referred to as a co-sensitizer in the invention. The operation mechanism of the co-sensitizer is not quite clear but may be considered to be mostly based on the following chemical process. Specifically, the co-sensitizer reacts with various intermediate active species (for example, a radical, a peroxide, an oxidizing agent or a reducing agent) generated during the process of photo-reaction initiated by light absorption of the photopolymerization initiation system and subsequent addition-polymerization reaction to produce new active radicals. The co-sensitizers are roughly classified into (a) a compound which is reduced to produce an active radical, (b) a compound which is oxidized to produce an active radical and (c) a compound which reacts with a radical having low activity to convert it into a more highly active radical or acts as a chain transfer agent. However, in many cases, a common view about that an individual compound belongs to which type is not present.

(a) Compound which is reduced to produce an active radical

Compound having carbon-halogen bond:

An active radical is considered to be generated by the reductive cleavage of the carbon-halogen bond. Specific examples of the compound preferably used include a trihalomethyl-s-triazine and a trihalomethyloxadiazole.

Compound having nitrogen-nitrogen bond:

An active radical is considered to be generated by the reductive cleavage of the nitrogen-nitrogen bond. Specific examples of the compound preferably used include a hexaarylbiimidazole.

Compound having oxygen-oxygen bond:

An active radical is considered to be generated by the reductive cleavage of the oxygen-oxygen bond. Specific examples of the compound preferably used include an organic peroxide.

Onium compound:

An active radical is considered to be generated by the reductive cleavage of a carbon-hetero bond or oxygen-nitrogen bond. Specific examples of the compound preferably used include a diaryliodonium salt, a triarylsulfonium salt and an N-alkoxypyridinium (azinium) salt.

Ferrocene and iron allene complexe:

An active radical can be reductively generated.

(b) Compound which is oxidized to produce an active radical

Alkylate complex:

An active radical is considered to be generated by the oxidative cleavage of a carbon-hetero bond. Specific examples of the compound preferably used include a triaryl alkyl borate.

Alkylamine compound:

An active radical is considered to be generated by the oxidative cleavage of a C-X bond on the carbon adjacent to nitrogen, wherein X is preferably a hydrogen atom, a carboxyl group, a trimethylsilyl group or a benzyl group. Specific examples of the compound include an ethanolamine, an N-phenylglycine and an N-trimethylsilylmethylaniline.

Sulfur-containing or tin-containing compound:

A compound in which the nitrogen atom of the above-described amine is replaced by a sulfur atom or a tin atom is considered to generate an active radical in the same manner. Also, a compound having an S-S bond is known to effect sensitization by the cleavage of the S-S bond.

α-Substituted methylcarbonyl compound:

An active radical can be generated by the oxidative cleavage of carbonyl-α-carbon bond. The compound in which the carbonyl is converted into an oxime ether also shows the similar function. Specific examples of the compound include an 2-alkyl-1-[4-(alkylthio)phenyl]-2-morpholinopronone-1 and an oxime ether obtained by a reaction of the 2-alkyl-1-[4-(alkylthio)phenyl]-2-morpholinopronone-1 with a hydroxyamine and subsequent etherification of the N-OH.

Sulfinic acid salt:

An active radical can be reductively generated. Specific examples of the compound include sodium arylsulfinate.

(c) Compound which reacts with a radical to convert it into a more highly active radical or acts as a chain transfer agent:

For example, a compound having SH, PH, SiH or GeH in its molecule is used as the compound which reacts with a radical to convert it into a more highly active radical or acts as a chain transfer agent. The compound donates hydrogen to a low active radical species to generate a radical or is oxidized and deprotonized to generate a radical. Specific examples of the compound include a 2-mercaptobenzimidazole.

A large number of examples of the co-sensitizer are more specifically described, for example, in JP-A-9-236913 as additives for the purpose of increasing sensitivity. Some of them are set forth below, but the invention should not be construed as being limited thereto.

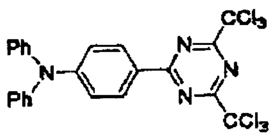
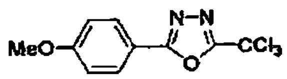
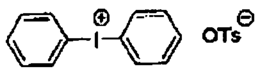

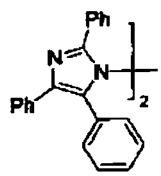
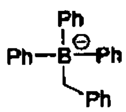
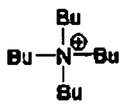
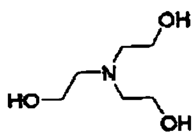

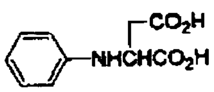
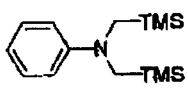
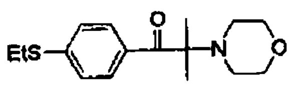

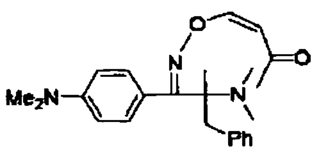
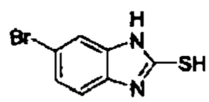

Similarly to the above-described sensitizing dye, the co-sensitizer can be subjected to various chemical modifications so as to improve the characteristics of the image-forming layer of the lithographic printing plate precursor. For

instance, methods, for example, binding to the sensitizing dye, polymerization initiator, polymerizable compound or other radical-generating part, introduction of a hydrophilic site, introduction of a substituent for improving compatibility or inhibiting deposition of crystal, introduction of a substituent for improving adhesion property, and formation of a polymer, may be used. The co-sensitizers may be used individually or in combination of two or more thereof. The amount of the co-sensitizer used is ordinarily from 0.05 to 100 parts by weight, preferably from 1 to 80 parts by weight, more preferably from 3 to 50 parts by weight, per 100 parts by weight of the polymerizable compound.

(Microcapsule)

In the invention, in order to incorporate the above-described constituting components of the image-forming layer and other constituting components described hereinafter into the image-forming layer, a part or whole of the constituting components is encapsulated into microcapsules and added to the image-forming layer as described, for example, in JP-A-2001-277740 and JP-A-2001-277742. In such a case, each constituting component may be present inside or outside the microcapsule in an appropriate ratio.

As a method of microencapsulating the constituting components of the image-forming layer, known methods can be used. Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by polymerization of monomer described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferable microcapsule wall used in the invention has three-dimensional crosslinking and has a solvent-swellable property. From this point of view, a preferable wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into the binder polymer described above may be introduced into the microcapsule wall.

The average particle size of the microcapsule is preferably from 0.01 to 3.0 μm, more preferably from 0.05 to 2.0 μm, particularly preferably from 0.10 to 1.0 μm. In the range described above, preferable resolution and good preservation stability can be achieved.

(Surfactant)

In the invention, it is preferred to use a surfactant in the image-forming layer in order to progress the developing property and to improve the state of surface coated. The surfactant includes, for example, a nonionic surfactant, an anionic surfactant, a cationic surfactant, an amphoteric surfactant and a fluorine-based surfactant. The surfactants may be used individually or in combination of two or more thereof.

The nonionic surfactant used in the invention is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols and copolymers of polyethylene glycol and polypropylene glycol.

The anionic surfactant used in the invention is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate

ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant used in the invention is not particularly restricted and cationic surfactants hitherto known can be used. Examples of the cationic surfactant include alkylamine salts, quaternary ammonium salts, polyoxyethylene alkyl amine salts and polyethylene polyamine derivatives.

The amphoteric surfactant used in the invention is not particularly restricted and amphoteric surfactants hitherto known can be used. Examples of the amphoteric surfactant include carboxybetaines, aminocarboxylic acids, sulfobetaines, aminosulfuric esters and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, a preferable surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkylphosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, fluorine-based surfactants described in JP-A-62-170950, JP-A-62-226143 and JP-A-60-168144 are also preferably exemplified.

The surfactant may be used singularly or in combination of two or more kinds of the surfactants.

The content of the surfactant is preferably from 0.001 to 10% by weight, more preferably from 0.01 to 7% by weight, based on the total solid content of the image-forming layer.

(Hydrophilic polymer)

In the invention, a hydrophilic polymer may be incorporated into the image-forming layer in order to improve the developing property and dispersion stability of microcapsule.

Preferable examples of the hydrophilic polymer include those having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group.

Specific examples of the hydrophilic polymer include gum arabic, casein, gelatin, a starch derivative, carboxymethyl cellulose or a sodium salt thereof, cellulose acetate, sodium alginate, a vinyl acetate-maleic acid copolymer, a styrene-maleic acid copolymer, polyacrylic acid or a salt thereof, polymethacrylic acid or a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or polymer of acrylamide, a homopolymer or copolymer of methacrylamide, a homopolymer or copolymer of N-methylolacrylamide, polyvinyl pyrrolidone, an alcohol-soluble nylon, and a polyether of 2,2-bis(4-hydroxyphenyl)propane with epichlorohydrin.

The hydrophilic polymer preferably has a weight average molecular weight of 5,000 or more, more preferably from 10,000 to 300,000. The hydrophilic polymer may be any of a random polymer, a block polymer, a graft polymer or the like.

The content of the hydrophilic polymer in the image-forming layer is preferably 20% by weight or less, more preferably 10% by weight or less, based on the total solid content of the image-forming layer.

(Coloring agent)

In the invention, a dye having large absorption in the visible light region can be used as a coloring agent for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (produced by Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247. Also, a pigment, for example, phthalocyanine-based pigment, azo-based pigment, carbon black and titanium oxide can be preferably used.

It is preferable to add the coloring agent, because the image area and the non-image area after the image

formation can be easily distinguished. The amount of the coloring agent added is preferably from 0.01 to 10% by weight based on the total solid content of the image-forming layer.

(Print-out agent)

In the image-forming layer according to the invention, a compound capable of undergoing discoloration by the effect of an acid or a radical can be added in order to form a print-out image. As such a compound, for example, various dyes, e.g., diphenylmethane-based, triphenylmethane-based, thiazine-based, oxazine-based, xanthene-based, anthraquinone-based, iminoquinone-based, azo-based and azomethine-based dyes are effectively used.
Specific examples thereof include dyes, for example, Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH (produced by Hodogaya Chemical Co., Ltd.), Oil Blue #603 (produced by Orient Chemical Industry Co., Ltd.), Oil Pink #312 (produced by Orient Chemical Industry Co., Ltd.), Oil Red 5B (produced by Orient Chemical Industry Co., Ltd.), Oil Scarlet #308 (produced by Orient Chemical Industry Co., Ltd.), Oil Red OG (produced by Orient Chemical Industry Co., Ltd.), Oil Red RR (produced by Orient Chemical Industry Co., Ltd.), Oil Green #502 (produced by Orient Chemical Industry Co., Ltd.), Spiron Red BEH Special (produced by Hodogaya Chemical Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-β-naphthyl-4-p-diethylaminophenylimino-5-pyrazolone, and leuco dyes, for example, p,p',p''-hexamethyltriaminotriphenyl methane (leuco Crystal Violet) and Pergascript Blue SRB (produced by Ciba Geigy).
Other preferable examples include leuco dyes known as a material for heat-sensitive paper or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino) fluorane, 3,6-dimethoxyfluorane, 3-(N,N-diethylamino)-5-methyl-7-(N,N-dibenzylamino)fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthalide.
The dye capable of undergoing discoloration by the effect of an acid or a radical is preferably added in an amount of 0.01 to 15% by weight based on the total solid content of the image-forming layer.

(Polymerization inhibitor)

To the image-forming layer according to the invention, a small amount of a thermal polymerization inhibitor is preferably added in order to prevent the polymerizable compound from undergoing undesirable thermal polymerization during the production or preservation of the image-forming layer.
Preferable examples of the thermal polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis (4-methyl-6-tert-butylphenol) and N-nitroso-N-phenylhydroxylamine aluminum salt.
The amount of the thermal polymerization inhibitor added is preferably from about 0.01 to about 5% by weight based on the total solid content of the image-forming layer.

(Higher fatty acid derivative)

In the image-forming layer according to the invention, for example, a higher fatty acid derivative, e.g., behenic acid or behenic acid amide may be added and localized on the surface of the image-forming layer during the process of drying after coating in order to avoid polymerization inhibition due to oxygen. The amount of the higher fatty acid derivative added is preferably from about 0.1 to about 10% by weight based on the total solid content of the image-forming layer.

(Plasticizer)

The image-forming layer according to the invention may contain a plasticizer. Preferable examples of the plasticizer include a phthalic acid ester, for example, dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate or diallyl phthalate; a glycol ester, for example, dimethyl glycol phthalate, ethyl phthalylethyl glycolate, methyl phthalylethyl glycolate, butyl phthalylbutyl glycolate or triethylene glycol dicaprylic acid ester; a phosphoric acid ester, for example, tricresyl phosphate or triphenyl phosphate; an aliphatic dibasic acid ester, for example, diisobutyl adipate, dioctyl adipate, dimethyl sebacate, dibutyl sebacate, dioctyl azelate or dibutyl maleate; polyglycidyl methacrylate, triethyl citrate, glycerin triacetyl ester and butyl laurate. The content of the plasticizer is preferably about 30% by weight or less based on the total solid content of the image-forming layer.

(Fine inorganic particle)

The image-forming layer according to the invention may contain fine inorganic particle in order to increase strength of the cured layer in the image area. The fine inorganic particle preferably includes, for example, silica, alumina, magnesium oxide, titanium oxide, magnesium carbonate, calcium alginate and a mixture thereof. Even if the fine inorganic particle has no light to heat converting property, it can be used, for example, for strengthening the layer or enhancing interface adhesion property due to surface roughening. The fine inorganic particle preferably has an average particle size from 5 nm to 10 μm, more preferably from 0.5 to 3μm. In the range described above, it is stably dispersed in the image-forming layer, sufficiently maintains the film strength of the image-forming layer and can form the non-image area excellent in hydrophilicity and preventing from the occurrence of stain at the printing.
The fine inorganic particle described above is easily available as a commercial product, for example, colloidal silica dispersion.
The content of the fine inorganic particle is preferably 20% by weight or less, more preferably 10% by weight or less, based on the total solid content of the image-forming layer.

(Hydrophilic low molecular weight compound)

The image-forming layer according to the invention may contain a hydrophilic low molecular weight compound in order to improve the developing property. The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine, e.g., triethanol amine, diethanol amine or monoethanol amine, or a salt thereof, an organic sulfonic acid, e.g., toluene sulfonic acid or benzene sulfonic acid, or a salt thereof, an organic phosphonic acid, e.g., phenyl phosphonic acid, or a salt thereof, an organic carboxylic acid, e.g., tartaric acid, oxalic acid, citric acid, maleic acid, lactic acid, gluconic acid or an amino acid, or a salt thereof, and an organic quaternary ammonium salt, e.g., tetraethyl ammonium hydrochloride.

(Formation of image-forming layer)

The image-forming layer according to the invention is formed by dispersing or dissolving each of the necessary constituting components described above to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid concentration of the coating solution is preferably from 1 to 50% by weight.
The image-forming layer according to the invention may also be formed by preparing plural coating solutions by dispersing or dissolving the same or different components described above into the same or different solvents and conducting repeatedly plural coating and drying.
The coating amount (solid content) of the image-forming layer after the coating and drying may be varied depending on the intended use, but ordinarily, it is preferably from 0.3 to 3.0 $g/m^2$. In the range described above, the preferable sensitivity and good film property of the image-forming layer can be obtained.
Various methods can be used for the coating. Examples of the method include bar coater coating, spin coating, spray coating, curtain coating, dip coating, air knife coating, blade coating and roll coating.

[Support]

The support for use in the lithographic printing plate precursor according to the invention is not particularly restricted as long as it is a dimensionally stable plate-like hydrophilic support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetatebutyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials known and used conventionally can be appropriately utilized.

The thickness of the support is preferably from 0.1 to 0.6 mm, more preferably from 0.15 to 0.4 mm, still more preferably from 0.2 to 0.3 mm.

Prior to the use of aluminum plate, a surface treatment, for example, roughening treatment or anodizing treatment is preferably performed. The surface treatment facilitates improvement in the hydrophilic property and ensures adhesion between the image-forming layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively).

As the method of the mechanical roughening treatment, a known method, for example, a ball grinding method, a brush grinding method, a blast grinding method or a buff grinding method can be used.

The electrochemical roughening treatment method includes, for example, a method of conducting it by passing alternating current or direct current in an electrolyte containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70°C, current density is from 5 to 60 A/dm$^2$, voltage is from 1 to 100 V, and electrolysis time is from 10 seconds to 5 minutes. The amount of the anodized film formed is preferably from 1.0 to 5.0 g/m$^2$, more preferably from 1.5 to 4.0 g/m$^2$. In the range described above, good printing durability and favorable scratch resistance in the non-image area of lithographic printing plate can be achieved.

The aluminum plate subjected to the surface treatment and having the anodized film is used as it is as the support in the invention. However, in order to more improve an adhesion property to a layer provided thereon, hydrophilicity, resistance to stain, heat insulating property or the like, other treatment, for example, a treatment for enlarging micropores or a sealing treatment of micropores of the anodized film described in JP-A-2001-253181 and JP-A-2001-322365, or a surface hydrophilizing treatment by immersing in an aqueous solution containing a hydrophilic compound, may be appropriately conducted. Needless to say, the enlarging treatment and sealing treatment are not limited to those described in the above-described patents and any conventionally known method may be employed.

As the sealing treatment, as well as a sealing treatment with steam, a sealing treatment with an aqueous solution containing an inorganic fluorine compound, for example, fluorozirconic acid alone or sodium fluoride, a sealing treatment with steam having added thereto lithium chloride or a sealing treatment with hot water may be employed.

Among them, the sealing treatment with an aqueous solution containing an inorganic fluorine compound, the

sealing treatment with water vapor and the sealing treatment with hot water are preferred.

The hydrophilizing treatment includes an alkali metal silicate method described in U.S. Patents 2,714,066, 3,181,461, 3,280,734 and 3,902,734. In the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

In the case of using a support having a surface of insufficient hydrophilicity, for example, a polyester film, in the invention, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate, and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support in the invention, it is preferred to provide an antistatic layer on the hydrophilic layer side, opposite side to the hydrophilic layer or both sides. When the antistatic layer is provided between the support and the hydrophilic layer, it also contributes to improve the adhesion property of the hydrophilic layer to the support. As the antistatic layer, a polymer layer having fine particles of metal oxide or a matting agent dispersed therein described in JP-A-2002-79772 can be used.

The support preferably has a center line average roughness of 0.10 to 1.2 μm. In the range described above, good adhesion property to the image-forming layer, good printing durability, and good resistance to stain can be achieved.

The color density of the support is preferably from 0.15 to 0.65 in terms of the reflection density value. In the range described above, good image-forming property by preventing halation at the image exposure and good aptitude for plate inspection after development can be achieved.

(Protective layer)

In the lithographic printing plate precursor according to the invention, a protective layer (oxygen-blocking layer) is preferably provided on the image-forming layer in order to prevent diffusion and penetration of oxygen which inhibits the polymerization reaction at the time of exposure. The protective layer for use in the invention preferably has oxygen permeability (A) at 25°C under one atmosphere of $1.0 \leq (A) \leq 20$ (ml/m$^2$·day). When the oxygen permeability (A) is extremely lower than 1.0 (ml/m$^2$·day), problems may occur in that an undesirable polymerization reaction arises during the production or preservation before image exposure and in that undesirable fog or spread of image line occurs at the image exposure. On the contrary, when the oxygen permeability (A) greatly exceeds 20 (ml/m$^2$·day), decrease in sensitivity may be incurred. The oxygen permeability (A) is more preferably in a range of $1.5 \leq (A) \leq 12$ (ml/m$^2$·day), still more preferably in a range of $2.0 \leq (A) \leq 10.0$ (ml/m$^2$·day). Besides the above described oxygen permeability, as for the characteristics required of the protective layer, it is desired that the protective layer does not substantially hinder the transmission of light for the exposure, is excellent in the adhesion property to the image-forming layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics, for example, oxygen-blocking property and removability of the protective layer by development.

Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component. As specific examples of the polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, more preferably from 30 to 90% by weight.

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, more preferably from 15 to 30% by weight, in the protective layer.

The components of the protective layer (selection of PVA and use of additives) and the coating amount are determined taking into consideration fogging property, adhesion property and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the polymer, for example, polyvinyl alcohol (PVA) is ordinarily from 2,000 to 10,000,000, preferably from 20,000 to 3,000,000.

As other additive of the protective layer, glycerin, dipropylene glycol or the like can be added in an amount corresponding to several % by weight of the polymer to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the polymer.

The adhesion property of the protective layer to the image portion and scratch resistance are also extremely important in view of handling of the printing plate precursor. Specifically, when a hydrophilic layer comprising a water-soluble polymer is laminated on the oleophilic image-forming layer, layer peeling due to an insufficient adhesion property is liable to occur, and the peeled portion causes such a defect as failure in curing of the image-forming layer due to polymerization inhibition by oxygen. Various proposals have been made for improving the adhesion property between the image-forming layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the image-forming layer. Any of these known techniques can be applied to the protective layer according to the invention. Coating methods of the protective layer are described in detail, for example, in U.S. Patent 3,458,311 and JP-B-55-49729.

Further, it is also preferred to incorporate an inorganic stratiform compound into the protective layer of the lithographic printing plate precursor according to the invention for the purpose of improving the oxygen-blocking property and property for protecting the surface of image-forming layer.

The inorganic stratiform compound used here is a particle having a thin tabular shape and includes, for instance, mica, for example, natural mica represented by the following formula: $A\ (B,\ C)_{2\text{-}5}\ D_4\ O_{10}\ (OH,\ F,\ O)_2$, (wherein A represents any one of K, Na and Ca, B and C each represents any one of Fe (II), Fe(III), Mn, Al, Mg and V, and D represents Si or Al) or synthetic mica; talc represented by the following formula: $3MgO{\cdot}4SiO{\cdot}H_2O$; teniolite; montmorillonite; saponite; hectolite; and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilic mica $KMg_{2.5}(Si_4O_{10})F_2$, and swellable mica, for example, Na tetrasilic mica $NaMg_{2.5}(Si_4O_{10})F_2$, Na or Li teniolite $(Na, Li)Mg_2Li(Si_4O_{10})F_2$, or montmorillonite based Na or Li hectolite $(Na, Li)_{1/8}Mg_{2/5}Li_{1/8}(Si_4O_{10})F_2$. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and in order to compensate it, a cation, for example, $Na^+$, $Ca^{2+}$ or $Mg^{2+}$, is adsorbed between the lattice layers. The cation existing between the lattice layers is referred to as an exchangeable cation and is exchangeable with various cations. In particular, in the case where the cation between the lattice layers is Li+ or $Na^+$, because of a small ionic radius, a bond between the stratiform crystal lattices is week, and the inorganic stratiform compound greatly swells upon contact with water. When share is applied under such condition, the stratiform crystal lattices are easily cleaved to form a stable sol in water. The bentnite and swellable synthetic mica have strongly such tendency and are useful in the

invention. Particularly, the swellable synthetic mica is preferably used.

With respect to the shape of the inorganic stratiform compound used in the invention, the thinner the thickness or the larger the plain size as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, particularly preferably 200 or more. The aspect ratio is a ratio of thickness to major axis of particle and can be determined, for example, from a projection drawing of particle by a microphotography. The larger the aspect ratio, the greater the effect obtained.

As for the particle size of the inorganic stratiform compound used in the invention, an average major axis is ordinarily from 0.3 to 20 μm, preferably from 0.5 to 10 μm, particularly preferably from 1 to 5 μm. An average thickness of the particle is ordinarily 0.1 μm or less, preferably 0.05 μm or less, particularly preferably 0.01 μm or less. For example, in the swellable synthetic mica that is the representative compound of the inorganic stratiform compounds, thickness is approximately from 1 to 50 nm and plain size is approximately from 1 to 20 μm.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/00 in terms of weight ratio to the amount of binder used in the protective layer. When a plurality of inorganic stratiform compounds is used in combination, it is also preferred that the total amount of the inorganic stratiform compounds fulfills the above-described weight ratio.

An example of common dispersing method for the inorganic stratiform compound used in the protective layer is described below. Specifically, from 5 to 10 parts by weight of a swellable stratiform compound that is exemplified as a preferred inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. A dispersion containing from 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

To the coating solution for protective layer can be added known additives, for example, a surfactant for improving coating property or a water-soluble plasticizer for improving physical property of coated layer in addition to the inorganic stratiform compound. Examples of the water-soluble plasticizer include propionamide, cyclohexanediol, glycerin or sorbitol. Also, a water-soluble (meth)acrylic polymer can be added. Further, to the coating solution may be added known additives for increasing adhesion property to the image-forming layer or for improving preservation stability of the coating solution.

The coating solution for protective layer thus-prepared is coated on the image-forming layer provided on the support and then dried to form a protective layer. The coating solvent may be appropriately selected in view of the binder used, and when a water-soluble polymer is used, distilled water or purified water is preferably used as the solvent. A coating method of the protective layer is not particularly limited, and known methods, for example, methods described in U.S. Patent 3,458,311 and JP-B-55-49729 can be utilized. Specific examples of the coating method for the protective layer include a blade coating method, an air knife coating method, a gravure coating method, a roll coating method, a spray coating method, a dip coating method and a bar coating method.

The coating amount of the protective layer is preferably in a range of 0.05 to 10 $g/m^2$ in terms of the coating amount after drying. When the protective layer contains the inorganic stratiform compound, it is more preferably in a range of 0.1 to 0.5 $g/m^2$, and when the protective layer does not contain the inorganic stratiform compound, it is more preferably in a range of 0.5 to 5 $g/m^2$.

[Backcoat layer]

A backcoat layer may be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the

starting material is inexpensive and easily available.

The method of preparing a lithographic printing plate according to the invention is described below. The method of preparing a lithographic printing plate according to the invention mainly comprises exposing imagewise the lithographic printing plate precursor, if desired, heating the entire surface of the exposed lithographic printing plate precursor, and undergoing any one of plate making processes (1) and (2) shown below:

(1) development on a printing machine by performing usual printing on the printing machine using dampening water and ink; and
(2) development with a developer having pH of 2 to 10.

[Exposure]

The lithographic printing plate precursor according to the invention is preferably exposed imagewise with a laser having an oscillation wavelength of 350 to 1,200 nm.

(1) An infrared laser can be used as the laser light source. The infrared laser used is not particularly restricted and suitably includes a solid laser or semiconductor laser emitting an infrared ray having a wavelength of 760 to 1,200 nm. The output of the infrared laser is preferably 100 mW or more. Further, in order to shorten the exposure time, it is preferred to use a multibeam laser device. The exposure time is preferably 20 microseconds per pixel or less. Also, the irradiation energy is preferably from 10 to 300 mJ/$cm^2$.
(2) A semiconductor laser of 405 nm or 830 nm, an FD-YAG laser or the like is also used as the laser light source. In recent years, a CTP system equipped with a semiconductor laser of 405 nm has become widespread in view of system cost and handling properties. For instance, the lithographic printing plate precursor is loaded in the inner drum exposure apparatus equipped with a light source having an oscillation wavelength in a range of 350 to 450 nm (wherein a light beam emitted from the light source is parallel divided into an ordinary beam and an extraordinary beam in an equal amount and these two beam spots are adjacently aligned with a partial overlap in the sub-scanning direction to form a spot shape of light beam) and is subjected to exposure with the spot shape of light beam to perform image recording.

The exposure apparatus for use in the invention may be any of an internal drum system, an external drum system and a flat bed system. Further, the highly accurate image can be recorded at high speed by simultaneously recording the image using a multibeam exposure system.

Moreover, the image-recording can be performed using an FM screen at the exposure of lithographic printing plate precursor according to the invention.

[Heating]

According to the invention, the lithographic printing plate precursor exposed imagewise may be heated overall between the exposure and development, if desired. By the heating, the image-forming reaction in the image-forming layer is accelerated to achieve advantages, for example, improvements in the sensitivity and printing durability and stabilization of the sensitivity.

In the case where the protective layer is provided on the image-forming layer, it is also preferred to carry out a water washing treatment before the development processing.

[Plate making]

Although an embodiment of developing the lithographic printing plate precursor according to the invention with a conventional alkali solution is preferable, a particularly preferable embodiment is described in greater detail below.

The lithographic printing plate precursor according to the invention is exposed imagewise with a semiconductor laser or a solid laser as described above, if desired, heated the entire surface of the exposed lithographic printing plate precursor as described above, and then subjected to usual printing by supplying oily ink and an aqueous component without undergoing any development processing step. Specifically, for example, a method wherein the lithographic printing plate precursor is exposed with a laser, if desired, heated the entire surface of the exposed lithographic printing plate precursor in an oven and then mounted on a printing machine to conduct printing without undergoing the development processing step or a method wherein the lithographic printing plate precursor is mounted on a printing machine, exposed with a laser on the printing machine, if desired, heated the entire surface of the exposed lithographic printing plate precursor on the printing machine and then subjected to printing without undergoing the development processing step is exemplified.

For instance, according to one embodiment of negative type lithographic printing plate precursor of on-machine development type, after the imagewise exposure of the lithographic printing plate precursor with a laser, when an aqueous component and oily ink are supplied to conduct printing without undergoing the development processing step, for example, a wet development processing step, in the exposed area of the image-forming layer, the image-forming layer cured by the exposure forms the oily ink receptive area having the oleophilic surface. On the other hand, in the unexposed area, the uncured image-forming layer is removed by dissolution or dispersion with the aqueous component and/or oily ink supplied to reveal the surface of support in the area. As a result, the aqueous component adheres on the revealed surface of support and the oily ink adheres to the exposed area of the image-forming layer, whereby printing is initiated. While either the aqueous component or oily ink may be supplied at first on the surface of lithographic printing plate precursor, it is preferred to supply the oily ink at first in view of preventing the aqueous component from contamination with the unexposed area of the image-forming layer. For the aqueous component and oily ink, dampening water and printing ink for conventional lithographic printing are used respectively.

Thus, the lithographic printing plate precursor is subjected to the on-machine development on a printing machine and used as it is for printing a large number of sheets.

In accordance with another embodiment of the plate making method of the lithographic printing plate precursor according to the invention, the lithographic printing plate precursor is exposed imagewise with a laser, if desired, heated the entire surface of the exposed lithographic printing plate precursor as described above, and then rubbed a surface of the exposed lithographic printing plate precursor with a rubbing member in the presence of a developer having pH of 2 to 10 in an automatic processor equipped with the rubbing member to remove the unexposed area of the image-forming layer, thereby preparing a lithographic printing plate.

The developer for use in the invention is preferably, for example, water alone or an aqueous solution containing water as a main component (containing 60% by weight or more of water). Particularly, an aqueous solution having the composition similar to that of conventionally known dampening water, an aqueous solution containing a surfactant (for example, an anionic, nonionic or cationic surfactant) and an aqueous solution containing a water-soluble polymer compound are preferable. An aqueous solution containing both a surfactant and a water-soluble polymer compound is especially preferable. The pH of the developer is more preferably from 3 to 8, and still more preferably from 4 to 7.

The anionic surfactant used in the invention includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant used in the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant used in the invention includes, for example, polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant used in the developer according to the invention, the HLB (hydrophile-lipophile balance) value thereof is preferably 6 or more, more preferably 8 or more.

Furthermore, an oxyethylene adduct of acetylene glycol type or acetylene alcohol type or a surfactant, for example, a fluorine-based surfactant or a silicon-based surfactant can also be used.

Of the surfactants used in the developer according to the invention, the nonionic surfactant is particularly preferable in view of foam depressing property.

The surfactants may be used individually or as a mixture of two or more thereof. The content of the surfactant in the developer is preferably from 0.01 to 10% by weight, more preferably from 0.01 to 5% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, those known can be used. For example, as a commercial product, Soyafive (trade name, produced by Fuji Oil Co., Ltd.) is available and various grade products can be used. The soybean polysaccharide preferably used has viscosity in a range from 10 to 100 mPa/sec in a 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, more preferably from 0.5 to 10% by weight.

The developer according to the invention may contain an organic solvent. The organic solvent that can be contained in the developer include, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) and a polar solvent.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

When the organic solvent is insoluble in water, it may be employed by being solubilized in water using a surfactant or the like. In the case where the developer contains the organic solvent, the concentration of the organic solvent is desirably less than 40% by weight in view of safety and inflammability.

Into the developer, an antiseptic agent, a chelating agent, a defoaming agent, an organic acid, an inorganic acid, an inorganic salt or the like can be incorporated in addition to the above components.

As the antiseptic agent, for example, phenol or a derivative thereof, formalin, an imidazole derivative, sodium dehydroacetate, a 4-isothiazolin-3-one derivative, benzisotiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative and a nitro bromo alcohol, e.g., 2-bromo-2-nitropropane-1,3-diol, 1,1-dibromo-1-nitro-2-ethanol or 1,1-dibromo-1-nitro-2-propanol are preferably used.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof; aminotri(methylenephosphonic acid), potassium salt thereof, sodium salt thereof; and phophonoalkanetricarboxylic acids are illustrated. A salt of an organic amine is also effectively used in place of the sodium salt or potassium salt in the chelating agents.

As the defoaming agent, for example, a conventional silicone-based self-emulsifying type or emulsifying type defoaming agent, and a nonionic surfactant having HLB of 5 or less are used. The silicone defoaming agent is preferably used. Any of emulsifying dispersing type and solubilizing type can be used.

As the organic acid, for example, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid are illustrated. The organic acid can also be used in the form of an alkali metal salt or an ammonium salt.

As the inorganic acid and inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate are illustrated.

The developer described above can be used as a developer and a development replenisher for an exposed lithographic printing plate precursor, and it is preferably applied to an automatic processor described hereinafter. In the case of conducting the development processing using an automatic processor, the developer becomes fatigued in accordance with the processing amount, and hence the processing ability may be restored using a replenisher or a fresh developer. Such a replenishment system can be preferably applied to the plate making method of the lithographic printing plate precursor according to the invention.

The development processing using the aqueous solution having pH of 2 to 10 according to the invention is preferably performed by an automatic processor equipped with a supplying means for developer and a rubbing member. As the automatic processor, there are illustrated an automatic processor in which a lithographic printing plate precursor after image exposure is subjected to a rubbing treatment while it is transporting described in JP-A-2-220061 and JP-A-60-59351, and an automatic processor in which a lithographic printing plate precursor after image-forming placed on a cylinder is subjected to a rubbing treatment while rotating the cylinder described in U.S. Patents 5,148,746 and 5,568,768 and British Patent 2,297,719. Among them, the automatic processor using a rotating brush roll as the rubbing member is particularly preferred.

The rotating brush roller which can be preferably used in the invention can be appropriately selected by taking account, for example, of scratch resistance of the image area and nerve strength of the support of lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-U-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate; a polyamide-based synthetic fiber, e.g., nylon 6.6 or nylon 6.10; a polyacrylic synthetic fiber, e.g., polyacrylonitrile or polyalkyl (meth)acrylate; and a polyolefin-based synthetic fiber, e.g., polypropylene or polystyrene) can be used. For instance, a brush material having a fiber bristle diameter of 20 to 400 μm and a bristle length of 5 to 30 mm can be preferably used. The outer diameter of the rotating brush roller is preferably from 30 to 200 mm, and the peripheral velocity at the tip of the brush rubbing the plate surface is preferably from 0.1 to 5 m/sec. It is preferred to use a plurality, that is, two or more of the rotating brush rollers.

The rotary direction of the rotating brush roller for use in the invention may be the same direction or the opposite direction with respect to the transporting direction of the lithographic printing plate precursor according to the invention, but when two or more rotating brush rollers are used in an automatic processor as shown in Fig. 1, it is preferred that at least one rotating brush roller rotates in the same direction and at least one rotating brush roller rotates in the opposite direction with respect to the transporting direction. By such arrangement, the image-forming layer in the non-image area can be more steadily removed. Further, a technique of rocking the rotating brush roller in the rotation axis direction of the brush roller is also effective.

The developer can be used at an appropriate temperature, and is preferably used from 10 to 50°C.

In the invention, the lithographic printing plate after the treatment described above may be subsequently subjected to water washing, a drying treatment: and an oil-desensitizing treatment, if desired. In the oil-desensitizing treatment, a; known oil-desensitizing solution can be used.

## EXAMPLES

The present invention will be described in more detail with reference to the following examples, but the invention should not be construed as being limited thereto.

### Examples 1 to 20 and Comparative Examples 1 to 4

[Preparation of Lithographic printing plate precursors 1 to 24]

<Preparation of Aluminum support 1>

An aluminum plate (material: JIS A1050) having a thickness of 0.3 mm was subjected to a degrease treatment with an aqueous 10% by weight sodium aluminate solution at 50°C for 30 seconds in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/$cm^3$) of pumice having a median

diameter of 25 μm, and then thoroughly washed with water. The plate was etched by dipping it in an aqueous 25% by weight sodium hydroxide solution at 45°C for 9 seconds and after washing with water, dipped in an aqueous 20% by weight nitric acid solution at 60°C for 20 seconds, followed by washing with water. The etching amount of the grained surface was about 3 g/$m^2$.

Subsequently, the aluminum plate was subjected to a continuous electrochemical surface roughening treatment using alternate current voltage of 60 Hz. The electrolytic solution used was an aqueous 1% by weight nitric acid solution (containing 0.5% by weight of aluminum ion) at a liquid temperature of 50°C. The electrochemical surface roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was a ferrite. The current density was 30 A/$dm^2$ in terms of the peak value of current, and 5% of the current flowing from the power source was divided to the auxiliary anode. The quantity of electricity at the nitric acid electrolysis was 175 C/$dm^2$ when the aluminum plate was serving as the anode. Then; the aluminum plate was washed with water by spraying.

Then, the aluminum plate was subjected to an electrochemical surface roughening treatment in the same manner as in the nitric acid electrolysis above using, as the electrolytic solution, an aqueous 0.5% by weight hydrochloric acid solution (containing 0.5% by weight of aluminum ion) at a liquid temperature of 50°C under the conditions that the quantity of electricity was 50 C/$dm^2$ when the aluminum plate was serving as the anode, and then washed with water by spraying. The plate was then treated in an aqueous 15% by weight sulfuric acid solution (containing 0.5% by weight of aluminum ion) as the electrolytic solution at a current density of 15 A/$dm^2$ to provide a direct current anodic oxide film of 2.5 g/$m^2$, thereafter washed with water and dried, thereby preparing Aluminum support 1.

The center line average roughness (Ra) of the thus-obtained aluminum support was measured using a stylus having a diameter of 2 μm and found to be 0.51 μm.

<Preparation of lower layer>

Coating solution for lower layer having the composition shown below was coated on Aluminum support 1 obtained above and dried at 100°C for 3 minutes. The coating amount of the lower layer was 10 mg/$m^2$.

(Coating solution for lower layer)

| | |
|---|---|
| Electron donating double bond compound (-e compound) shown in Table 1 below | 0.50 g |
| N-Methylpyrrolidone | 49.00 g |
| Methanol | 450.00 g |
| Water | 1.50 g |

<Preparation of image-forming layer>

Coating solution 1 for image-forming layer having the composition shown below was coated on the lower layer and dried at 80°C for one minute. The coating amount of the image-forming layer prepared was 1.2 g/$m^2$.

(Coating solution 1 for image-forming layer)

| | |
|---|---|
| Binder Polymer (1) (molecular weight: 90,000) shown below | 0.54 g |
| Electron accepting double bond compound (+ e compound) shown in Table 1 below | 0.48 g |
| Sensitizing Dye (1) shown below | 0.06 g |
| Polymerization Initiator (1) shown below | 0.10 g |
| Co-sensitizer (1) shown below | 0.07 g |
| Dispersion of ε-phthalocyanine pigment [pigment: 15 parts by weight; dispersing agent (allyl methacrylate/methacrylic acid (80/20) copolymer_ (molecular weight: 70,000)): 10 parts by weight; solvent (cyclohexanone/methoxypropyl acetate/1-methoxy-2-propanol = 15 parts by weight/20 parts by weight/40 parts by weight)] | 0.40 g |
| Methyl ethyl ketone | 4.80 g |

(continued)

| | |
|---|---|
| Dimethylsulfoxide | 4.80 g |

Binder Polymer (1):

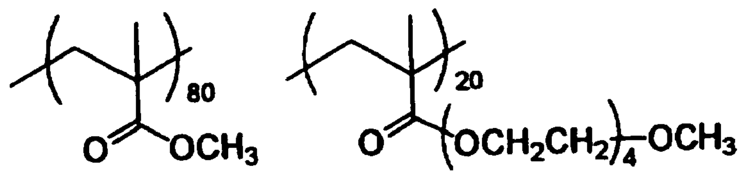

Sensitizing Dye (1):

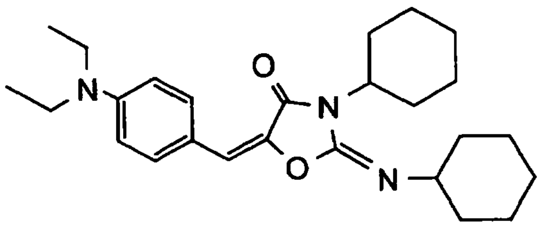

Polymerization Initiator (1):

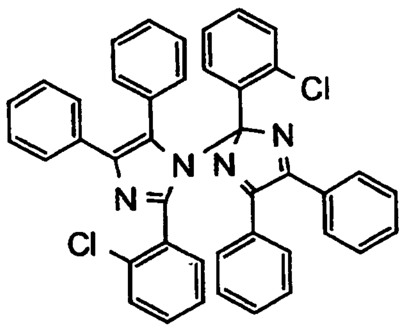

Co-sensitizer (1):

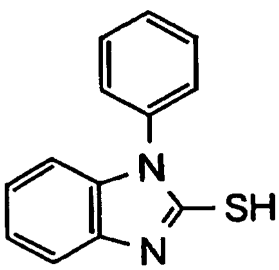

<Preparation of protective layer>

Coating solution 1 for protective layer having the composition shown below was coated on the image-forming layer using a bar so as to have a dry coating amount of 0.50 g/$m^2$ and dried at 125°C for 70 seconds to form a protective layer, thereby preparing Lithographic printing plate precursors 1 to 24, respectively.

(Coating solution 1 for protective layer)

| | |
|---|---|
| Polyvinyl alcohol (saponification degree: 98% by mole; polymerization degree: 500) | 40 g |
| Polyvinyl pyrrolidone (molecular weight: 50,000) | 5 g |
| Vinyl pyrrolidone/vinyl acetate (1/1) copolymer (molecular weight: 70,000) | 0.5 g |
| Surfactant (Emalex 710, produced by Nihon-Emulsion Co., Ltd.) | 0.5 g |
| Water | 950 g |

<Exposure, Development and Printing>

Each of Lithographic printing plate precursors 1 to 24 was subjected to imagewise exposure using a semiconductor laser of 405 nm having an output of 100 mW with varying energy density.

Then, development processing was performed in an automatic development processor having a structure shown in Fig. 1 using the aqueous developing solution having the composition shown below to prepare a lithographic printing plate (without heating). The automatic development processor was an automatic processor having two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction of lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of lithographic printing plate precursor. The transportation of the lithographic printing plate precursor was performed at transporting speed of 100 cm/min.

The aqueous developing solution was supplied on the surface of the lithographic printing plate precursor by showering from a spray pipe using a circulation pump. The tank volume for aqueous developing solution was 10 liters. The pH of the aqueous developing solution was 7.0.

(Aqueous developing solution)

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0.50 g |
| Ethylene glycol | 0.50 g |
| Ammonium primary phosphate | 0.05 g |
| Citric acid | 0.05 g |

On the other hand, within 30 seconds after the laser imagewise exposure, the exposed lithographic printing plate precursor was put in an oven and heated the entire surface of the lithographic printing plate precursor by blowing hot air to maintain at 110°C for 15 seconds and then the development processing was performed within 30 seconds in the same manner as described above to prepare a lithographic printing plate (with heating).

Then, each of the lithographic printing plate (without heating) and the lithographic printing plate (with heating) was mounted on a printing machine (SOR-M, produced by Heidelberg) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G (N) black ink (produced by Dainippon Ink & Chemicals, Inc.).

<Evaluation>

Using the lithographic printing plates prepared above, the printing durability and stain resistance were evaluated in the following manner. The results obtained are shown in Table 1.

(Printing durability)

As increase in the number of printing sheets according to the printing as described above, the image-forming layer was gradually abraded to cause decrease in the ink receptivity, resulting in decrease of ink density on a printing paper. With respect to the lithographic printing plate obtained by the exposure in the same exposure amount, a number of printing sheets obtained until the ink density (reflection density) decreased by 0.1 from that at the initiation of printing was determined to relatively evaluate the printing durability.

Specifically, the printing durability was calculated according to the formula shown below using the comparative example referred to as "Evaluation Criterion" in Table 1 as the criterion (100). As the value increases, the printing durability becomes higher.

Printing durability = (Number of printing sheets of subject lithographic printing plate)/(Number of printing sheets of criterion lithographic printing plate) x 100

(Stain resistance)

The 500th sheet of the printed material from the initiation of printing was picked up and the density of ink adhered on the non-image area was measured to relatively evaluate the stain resistance. Specifically, the stain resistance was calculated according to the formula shown below using the comparative example referred to as "Evaluation Criterion" in Table 1 as the criterion (100). As the value increases, the density of ink adhered on the non-image area decreases, that is, the stain resistance becomes better.

Stain resistance = (Ink density of non-image area on printed material of criterion lithographic printing plate)/(Ink density of non-image area on printed material of subject lithographic printing plate) x 100

TABLE 1

| | Lithographic Printing Plate Precursor | -e Compound | e Value | + e Compound | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 1 | 1 | (1-1) | -0.9 | (2-1) | 3.7 | 4.6 | 170 | 170 | 100 | 100 | |
| Example 2 | 2 | | | (2-2) | 2.3 | 3.2 | 130 | 130 | 100 | 100 | |
| Example 3 | 3 | | | (2-3) | 3.7 | 4.6 | 170 | 170 | 100 | 100 | |
| Example 4 | 4 | | | (2-4) | 0.6 | 1.5 | 110 | 110 | 100 | 100 | |
| Example 5 | 5 | (1-2) | -0.3 | (2-1) | 3.7 | 4 | 150 | 150 | 100 | 100 | |
| Example 6 | 6 | | | (2-2) | 2.3 | 2.6 | 130 | 130 | 100 | 100 | |
| Example 7 | 7 | | | (2-3) | 3.7 | 4 | 150 | 150 | 100 | 100 | |
| Example 8 | 8 | | | (2-4) | 0.6 | 0.9 | 110 | 110 | 100 | 100 | |
| Example 9 | 9 | (1-3) | -1.3 | (2-1) | 3.7 | 5 | 170 | 170 | 100 | 100 | |
| Example 10 | 10 | | | (2-2) | 2.3 | 3.6 | 150 | 150 | 100 | 100 | |
| Example 11 | 11 | | | (2-3) | 3.7 | 5 | 170 | 170 | 100 | 100 | |
| Example 12 | 12 | | | (2-4) | 0.6 | 1.9 | 110 | 110 | 100 | 100 | |
| Example 13 | 13 | (1-4) | -0.8 | (2-1) | 3.7 | 4.5 | 160 | 160 | 100 | 100 | |
| Example 14 | 14 | | | (2-2) | 2.3 | 3.1 | 140 | 140 | 100 | 100 | |
| Example 15 | 15 | | | (2-3) | 3.7 | 4.5 | 160 | 160 | 100 | 100 | |
| Example 16 | 16 | | | (2-4) | 0.6 | 1.4 | 110 | 110 | 100 | 100 | |
| Example 17 | 17 | (1-5) | -1.6 | (2-1) | 3.7 | 5.3 | 180 | 180 | 100 | 100 | |
| Example 18 | 18 | | | (2-2) | 2.3 | 3.9 | 150 | 150 | 100 | 100 | |
| Example 19 | 19 | | | (2-3) | 3.7 | 5.3 | 180 | 180 | 100 | 100 | |
| Example 20 | 20 | | | (2-4) | 0.6 | 2.2 | 120 | 120 | 100 | 100 | |

(continued)

| | Lithographic Printing Plate Precursor | -e Compound | e Value | + e Compound | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Comparative Example 1 | 21 | (1-6) | 0.4 | (2-1) | 3.7 | 3.3 | 105 | 105 | 100 | 100 | |
| Comparative Example 2 | 22 | | | (2-2) | 2.3 | 1.9 | 100 | 100 | 100 | 100 | |
| Comparative Example 3 | 23 | | | (2-3) | 3.7 | 3.3 | 105 | 105 | 100 | 100 | |
| Comparative Example 4 | 24 | | | (2-4) | 0.6 | 0.2 | 100 | 100 | 100 | 100 | Evaluation Criterion |

(1-1) 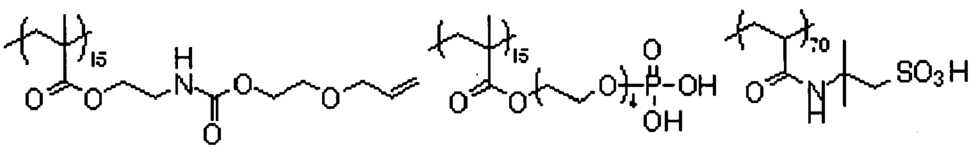

(1-2) 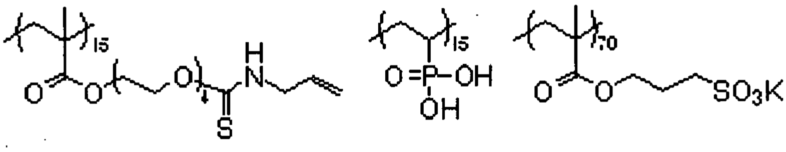

(1-3) 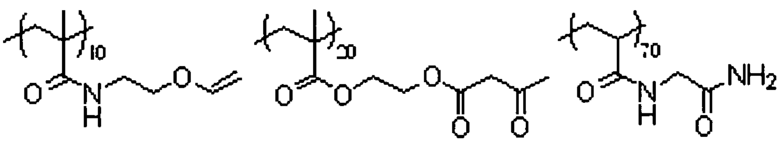

(1-4) 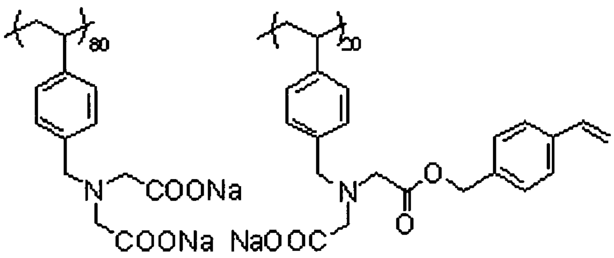

(1-5) 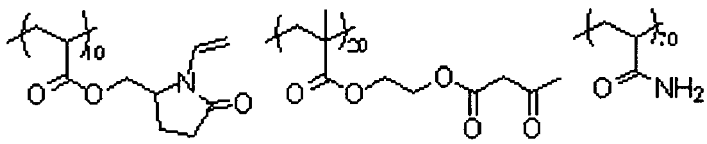

(1-6) 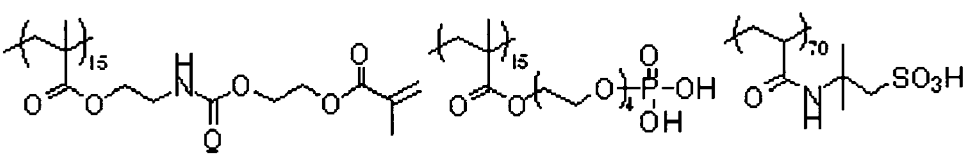

The molecular weight of the compound (1-1) is 100,000, the molecular weight of the compound (1-2) is 80,000,

the molecular weight of the compound (1-3) is 100,000, the molecular weight of the compound (1-4) is 60,000, the molecular weight of the compound (1-5) is 100,000, and the molecular weight of the compound (1-6) is 100,000.

(2-1)

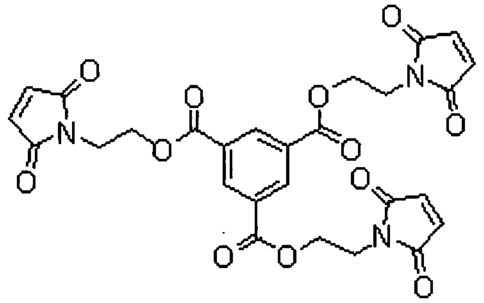

(2-2)

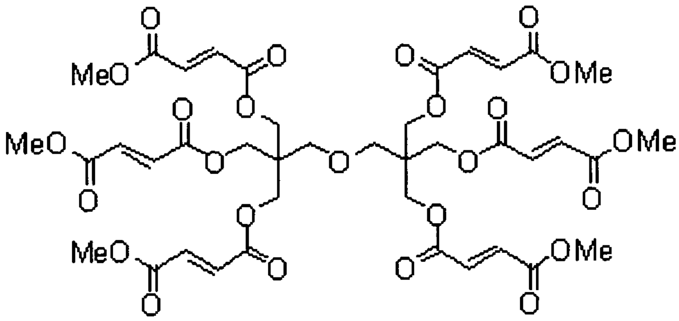

(2-3)

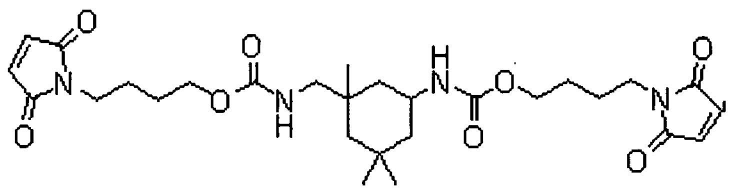

(2-4)

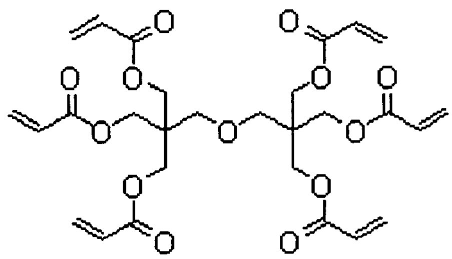

As is apparent from the results shown in Table 1, the lithographic printing plate precursor according to the invention can improve the printing durability while maintaining the stain resistance.

Examples 21 to 28 and Comparative Examples 5 to 8

[Preparation of Lithographic printing plate precursors 25 to 36]

<Preparation of lower layer>

Coating solution for lower layer having the composition shown below was coated on Aluminum support 1 obtained above and dried at 100°C for 3 minutes. The coating amount of the lower layer was 10 mg/m$^2$.

(Coating solution for lower layer)

| | |
|---|---|
| Electron accepting double bond compound shown in Table 2 below | 0.50 g |
| N-Methylpyrrolidone | 49.00 g |
| Methanol | 450.00 g |
| Water | 1.50 g |

<Preparation of image-forming layer>

Coating solution 2 for image-forming layer having the composition shown below was coated on the lower layer and dried at 80°C for one minute. The coating amount of the image-forming layer prepared was 1.2 g/m$^2$.

(Coating solution 2 for image-forming layer)

| | |
|---|---|
| Binder Polymer (1) shown above | 0.54 g |
| Electron donating double bond compound shown in Table 2 below | 0.48 g |
| Sensitizing Dye (1) shown above | 0.06 g |
| Polymerization Initiator (1) shown above | 0.10 g |
| Co-sensitizer (1) shown above | 0.07 g |
| Dispersion of ε-phthalocyanine pigment | 0.40 g |
| [pigment: 15 parts by weight; dispersing agent (allyl methacrylate/methacrylic acid (80/20) copolymer_ (molecular weight: 70,000)): 10 parts by weight; solvent (cyclohexanone/methoxypropyl acetate/1-methoxy-2-propanol = 15 parts by weight/20 parts by weight/40 parts by weight)] | |
| Methyl ethyl ketone | 4.80 g |
| Dimethylsulfoxide | 4.80 g |

<Preparation of protective layer>

Coating solution 1 for protective layer described above was coated on the image-forming layer using a bar so as to have a dry coating amount of 0.50 g/m$^2$ and dried at 125°C for 70 seconds to form a protective layer, thereby preparing Lithographic printing plate precursors 25 to 36, respectively.

<Exposure, Development and Printing>

Each of Lithographic printing plate precursors 25 to 36 was subjected to imagewise exposure using a semiconductor laser of 405 nm having an output of 100 mW with varying energy density.

Then, development processing was performed in an automatic development processor having a structure shown in Fig. 1 using the aqueous developing solution having the composition shown below to prepare a lithographic printing plate (without heating). The automatic development processor was an automatic processor having two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200

rpm (peripheral velocity at the tip of brush: 0.94 m/sec) in the same direction as the transporting direction of lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of lithographic printing plate precursor. The transportation of the lithographic printing plate precursor was performed at transporting speed of 100 cm/min.

The aqueous developing solution was supplied on the surface of the lithographic printing plate precursor by showering from a spray pipe using a circulation pump. The tank volume for aqueous developing solution was 10 liters. The pH of the aqueous developing solution was 7.0.

(Aqueous developing solution)

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0.50 g |
| Ethylene glycol | 0.50 g |
| Ammonium primary phosphate | 0.05 g |
| Citric acid | 0.05 g |

On the other hand, within 30 seconds after the laser imagewise exposure, the exposed lithographic printing plate precursor was put in an oven and heated the entire surface of the lithographic printing plate precursor by blowing hot air to maintain at 110°C for 15 seconds and then the development processing was performed within 30 seconds in the same manner as described above to prepare a lithographic printing plate (with heating).

Then, each of the lithographic printing plate (without heating) and the lithographic printing plate (with heating) was mounted on a printing machine (SOR-M, produced by Heidelberg) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G (N) black ink (produced by Dainippon Ink & Chemicals, Inc.).

<Evaluation>

Using the lithographic printing plates prepared above, the printing durability and stain resistance were evaluated in the following manner. The results obtained are shown in Table 2.

(Printing durability)

As increase in the number of printing sheets according to the printing as described above, the image-forming layer was gradually abraded to cause decrease in the ink receptivity, resulting in decrease of ink density on a printing paper. With respect to the lithographic printing plate obtained by the exposure in the same exposure amount, a number of printing sheets obtained until the ink density (reflection density) decreased by 0.1 from that at the initiation of printing was determined to relatively evaluate the printing durability.

Specifically, the printing durability was calculated according to the formula shown below using the comparative example referred to as "Evaluation Criterion" in Table 2 as the criterion (100). As the value increases, the printing durability becomes higher.

Printing durability = (Number of printing sheets of subject lithographic printing plate)/(Number of printing sheets of criterion lithographic printing plate) x 100

(Stain resistance)

The 500th sheet of the printed material from the initiation of printing was picked up and the density of ink adhered on the non-image area was measured to relatively evaluate the stain resistance. Specifically, the stain resistance was calculated according to the formula shown below using the comparative example referred to as "Evaluation Criterion" in Table 2 as the criterion (100). As the value increases, the density of ink adhered on the non-image area decreases, that is, the stain resistance becomes better.

Stain resistance = (Ink density of non-image area on printed material of criterion lithographic printing plate)/(Ink density of non-image area on printed material of subject lithographic printing plate) x 100

TABLE 2

| | Lithographic Printing Plate Precursor | + e Compound | e Value | - e Compound | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 21 | 25 | (2-5) | 1.1 | (1-7) | -1.8 | 2.9 | 130 | 130 | 100 | 100 | |
| Example 22 | 26 | | | (1-8) | -0.9 | 2 | 120 | 120 | 100 | 100 | |
| Comparative Example 5 | 27 | | | (2-4) | 0.6 | 0.5 | 100 | 100 | 100 | 100 | |
| Example 23 | 28 | (2-6) | 3.3 | (1-7) | -1.8 | 5.1 | 180 | 180 | 100 | 100 | |
| Example 24 | 29 | | | (1-8) | -0.9 | 4.2 | 160 | 160 | 100 | 100 | |
| Comparative Example 6 | 30 | | | (2-4) | 0.6 | 2.7 | 105 | 105 | 100 | 100 | |
| Example 25 | 31 | (2-7) | 3.7 | (1-7) | -1.8 | 5.5 | 180 | 180 | 100 | 100 | |
| Example 26 | 32 | | | (1-8) | -0.9 | 4.6 | 170 | 170 | 100 | 100 | |
| Comparative Example 7 | 33 | | | (2-4) | 0.6 | 3.1 | 105 | 105 | 100 | 100 | |
| Example 27 | 34 | (1-6) | 0.4 | (1-7) | -1.8 | 2.2 | 120 | 120 | 100 | 100 | |
| Example 28 | 35 | | | (1-8) | -0.9 | 1.3 | 110 | 110 | 100 | 100 | |
| Comparative Example 8 | 36 | | | (2-4) | 0.6 | 0.2 | 100 | 100 | 100 | 100 | Evaluation Criterion |

(2-5) 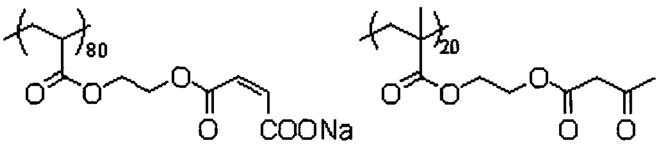

(2-6) 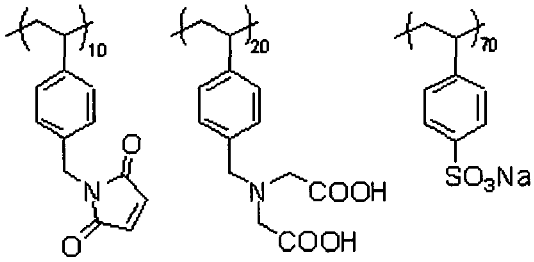

(2-7) 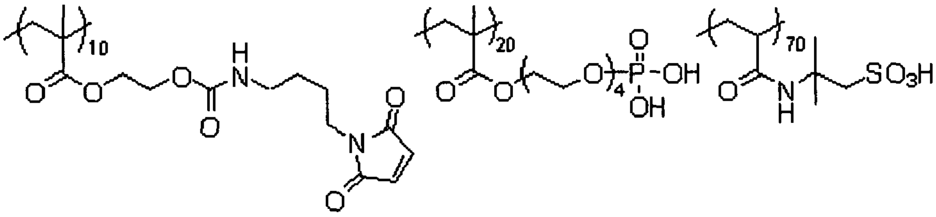

(1-7) 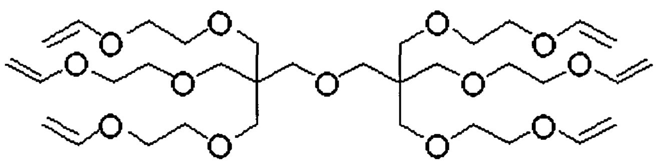

(1-8) 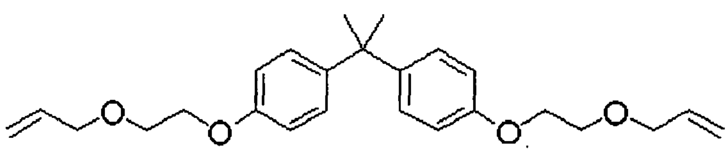

<u>The molecular weight of the compound (2-5) is 80,000, the molecular weight of the compound (2-6) is 60,000, and the molecular weight of the compound (2-7) is 90,000.</u>

As is apparent from the results shown in Table 2, the lithographic printing plate precursor according to the invention can improve the printing durability while maintaining the stain resistance.

Examples 29 to 32 and Comparative Examples 9 to 12

[Preparation of Lithographic printing plate precursors 37 to 44]

On the lower layer prepared by coating the coating solution for lower layer containing the electron donating double bond compound or the electron accepting double bond compound as shown in Table 3 on aluminum support 1, were coated Coating solution 3 for image-forming layer shown below and Coating solution 2 for protective layer shown below in the same manner as in Example 1 to prepare Lithographic printing plate precursors 37 to 44, respectively.

(Coating solution 3 for image-forming layer)

| | |
|---|---|
| Binder Polymer (2) (molecular weight: 80,000) shown below | 0.54 g |
| Polymerizable Compound (2) shown below | 0.20 g |
| Electron donating double bond compound or electron accepting double bond compound shown in Table 3 below | 0.28 g |
| Sensitizing Dye (1) shown above | 0.06 g |
| Polymerization Initiator (1) shown above | 0.18 g |
| Co-sensitizer (1) shown above | 0.07 g |
| Dispersion of ε-phthalocyanine pigment | 0.40 g |
| [pigment: 15 parts by weight; dispersing agent (allyl methacrylate/methacrylic acid (80/20) copolymer_ (molecular weight: 70,000)): 10 parts by weight; solvent (cyclohexanone/methoxypropyl acetate/1-methoxy-2-propanol = 15 parts by weight/20 parts by weight/40 parts by weight)] | |
| Thermal polymerization inhibitor | 0.01 g |
| N-nitrosophenylhydroxylamine aluminum salt | |
| Fluorine-Based Surfactant (1) (molecular weight: 11.000) shown below | 0.001 g |
| Polyoxyethylene-polyoxypropylene condensate (Pluronic L44, produced by ADEKA Corp.) | 0.04 g |
| Tetraethylamine hydrochloride | 0.01 g |
| 1-Methoxy-2-propanol | 3.5 g |
| Methyl ethyl ketone | 8.0 g |

Polymerizable Compound (2):

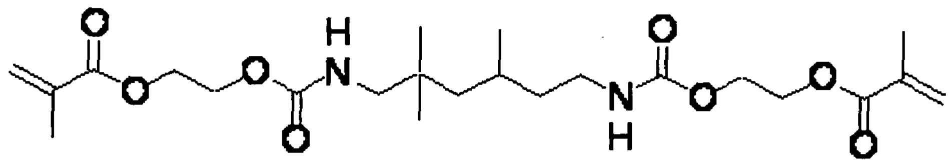

Binder Polymer (2):

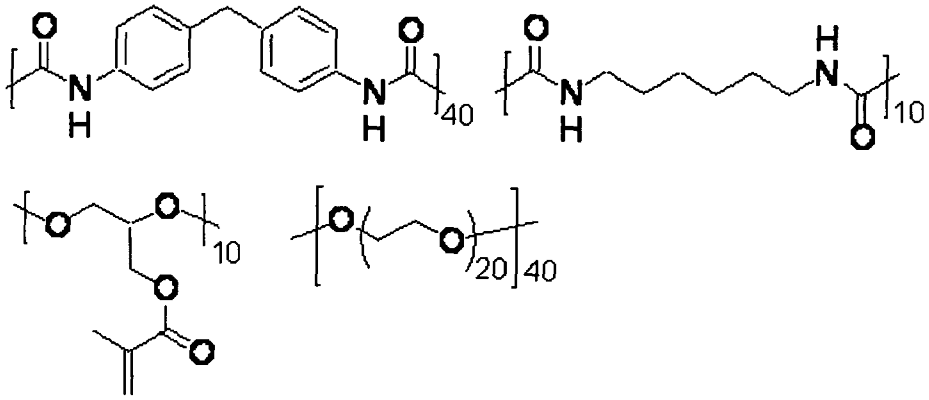

Fluorine-Based Surfactant (1)

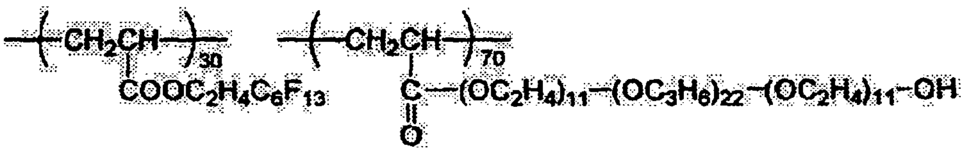

(Coating solution 2 for protective layer)

| | |
|---|---|
| Dispersion of Mica (1) shown below | 13.00 g |
| Polyvinyl alcohol (saponification degree: 98% by mole; polymerization degree: 500) | 1.30 g |
| Sodium 2-ethylhexylsulfosuccinate | 0.20 g |
| Vinyl pyrrolidone/vinyl acetate (1/1) copolymer (molecular weight: 70,000) | 0.05 g |
| Surfactant (Emalex 710, produced by Nihon-Emulsion Co., Ltd.) | 0.05 g |
| Water | 133.00 g |

(Preparation of Dispersion of Mica (1))

In 368 g of water was added 32 g of synthetic mica (SOMASIF ME-100, produced by CO-OP Chemical Co., Ltd.; aspect ratio: 1,000 or more) and the mixture was dispersed using a homogenizer until the average particle diameter (measured by a laser scattering method) became 0.5 μm to obtain Dispersion of Mica (1).

Lithographic printing plate precursors 37 to 44 thus-obtained were evaluated in the same manner as in Example 1 using the aqueous developing solution having the composition described above. As the evaluation criterion (100), the comparative example referred to as "Evaluation Criterion" in Table 3 was used. The results obtained are shown in Table 3.

TABLE 3

| | Lithographic Printing Plate Precursor | e Compound in Lower Layer | e Value | e Compound in Image-Forming Layer | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 29 | 37 | (1-1) | -0.9 | (2-3) | 3.7 | 4.6 | 170 | 170 | 100 | 100 | |
| Comparative Example 9 | 38 | (1-1) | -0.9 | (1-7) | -1.8 | 0.9 | 100 | 100 | 100 | 100 | Evaluation Criterion |
| Example 30 | 39 | (1-3) | -1.3 | (2-3) | 3.7 | 5 | 170 | 170 | 100 | 100 | |
| Comparative Example 10 | 40 | (1-3) | -1.3 | (1-7) | -1.8 | 0.5 | 100 | 100 | 100 | 100 | |
| Example 31 | 41 | (1-6) | 0.4 | (1-7) | -1.8 | 2.2 | 120 | 120 | 100 | 100 | |
| Comparative Example 11 | 42 | (1-6) | 0.4 | Polymerizable Compound (2) | 0.4 | 0 | 100 | 100 | 100 | 100 | |
| Example 32 | 43 | (2-7) | 3.7 | (1-7) | -1.8 | 5.5 | 180 | 180 | 100 | 100 | |
| Comparative Example 12 | 44 | (2-7) | 3.7 | Polymerizable Compound (2) | 0.4 | 3.3 | 105 | 105 | 100 | 100 | |

As is apparent from the results shown in Table 3, the lithographic printing plate precursor according to the invention can improve the printing durability while maintaining the stain resistance.

Examples 33 to 36 and Comparative Examples 13 to 16

[Preparation of Lithographic printing plate precursors 45 to 52]

<Preparation of Aluminum support 2>

An aluminum plate according to JIS A 1050 having a thickness of 0.3 mm was subjected to surface treatment by performing processes (a) to (k) shown below in this order.

(a) Mechanical surface roughening treatment

Mechanical surface roughening of the aluminum plate was conducted by means of rotating roller-form nylon brushes while supplying a suspension (having specific gravity of 1.12) of an abrasive (silica sand) in water as an abrasion slurry solution to the surface of the aluminum plate. The average particle size of the abrasive was 8 μm and the maximum particle size was 50 μm. The material of the nylon brush was 6·10 nylon, and the brush has a bristle length of 50 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) provided under the brush rollers were spaced 300 mm. The brush rollers were pressed against the aluminum plate till the load applied to a driving motor for rotating the brush became 7 kw greater than the load before pressing the brush rollers against the aluminum plate. The rotating direction of the brushes was the same as the moving direction of the aluminum plate. The rotation number of the brushes was 200 rpm.

(b) Alkali etching treatment

Etching treatment of the aluminum plate was conducted by spraying an aqueous sodium hydroxide solution (sodium hydroxide concentration: 26% by weight, aluminum ion concentration: 6.5% by weight) having temperature of 70°C to dissolve the aluminum plate in an amount of 6 g/m$^2$, followed by washing by spraying well water.

(c) Desmut treatment

Desmut treatment of the aluminum plate was conducted by spraying an aqueous 1% by weight nitric acid solution (containing 0.5% by weight of aluminum ion) having temperature of 30°C, followed by washing with water by spraying. The aqueous nitric acid solution used for the desmut treatment was a waste solution of the process of conducting electrochemical surface roughening treatment using alternating current in an aqueous nitric acid solution described below.

(d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion) and the solution temperature was 50°C. The electrochemical surface roughening treatment was conducted using an alternating current source, which provided a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm$^2$ at the peak current, and the electric amount was 220 C/dm$^2$ in terms of the total electric quantity during the aluminum plate functioning as an anode. To the auxiliary anode, 5% of the current from the electric source was divided. Subsequently, the plate was washed by spraying well water.

(e) Alkali etching treatment

Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.20 g/m$^2$. Thus, the smut component mainly comprising aluminum hydroxide formed in the precedent process of conducting electrochemical surface roughening treatment using alternating current was removed and an edge portion of the pit formed was dissolved to smoothen the edge portion. Subsequently, the plate was washed by spraying well water.

(f) Desmut treatment

Desmut treatment of the aluminum plate was conducted by spraying an aqueous 15% by weight nitric acid solution (containing 4.5% by weight of aluminum ion) having temperature of 30°C, followed by washing by spraying well water. The aqueous nitric acid solution used for the desmut treatment was a waste solution of the process of conducting electrochemical surface roughening treatment using alternating current in an aqueous nitric acid solution described above.

(g) Electrochemical surface roughening treatment

Electrochemical surface roughening treatment of the aluminum plate was continuously conducted by applying 60 Hz alternating current voltage. The electrolytic solution used was an aqueous solution containing 7.5 g/liter of hydrochloric acid (containing 5 g/liter of aluminum ion) and the solution temperature was 35°C. The electrochemical surface roughening treatment was conducted using an alternating current source which provided a rectangular wave alternating current and using a carbon electrode as a counter electrode. A ferrite was used as an auxiliary anode. The electrolytic cell used was a radial cell type. The current density was 25 A/dm$^2$ at the peak current, and the electric amount was 50 C/dm$^2$ in terms of the total electric quantity during the aluminum plate functioning as an anode. Subsequently, the plate was washed by spraying well water.

(h) Alkali etching treatment

Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.10 g/m$^2$. Thus, the smut component mainly comprising aluminum hydroxide formed in the precedent process of conducting electrochemical surface roughening treatment using alternating current was removed and an edge portion of the pit formed was dissolved to smoothen the edge portion. Subsequently, the plate was washed by spraying well water.

(i) Desmut treatment

Desmut treatment of the aluminum plate was conducted by spraying an aqueous 25% by weight sulfuric acid solution (containing 0.5% by weight of aluminum ion) having temperature of 60°C, followed by washing by spraying well water.

(j) Anodizing treatment

Anodizing treatment of the aluminum plate was conducted using sulfuric acid as an electrolytic solution. The electrolytic solution was an aqueous solution having sulfuric acid concentration of 170 g/liter (containing 0.5% by weight of aluminum ion) and the temperature thereof was 43°C. The current density was about 30 A/dm$^2$. Subsequently, the plate was washed by spraying well water. The amount of the final anodic oxide film was 2.7 g /m$^2$.

(k) Alkali metal silicate treatment

Alkali metal silicate treatment (silicate treatment) of the aluminum plate was conducted by immersing the aluminum plate in a treatment tank containing an aqueous 1% by weight sodium silicate solution No. 3 having temperature of 30°C for 10 seconds. Subsequently, the plate was washed by spraying well water, whereby Aluminum support 2 was prepared. The adhesion amount of the silicate was 3.6 mg/m$^2$.

<Preparation of lower layer>

Coating solution for lower layer having the composition shown below was coated on Aluminum support 2 obtained above and dried at 100°C for 3 minutes. The coating amount of the lower layer was 7 mg/m$^2$.

(Coating solution for lower layer)

| | |
|---|---|
| Electron donating double bond compound or Electron accepting double bond compound shown in Table 4 below | 0.50 g |
| N-Methylpyrrolidone | 50.00 g |
| Methanol | 450.00 g |

<Preparation of image-forming layer>

Coating solution 4 for image-forming layer having the composition shown below was coated on the lower layer using a bar and dried in an oven at 70°C for 60 seconds to form an image-forming layer having a dry coating amount of 1.1 g/$m^2$. Coating solution 4 for image-forming layer was prepared by mixing Mother solution (1) shown below with Microcapsule solution (2) shown below just before coating.

Mother solution (1)

| | |
|---|---|
| Binder Polymer (3) (molecular weight: 80,000) shown below | 0.162 g |
| Polymerization Initiator (2) shown below | 0.160 g |
| Polymerization Initiator (3) shown below | 0.180 g |
| Infrared Absorbing Agent (3) shown below | 0.020 g |
| Polymerizable compound (Aronics M-215, produced by Toa Gosei Co., Ltd.) | 0.185 g |
| Electron donating double bond compound or Electron accepting double bond compound shown in Table 4 below | 0.200 g |
| Fluorine-Based Surfactant (1) shown below | 0.044 g |
| Methyl ethyl ketone | 1.091 g |
| 1-Methoxy-2-propanol | 8.210 g |

The electron donating double bond compound or electron accepting double bond compound is also referred to as "e compound" hereinafter.

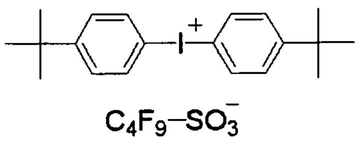

Polymerization Initiator (3)

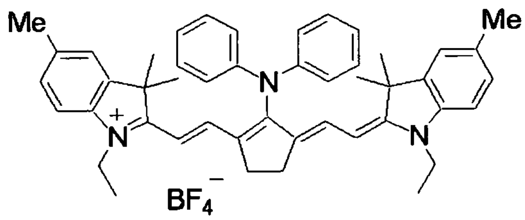

Infrared Absorbing Agent (3)

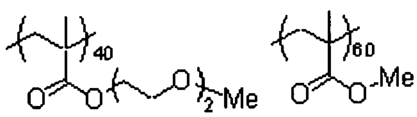

Binder Polymer (3)

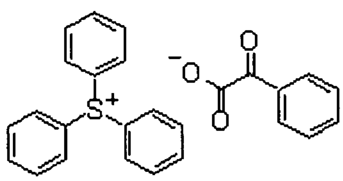

Polymerization Initiator (2)

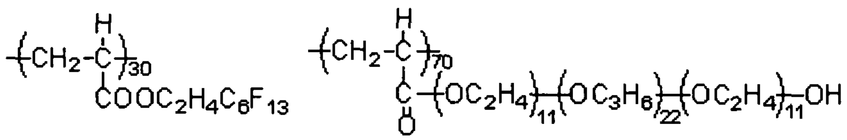

Fluorine-Based Surfactant (1)

Microcapsule solution (2)

| | |
|---|---|
| Microcapsule (2) prepared as shown below | 2.640 g |
| Water | 2.425 g |

Preparation of Microcapsule (2)

As an oil phase component, 10 g of adduct of trimethylolpropane and xylene diisocyanate (Takenate D-110N, produced by Mitsui Takeda Chemicals, Inc., 75% by weight ethyl acetate solution), 6.00 g of Aronics SR-399 (produced by Toa Gosei Co., Ltd.) and 0.12 g of Pionin A-41C (produced by Takemoto Oil & Fat Co., Ltd.) were dissolved in 16.67 g of ethyl acetate. As an aqueous phase component, 37.5 g of an aqueous 4% by weight PVA-205 solution was prepared. The oil phase component and the aqueous phase component were mixed and emulsified using a homogenizer at 12,000 rpm for 10 minutes. The resulting emulsion was added to 25 g of distilled water and the mixture was stirred at room temperature for 30 minutes and then stirred at 40°C for 2 hours. The thus-obtained microcapsule solution was diluted with distilled water to have a solid content concentration of 15% by weight to prepare Microcapsule (2). The average particle diameter of the microcapsule was 0.2 μm.

<Preparation of protective layer>

Coating solution 3 for protective layer having the composition shown below was coated on the image-forming layer using a bar and dried in an oven at 125°C for 75 seconds to form a protective layer having a dry coating amount of 0.15 g /m$^2$, thereby preparing Lithographic printing plate precursors 45 to 52, respectively.

(Coating solution 3 for protective layer)

| | |
|---|---|
| Polyvinyl alcohol (aqueous 6% by weight solution) (PVA 105, produced by Kuraray Co., Ltd., saponification degree: 98.5% by mole; polymerization degree: 500) | 2.24 g |
| Polyvinyl pyrrolidone (K 30) (molecular weight: 58,000) | 0.0053 g |
| Surfactant (aqueous 1% by weight solution) (Emalex 710, produced by Kao Corp.) | 2.15 g |
| Scale-like synthetic mica (aqueous 3.4% by weight dispersion)(MEB 3L, produced by UNICOO Co., Ltd., average particle size: 1 to 5 μm) | 3.75 g |
| Distilled water | 10.60 g |

<Exposure, Development and Printing>

Each of Lithographic printing plate precursors 45 to 52 was exposed by Trendsetter 3244VX, produced by Creo Co., equipped with a water-cooled 40 W infrared semiconductor laser under the conditions of output of 9W, a rotational number of an outer surface drum of 210 rpm and resolution of 2,400 dpi.

Then, development processing was performed in an automatic development processor having a structure shown in Fig. 1 using Aqueous developing solution 3 (pH: 4.5) having the composition shown below to prepare a lithographic printing plate (without heating). The automatic development processor was an automatic processor having

two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction of lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of lithographic printing plate precursor. The transportation of the lithographic printing plate precursor was performed at transporting speed of 100 cm/min.

Aqueous developing solution 3 was supplied on the surface of the lithographic printing plate precursor by showering from a spray pipe using a circulation pump. The tank volume for Aqueous developing solution 3 was 10 liters.

(Aqueous developing solution 3)

| | |
|---|---|
| Water | 100.00 g |
| Polyoxyethylene naphthyl ether (average number of oxyethylene: n = 13) | 0.50 g |
| Sodium salt of dioctylsulfosuccinic acid ester | 0.50 g |
| Ammonium primary phosphate | 0.05 g |
| Citric acid | 0.05 g |

On the other hand, within 30 seconds after the laser imagewise exposure, the exposed lithographic printing plate precursor was put in an oven and heated the entire surface of the lithographic printing plate precursor by blowing hot air to maintain at 110°C for 15 seconds and then the development processing was performed within 30 seconds in the same manner as described above to prepare a lithographic printing plate (with heating).

Then, each of the lithographic printing plate (without heating) and the lithographic printing plate (with heating) was mounted on a printing machine (SOR-M, produced by Heidelberg) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G (N) black ink (produced by Dainippon Ink & Chemicals, Inc.).

<Evaluation>

With respect to the lithographic printing plates prepared above, the printing durability and stain resistance were evaluated in the same manner as in Example 1. The results obtained are shown in Table 4. As the evaluation criterion (100), the comparative example referred to as "Evaluation Criterion" in Table was used.

TABLE 4

| | Lithographic Printing Plate Precursor | e Compound in Lower Layer | e Value | e Compound in Image-Forming Layer | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 33 | 45 | (1-1) | -0.9 | (2-3) | 3.7 | 4.6 | 170 | 170 | 100 | 100 | |
| Comparative Example 13 | 46 | (1-1) | -0.9 | (1-7) | -1.8 | 0.9 | 100 | 100 | 100 | 100 | Evaluation Criterion |
| Example 34 | 47 | (1-3) | -1.3 | Aronics M-215 | 0.6 | 1.9 | 110 | 110 | 100 | 100 | |
| Comparative Example 14 | 48 | (1-3) | -1.3 | (1-7) | -1.8 | 0.5 | 100 | 100 | 100 | 100 | |
| Example 35 | 49 | (1-6) | 0.4 | (1-7) | -1.8 | 2.2 | 120 | 120 | 100 | 100 | |
| Comparative Example 15 | 50 | (1-6) | 0.4 | (2-3) | 3.7 | 3.3 | 105 | 105 | 100 | 100 | |
| Example 36 | 51 | (2-7) | 3.7 | (1-7) | -1.8 | 5.5 | 180 | 180 | 100 | 100 | |
| Comparative Example 16 | 52 | (2-7) | 3.7 | Aronics M-215 | 0.6 | 3.1 | 105 | 105 | 100 | 100 | |

The structure of Aronics M-215 shown in Table 4 is described below.

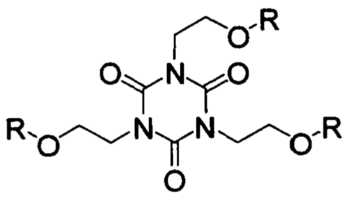

R=H or

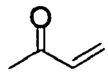

Aronics M-215

As is apparent from the results shown in Table 4, the lithographic printing plate precursor according to the invention can improve the printing durability while maintaining the stain resistance.

Examples 37 to 40 and Comparative Examples 17 to 20

Each of Lithographic printing plate precursors 45 to 52 was exposed by Trendsetter 3244VX, produced by Creo Co., equipped with a water-cooled 40 W infrared semiconductor laser under the conditions of output of 9W, a rotational number of an outer surface drum of 210 rpm and resolution of 2,400 dpi. The exposed lithographic printing plate precursor was mounted without conducting development processing on a plate cylinder of a printing machine (SOR-M, produced by Heidelberg Co.). After supplying Dampening water (1) (adjusted pH to 4.5) having the composition shown below and TRANS-G (N) black ink (produced by Dainippon Ink & Chemicals, Inc.), printing was performed at a printing speed of 6,000 sheets per hour. The printing durability and stain resistance were evaluated in the same manner as in Example 1. The results obtained are shown in Table 5. As the evaluation criterion (100), the comparative example referred to as "Evaluation Criterion" in Table 5 was used.

<Dampening water (1) >

| | |
|---|---|
| EU-3 (etching solution, produced by Fuji Film Co., Ltd.) | 1 part by weight |
| Water | 89 parts by weight |
| Isopropyl alcohol | 7 parts by weight |

TABLE 5

| | Lithographic Printing Plate Precursor | e Compound in Lower Layer | e Value | e Compound in Image-Forming Layer | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 37 | 45 | (1-1) | -0.9 | (2-3) | 3.7 | 4.6 | 170 | 170 | 100 | 100 | |
| Comparative Example 17 | 46 | (1-1) | -0.9 | (1-7) | -1.8 | 0.9 | 100 | 100 | 100 | 100 | Evaluation Criterion |
| Example 38 | 47 | (1-3) | -1.3 | Aronics M-215 | 0.6 | 1.9 | 110 | 110 | 100 | 100 | |
| Comparative Example 18 | 48 | (1-3) | -1.3 | (1-7) | -1.8 | 0.5 | 100 | 100 | 100 | 100 | |
| Example 39 | 49 | (1-6) | 0.4 | (1-7) | -1.8 | 2.2 | 120 | 120 | 100 | 100 | |
| Comparative Example 19 | 50 | (1-6) | 0.4 | (2-3) | 3.7 | 3.3 | 105 | 105 | 100 | 100 | |
| Example 40 | 51 | (2-7) | 3.7 | (1-7) | -1.8 | 5.5 | 180 | 180 | 100 | 100 | |
| Comparative Example 20 | 52 | (2-7) | 3.7 | Aronics M-215 | 0.6 | 3.1 | 105 | 105 | 100 | 100 | |

Examples 41 to 456 and Comparative Examples 21 and 22

[Preparation of Lithographic printing plate precursors 53 to 59]

<Preparation of lower layer>

Coating solution for lower layer having the composition shown below was coated on Aluminum support 1 obtained above and dried at 100°C for 3 minutes. The coating amount of the lower layer was 10 $mg/m^2$.

(Coating solution for lower layer)

| | |
|---|---|
| Electron donating double bond compound (1-1) or Electron accepting double bond compound (2-7) shown in Table 6 below | 0.50 g |
| N-Methylpyrrolidone | 49.00 g |
| Methanol | 450.00 g |
| Water | 1.50 g |

<Preparation of image-forming layer>

Coating solution A for image-forming layer having the composition shown below was coated on the lower layer and dried at 100°C for one minute. The coating amount of the image-forming layer prepared was 1.5 $g/m^2$.

(Coating solution A for image-forming layer)

| | |
|---|---|
| Binder Polymer (4) (molecular weight: 100,000) shown below | 0.54 g |
| Electron donating double bond compound or Electron accepting double bond compound shown in Table 6 below | X g |
| Pentaerythritol tetraacrylate | (0.48 - X) g |
| Sensitizing Dye (1) shown above | 0.06 g |
| Polymerization Initiator (1) shown above | 0.10 g |
| Co-sensitizer (1) shown above | 0.07 g |
| Dispersion of ε-phthalocyanine pigment | 0.40 g |
| [pigment: 15 parts by weight; dispersing agent (allyl methacrylate/methacrylic acid (80/20) copolymer_ (molecular weight: 70,000)): 10 parts by weight; solvent (cyclohexanone/methoxypropyl acetate/1-methoxy-2-propanol = 15 parts by weight/20 parts by weight/40 parts by weight)] | |
| Methyl ethyl ketone | 4.80 g |
| 1-Methoxy-2-propanol | 4.80 g |

Binder Polymer (4~~1~~):

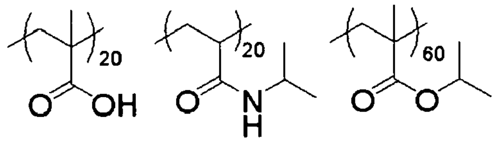

In Coating solution A for image-forming layer, X is 0.30, when the electron donating double bond compound or electron accepting double bond compound is added and X is 0, when the electron donating double bond compound or electron accepting double bond compound is not added.

<Preparation of protective layer>

An aqueous 3% by weight polyvinyl alcohol (saponification degree: 98% by mole, polymerization degree: 550) solution was coated on the image-forming layer to have a dry coating amount of 2 g/m$^2$ and dried at 100°C for 2 minutes to form a protective layer, thereby preparing Lithographic printing plate precursors 53 to 59, respectively.

<Exposure, Development and Printing>

Each of Lithographic printing plate precursors 53 to 59 was subjected to imagewise exposure using a semiconductor laser of 405 nm having an output of 100 mW with varying energy density. Within 30 seconds after the laser imagewise exposure, the exposed lithographic printing plate precursor was put in an oven and heated the entire surface of the lithographic printing plate precursor by blowing hot air to maintain at 110°C for 15 seconds. Then, development processing was performed within 30 seconds in an automatic development processor having a structure shown in Fig. 1 using the aqueous developing solution (adjusted pH to 13.0 with KOH) having the composition shown below to prepare a lithographic printing plate. The automatic development processor was an automatic processor having two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction of lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of lithographic printing plate precursor. The transportation of the lithographic printing plate precursor was performed at transporting speed of 100 cm/min.

The aqueous developing solution was supplied on the surface of the lithographic printing plate precursor by showering from a spray pipe using a circulation pump. The tank volume for aqueous developing solution was 10 liters.

(Aqueous developing solution)

| | |
|---|---|
| DV-2 (produced by Fuji Film Co., Ltd.) | 200.00 g |
| Water | 800.00 g |

Then, the lithographic printing plate obtained was mounted on a printing machine (SOR-M, produced by Heidelberg) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G (N) black ink (produced by Dainippon Ink & Chemicals, Inc.).

<Evaluation>

Using the lithographic printing plates prepared above, the printing durability and stain resistance were evaluated in the following manner. The results obtained are shown in Table 6.

(Printing durability)

As increase in the number of printing sheets according to the printing as described above, the image-forming layer was gradually abraded to cause decrease in the ink receptivity, resulting in decrease of ink density on a printing paper. With respect to the lithographic printing plate obtained by the exposure in the same exposure amount, a number of printing sheets obtained until the ink density (reflection density) decreased by 0.1 from that at the initiation of printing was determined to relatively evaluate the printing durability.

Specifically, the printing durability was calculated according to the formula shown below using the comparative example 22 referred to as "Evaluation Criterion" in Table 6 as the criterion (100). As the value increases, the printing durability becomes higher.

Printing durability = (Number of printing sheets of subject lithographic printing plate)/(Number of printing sheets of criterion lithographic printing plate) x 100

(Stain resistance)

The 500th sheet of the printed material from the initiation of printing was picked up and the density of ink adhered on the non-image area was measured to relatively evaluate the stain resistance. Specifically, the stain resistance was calculated according to the formula shown below using the comparative example 22 referred to as "Evaluation Criterion" in Table 6 as the criterion (100) respectively. As the value increases, the density of ink adhered on the non-image area decreases, that is, the stain resistance becomes better.

Stain resistance = (Ink density of non-image area on printed material of criterion lithographic printing plate)/(Ink density of non-image area on printed material of subject lithographic printing plate) x 100

TABLE 6

| | Lithographic Printing Plate Precursor | e Compound in Lower Layer | e Value | e Compound in Image-Forming Layer | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 41 | 53 | (1-1) | -0.9 | (2-1) | 3.7 | 4.6 | 145 | 170 | 100 | 100 | |
| Example 42 | 54 | | | (2-2) | 2.3 | 3.2 | 130 | 140 | 100 | 100 | |
| Example 43 | 55 | | | (2-3) | 3.7 | 4.6 | 145 | 170 | 100 | 100 | |
| Comparative Example 21 | 56 | | | None | 0.6 | 1.5 | 105 | 100 | 100 | 100 | |
| Example 44 | 57 | (2-7) | 3.7 | (1-7) | -1.8 | 5.5 | 150 | 180 | 100 | 100 | |
| Example 45 | 58 | | | (1-8) | -0.9 | 4.6 | 154 | 170 | 100 | 100 | |
| Comparative Example 22 | 59 | | | None | 0.6 | 3.1 | 100 | 100 | 100 | 100 | Evaluation Criterion |

As is apparent from the results shown in Table 6, the lithographic printing plate precursor according to the invention can improve the printing durability while maintaining the stain resistance.

<u>Examples 46 to 50 and Comparative Examples 23 and 24</u>

[Preparation of Lithographic printing plate precursors 60 to 66]

<Preparation of lower layer>

Coating solution for lower layer having the composition shown below was coated on Aluminum support 1 obtained above and dried at 100°C for 3 minutes. The coating amount of the lower layer was 10 mg/$m^2$.

(Coating solution for lower layer)

| | |
|---|---|
| Electron donating double bond compound (1-1) or Electron accepting double bond compound (2-7) shown in Table 7 below | 0.50 g |
| N-Methylpyrrolidone | 49.00 g |
| Methanol | 450.00 g |
| Water | 1.50 g |

<Preparation of image-forming layer>

Coating solution B for image-forming layer having the composition shown below was coated on the lower layer and dried at 100°C for one minute. The coating amount of the image-forming layer prepared was 1.5 g/$m^2$. Thus, Lithographic printing plate precursors 60 to 66 were prepared, respectively.

(Coating solution B for image-forming layer)

| | |
|---|---|
| Binder Polymer (<u>4</u>) shown below | 1.00 g |
| Electron donating double bond compound or Electron accepting double bond compound shown in Table 7 below | X g |
| Dipentaerythritol hexaaacrylate | (1.00 - X) g |
| Sensitizing Dye (Y-5) shown below | 0.30 g |
| Polymerization Initiator (X-3) shown below | 0.20 g |
| Fluorine-based surfactant | 0.03 g |
| (Megafac F-177, produced by Dainippon Ink & Chemicals, Inc.) | |
| Methyl ethyl ketone | 10.0 g |
| 1-Methoxy-2-propanol | 10.0 g |

Binder Polymer (<u>4</u>~~1~~):

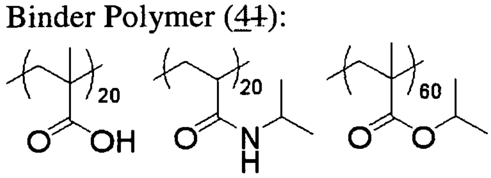

Sensitizing Dye (Y-5):

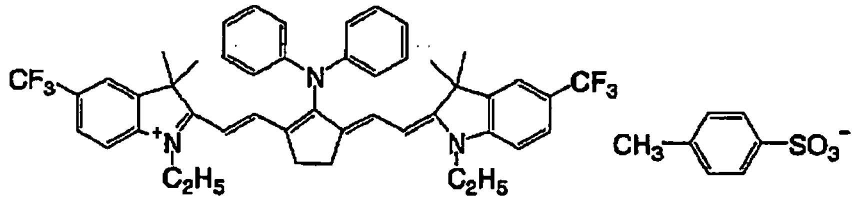

Polymerization Initiator (X-3):

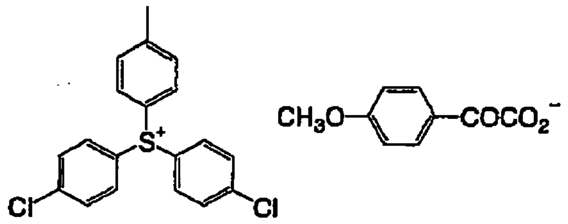

In Coating solution B for image-forming layer, X is 0.60, when the electron donating double bond compound or electron accepting double bond compound is added and X is 0, when the electron donating double bond compound or electron accepting double bond compound is not added.

<Exposure, Development and Printing>

Each of Lithographic printing plate precursors 60 to 66 was exposed by Trendsetter 3244VX, produced by Creo Co., equipped with a water-cooled 40 W infrared semiconductor laser under the conditions of output of 9W, a rotational number of an outer surface drum of 210 rpm and resolution of 2,400 dpi.

Within 30 seconds after the laser imagewise exposure, the exposed lithographic printing plate precursor was subjected to development processing in an automatic development processor having a structure shown in Fig. 1 using the aqueous developing solution (adjusted pH to 13.0 with KOH) having the composition shown below to prepare a lithographic printing plate. The automatic development processor was an automatic processor having two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction of lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of lithographic printing plate precursor. The transportation of the lithographic printing plate precursor was performed at transporting speed of 100 cm/min.

The aqueous developing solution was supplied on the surface of the lithographic printing plate precursor by showering from a spray pipe using a circulation pump. The tank volume for aqueous developing solution was 10 liters.

(Aqueous developing solution)

| | |
|---|---|
| DV-2 (produced by Fuji Film Co., Ltd.) | 200.00 g |
| Water | 800.00 g |

Then, the lithographic printing plate obtained was mounted on a printing machine (SOR-M, produced by Heidelberg) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G (N) black

ink (produced by Dainippon Ink & Chemicals, Inc.).

<Evaluation>

Using the lithographic printing plates prepared above, the printing durability and stain resistance were evaluated in the following manner. The results obtained are shown in Table 7.

(Printing durability)

As increase in the number of printing sheets according to the printing as described above, the image-forming layer was gradually abraded to cause decrease in the ink receptivity, resulting in decrease of ink density on a printing paper. With respect to the lithographic printing plate obtained by the exposure in the same exposure amount, a number of printing sheets obtained until the ink density (reflection density) decreased by 0.1 from that at the initiation of printing was determined to relatively evaluate the printing durability.

Specifically, the printing durability was calculated according to the formula shown below using the comparative example 24 referred to as "Evaluation Criterion" in Table 7 as the criterion (100). As the value increases, the printing durability becomes higher.

Printing durability = (Number of printing sheets of subject lithographic printing plate)/(Number of printing sheets of criterion lithographic printing plate) x 100

(Stain resistance)

The 500th sheet of the printed material from the initiation of printing was picked up and the density of ink adhered on the non-image area was measured to relatively evaluate the stain resistance. Specifically, the stain resistance was calculated according to the formula shown below using the comparative example 24 referred to as "Evaluation Criterion" in Table 7 as the criterion (100) respectively. As the value increases, the density of ink adhered on the non-image area decreases, that is, the stain resistance becomes better.

Stain resistance = (Ink density of non-image area on printed material of criterion lithographic printing plate)/(Ink density of non-image area on printed material of subject lithographic printing plate) x 100

TABLE 7

| | Lithographic Printing Plate Precursor | e Compound in Lower Layer | e Value | e Compound in Image-Forming Layer | e Value | Difference in e Value | Printing Durability | | Stain Resistance | | Evaluation Criterion |
|---|---|---|---|---|---|---|---|---|---|---|---|
| | | | | | | | Without Heating | With Heating | Without Heating | With Heating | |
| Example 46 | 60 | (1-1) | -0.9 | (2-1) | 3.7 | 4.6 | 145 | 170 | 100 | 100 | |
| Example 47 | 61 | | | (2-2) | 2.3 | 3.2 | 130 | 140 | 100 | 100 | |
| Example 48 | 62 | | | (2-3) | 3.7 | 4.6 | 145 | 170 | 100 | 100 | |
| Comparative Example 23 | 63 | | | None | 0.6 | 1.5 | 105 | 100 | 100 | 100 | |
| Example 49 | 64 | (2-7) | 3.7 | (1-7) | -1.8 | 5.5 | 150 | 180 | 100 | 100 | |
| Example 50 | 65 | | | (1-8) | -0.9 | 4.6 | 154 | 170 | 100 | 100 | |
| Comparative Example 24 | 66 | | | None | 0.6 | 3.1 | 100 | 100 | 100 | 100 | Evaluation Criterion |

As is apparent from the results shown in Table 7, the lithographic printing plate precursor according to the invention can improve the printing durability while maintaining the stain resistance.

As can be seen from the results of the examples described above, the lithographic printing plate of a simple development type having high printing durability and excellent stain resistance can be particularly obtained by using the lithographic printing plate precursor according to the invention.

## Claims

1. A lithographic printing plate precursor comprising: a support; a layer A comprising a compound having a functional group represented by the following formula (1); and a layer B comprising a compound having a functional group represented by the following formula (2):

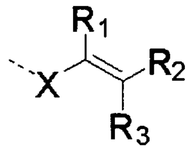 (1)

wherein, in the formula (1), $R_1$ to $R_3$ each independently represents a hydrogen atom or a monovalent substituent, X represents -O-, -S-, -N($R_4$)-, -C($R_5$)($R_6$)- or -Ar-, $R_4$ to $R_6$ each independently represents a hydrogen atom, an alkyl group, an aryl group, an alkenyl group or an alkynyl group, Ar represents an aromatic ring, and a dotted line represents a connecting bond to a mother skeleton of the compound, or any one of $R_1$ to $R_6$ and Ar in X may be connected to the mother skeleton of the compound to form a ring;

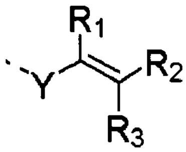 (2)

in the formula (2), $R_1$ to $R_3$ each independently represents a hydrogen atom or a monovalent substituent, Y represents -CO- or -$SO_2$-, and a dotted line represents a connecting bond to a mother skeleton of the compound, or any one of $R_1$ to $R_3$ may be connected to the mother skeleton of the compound to form a ring.

2. The lithographic printing plate precursor as claimed in Claim 1, which comprises: a support; a layer A comprising a compound having a functional group represented by the following formula (1); and a layer B comprising a compound having a functional group represented by the following formula (2):

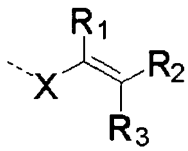 (1)

wherein, in the formula (1), $R_1$ to $R_3$ each independently represents a hydrogen atom, an alkyl group, an aryl group, an alkenyl group, an alkynyl group, an alkoxy group, an alkylthio group, an aryloxy group, an arylthio group, an amino group, an acyloxy group, an acylamino group, a sulfoxy group or a sulfoamino group, X represents -O-, -S-, -N($R_4$)-, -C($R_5$)($R_6$)- or -Ar-, $R_4$ to $R_6$ each independently represents a hydrogen atom, an alkyl group, an aryl group, an alkenyl group or an alkynyl group, Ar represents an aromatic ring, and a dotted line represents a connecting bond to a mother skeleton of the compound, or any one of $R_1$ to $R_6$ and Ar in X may be connected to the mother skeleton of the compound to form a ring;

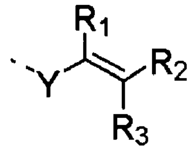 (2)

in the formula (2), $R_1$ to $R_3$ each independently represents a hydrogen atom, an alkyl group, an aryl group, an alkenyl group, an alkynyl group, a cyano group, an acyl group, an alkylacyl group, an arylacyl group, an alkoxyacyl group, an aryloxyacyl group, an aminoacyl group or a sulfone group, Y represents -CO- or -$SO_2$-, and a dotted line represents a connecting bond to a mother skeleton of the compound, or any one of $R_1$ to $R_3$ may be connected to the mother skeleton of the compound to form a ring.

**3.** The lithographic printing plate precursor as claimed in Claim 2, wherein, in the functional group represented by the formula (1), X represents -O-, -N($R_4$)-, -C($R_5$)($R_6$)- or -Ar-, $R_4$ to $R_6$ each independently represents a hydrogen atom, an alkyl group having 6 or less carbon atoms or a phenyl group, and Ar represents a phenyl group, a naphthyl group, a phenyl group having an electron donating group or a naphthyl group having an electron donating group.

**4.** The lithographic printing plate precursor as claimed in Claim 2, wherein, in the functional group represented by the formula (2), Y represents -CO-.

**5.** The lithographic printing plate precursor as claimed in Claim 2, wherein, in the functional group represented by the formula (2), Y represents -CO-, and at least one of $R_1$ to $R_3$ represents an alkylacyl group, an arylacyl group, an alkoxyacyl group, an aryloxyacyl group, an aminoacyl group, a sulfone group or a cyano group.

**6.** The lithographic printing plate precursor as claimed in Claim 1, wherein the layer A is an undercoat layer, the layer B is an image-forming layer, and the layer A and the layer B are adjacent to each other.

**7.** The lithographic printing plate precursor as claimed in Claim 1, wherein the layer B is an undercoat layer, the layer A is an image-forming layer, and the layer A and the layer B are adjacent to each other.

**8.** The lithographic printing plate precursor as claimed in Claim 6, wherein the compound having a functional group represented by the formula (1) is a polymer compound.

**9.** The lithographic printing plate precursor as claimed in Claim 7, wherein the compound having a functional group represented by the formula (2) is a polymer compound.

**10.** The lithographic printing plate precursor as claimed in Claim 6 or 8, wherein the compound having a functional group represented by the formula (1) further has a substrate adhesion group.

**11.** The lithographic printing plate precursor as claimed in Claim 7 or 9, wherein the compound having a functional group represented by the formula (2) further has a substrate adhesion group.

**12.** The lithographic printing plate precursor as claimed in Claim 6, 8 or 10, wherein the compound having a functional group represented by formula (1) further has a hydrophilic group.

**13.** The lithographic printing plate precursor as claimed in Claim 7, 9 or 11, wherein the compound having a functional group represented by the formula (2) further has a hydrophilic group.

**14.** The lithographic printing plate precursor as claimed in Claim 7, 9, 11 or 13, wherein the compound having a functional group represented by the formula (1) has two or more radical polymerizable double bonds in a molecule.

**15.** The lithographic printing plate precursor as claimed in Claim 6, 8, 10 or 12, wherein the compound having a functional group represented by the formula (2) has two or more radical polymerizable double bonds in a molecule.

**16.** A method for preparing a lithographic printing plate, comprising: exposing imagewise the lithographic printing plate precursor as claimed in any one of Claims 1 to 15 with laser of 350 to 1,200 nm; and rubbing a surface of the exposed lithographic printing plate precursor with a rubbing member in the presence of a developer having pH of from 2 to

10 in an automatic processor equipped with the rubbing member to remove an unexposed area of the image-forming layer.

**17.** The method for preparing a lithographic printing plate as claimed in Claim 16, wherein the exposed lithographic printing plate precursor is subjected to a heat treatment between the exposure and the development.

**18.** A lithographic printing method comprising: (i) mounting the lithographic printing plate precursor as claimed in any one of Claims 1 to 15 on a printing machine and exposing the mounted lithographic printing plate precursor imagewise with laser of 350 to 1,200 nm, or (ii) exposing the lithographic printing plate precursor as claimed in any one of Claims 1 to 15 imagewise with laser of 350 to 1,200 nm and mounting the exposed lithographic printing plate precursor on a printing machine; and supplying printing ink and dampening water on the exposed lithographic printing plate precursor to remove an unexposed area of the image-forming layer and to conduct printing.

FIG. 1

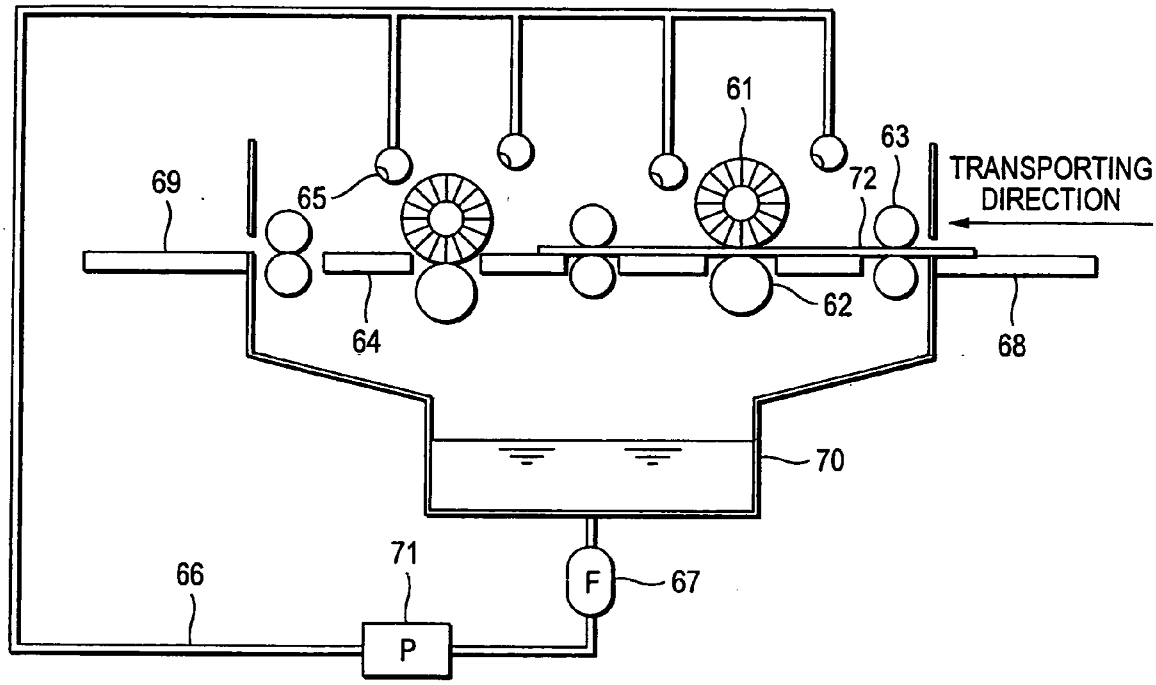

Europäisches Patentamt
European Patent Office
Office européen des brevets

# EUROPEAN SEARCH REPORT

Application Number
EP 08 01 7061

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 695 822 A (FUJI PHOTO FILM CO LTD [JP] FUJIFILM CORP [JP]) 30 August 2006 (2006-08-30) * page 58, line 40 - page 60, line 6; examples 6-10; table 3 * * page 63, line 16 - page 64, line 20; examples 16-20; table 6 * * examples 16-20 * * page 68, line 32 - line 50; example 26 * * page 70, line 51 - page 71, line 26; examples 36-40; table 12 * * paragraph [0247] - paragraph [0254] * * paragraph [0277] * ----- | 1-4,7,9, 11,13, 15,16,18 | INV. B41C1/10 G03F7/11 ADD. B41N1/08 |
| X | EP 1 520 694 A (FUJI PHOTO FILM CO LTD [JP] FUJIFILM CORP [JP]) 6 April 2005 (2005-04-06) * page 41, line 24 - page 42, line 44; examples 9-18 * * page 43, line 8 - line 18; claim 1; examples 21,22; table 5 * * paragraph [0191] - paragraph [0197] * * paragraph [0219] * ----- | 1-4,7,9, 11,13, 15,18 | |

TECHNICAL FIELDS SEARCHED (IPC)

B41M
B41C
B41N
G03F

The present search report has been drawn up for all claims

| Place of search | Date of completion of the search | Examiner |
|---|---|---|
| Munich | 26 January 2009 | Lindner, Thomas |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

**ANNEX TO THE EUROPEAN SEARCH REPORT ON EUROPEAN PATENT APPLICATION NO.** EP 08 01 7061

This annex lists the patent family members relating to the patent documents cited in the above-mentioned European search report. The members are as contained in the European Patent Office EDP file on
The European Patent Office is in no way liable for these particulars which are merely given for the purpose of information.

26-01-2009

| Patent document cited in search report | Publication date | Patent family member(s) | Publication date |
|---|---|---|---|
| EP 1695822 A | 30-08-2006 | US 2006194149 A1 | 31-08-2006 |
| EP 1520694 A | 06-04-2005 | AT 416918 T | 15-12-2008 |
| | | JP 2005125749 A | 19-05-2005 |
| | | US 2005074692 A1 | 07-04-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4708925 A
- JP 8276558 A
- US 6132935 A
- US 2850445 A
- JP 4420189 B
- JP 2938397 B
- US 6030750 A
- JP 2000211262 A
- JP 2001277740 A
- US 20010018159 A1
- JP 2002029162 A
- US 20020031715 A1
- JP 2002046361 A
- JP 2002137562 A
- US 20020102488 A1
- JP 2002326470 A
- US 20020117066 A1
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2002328465 A
- JP 2000066385 A
- JP 2000080068 A
- US 4069055 A
- JP 4365049 A
- US 4069056 A
- EP 104143 A
- US 339049 A
- US 410201 A
- JP 2150848 A

- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2002278057 A
- JP 2001133969 A
- JP 3296759 A
- JP 59028329 B
- JP 9236913 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 62170950 A
- JP 62226143 A
- JP 60168144 A
- JP 62293247 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- US 3458311 A
- JP 55049729 B
- US 292501 A
- US 44563 A
- JP 5045885 A
- JP 6035174 A
- JP 2220061 A
- JP 60059351 A
- US 5148746 A
- US 5568768 A
- GB 2297719 A
- JP 58159533 A
- JP 3100554 A
- JP B62167253 U

**Non-patent literature cited in the description**

- Polymer Handbook. vol. 1, 309
- *Nippon Secchaku Kyokaishi,* 1984, vol. 20 (7), 300-308
- **WAKABAYASHI et al.** *Bull. Chem. Soc. Japan,* 1969, vol. 42, 2924

- **M. P. HUTT.** *Journal of Heterocyclic Chemistry,* 1970, vol. 1 (3
- **MARTIN KUNZ.** *Rad Tech '98, Proceeding,* 19 April 1998
- *J. C. S. Perkin II,* 1979, 1653-1660
- *J. C. S. Perkin II,* 1979, 156-162
- *Journal of Photopolymer Science and Technology,* 1995, 202-232
- **S. I. SCHLESINGER.** *Photogr. Sci. Eng.,* 1974, vol. 18, 387
- **T. S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh, Proc. Conf. Rad. Curing ASIA,* October 1988, 478
- Senryo Binran. 1970
- Colour Index (C.I.). Saishin Ganryo Binran. 1977
- Saishin Ganryo Oyou Gijutsu. CMC Publishing Co., Ltd, 1986
- Insatsu Ink Gijutsu. CMC Publishing Co., Ltd, 1984
- Kinzoku Sekken no Seishitsu to Oyo. **SAIWAI SHOBO.** Insatsu Ink Gijutsu. CMC Publishing Co., Ltd, 1984
- Saishin Ganryo Oyo Gijutsu. CMC Publishing Co., Ltd, 1986
- **L.G. BROOKER et al.** *J. Am. Chem. Soc.,* 1951, vol. 73, 5326-5358